(19) Europäisches Patentamt
European Patent Office
Office européen des brevets

(11) EP 4 626 208 A1

(12) **EUROPEAN PATENT APPLICATION**
published in accordance with Art. 153(4) EPC

(43) Date of publication:
**01.10.2025 Bulletin 2025/40**

(21) Application number: **23912671.7**

(22) Date of filing: **12.12.2023**

(51) International Patent Classification (IPC):
***H10K 85/60*** *(2023.01)* ***C09K 11/06*** *(2006.01)*

(52) Cooperative Patent Classification (CPC):
**C09K 11/06; H10K 50/11; H10K 85/40; H10K 85/60**

(86) International application number:
**PCT/KR2023/020401**

(87) International publication number:
**WO 2024/143996 (04.07.2024 Gazette 2024/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.12.2022 KR 20220187291**

(71) Applicant: **Duk San Neolux Co., Ltd.**
**Chungcheongnam-do 31027 (KR)**

(72) Inventors:
- **LEE, Hyung Dong**
  **Cheonan-si Chungcheongnam-do 31027 (KR)**
- **PARK, Jung Hwan**
  **Cheonan-si Chungcheongnam-do 31027 (KR)**

(74) Representative: **Prüfer & Partner mbB**
**Patentanwälte · Rechtsanwälte**
**Sohnckestraße 12**
**81479 München (DE)**

# (54) ORGANIC ELECTRIC ELEMENT USING COMPOUND FOR ORGANIC ELECTRIC ELEMENT, AND ELECTRONIC DEVICE THEREOF

(57) The present invention provides an organic electronic device comprising a first electrode, a second electrode, and an organic layer between the first and second electrodes, and an electronic apparatus comprising the same. By using a mixture of the compounds of Formula 1 to Formula 3 of the present invention as a mixed-host in the organic layer, the driving voltage of the organic electronic device can be reduced, and the luminous efficiency and lifespan of the organic electronic device can be improved.

[Fig. 1]

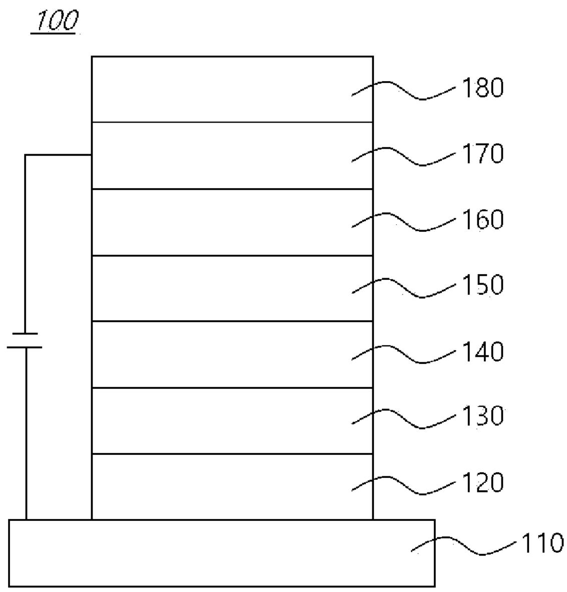


EP 4 626 208 A1

Processed by Luminess, 75001 PARIS (FR)

## Description

### Technical Field

The present invention relates to an organic electronic device using a compound for an organic electronic device and an electronic apparatus thereof, and more particularly, to an organic electronic device and an electronic apparatus thereof, in which a mixture containing three or more compounds is used as a host material in the emission layer.

### Background Art

In general, organic electroluminescence refers to a phenomenon in which electrical energy is converted into light energy by an organic material. An organic electronic device utilizing organic electroluminescence typically includes an anode, a cathode, and an organic layer interposed therebetween. In many cases, the organic layer has a multi-layered structure comprising different materials, respectively, in order to improve the efficiency and stability of an organic electronic device. For example, the organic layer may comprise a hole injection layer, a hole transport layer, an emission layer, an electron transport layer, and an electron injection layer.

The materials used in the organic layer of an organic electronic device may be classified, according to their functions, into a light-emitting material and chargetransporting materials such as a hole-injecting material, a hole-transporting material, an electron-transporting material, and an electron-injecting material. Further, the light-emitting material may be classified into a high molecular weight type and a low molecular weight type according to molecular weight, and may also be classified into a fluorescent material, which emits light from an excited singlet state, and a phosphorescent material, which emits light from an excited triplet state, according to its light-emission mechanism. Further, the light-emitting material may be classified, according to its emission color, into blue, green, and red light-emitting materials, and yellow and orange light-emitting materials, which are required for improved natural color reproduction.

Meanwhile, when a single material is used as a light-emitting material, problems may occur, such as a shift in the maximum emission wavelength toward a longer wavelength due to intermolecular interactions, a deterioration in color purity, or a reduction in luminous efficiency, thereby resulting in decreased efficiency of the corresponding device. Accordingly, a host/dopant system may be employed as the light-emitting material in order to enhance color purity and improve luminous efficiency through energy transfer. This is based on the principle that, when a small amount of a dopant having a smaller energy band gap than that of a host forming the emission layer is mixed into the emission layer, excitons generated in the emission layer are transferred to the dopant, thereby enabling light emission with high efficiency. Here, since the emission wavelength of the host is shifted to the wavelength region of the dopant, light having a desired wavelength can be obtained depending on the type of the dopant.

Currently, the portable display market is expanding with the adoption of large-area displays, which require greater power consumption than conventional portable displays. Accordingly, power consumption has become a critical factor for portable displays that operate with limited battery power, and issues related to efficiency and lifespan must also be addressed.

Efficiency, lifespan, driving voltage, and the like are interrelated. An increase in efficiency may lead to a decrease in driving voltage, which in turn may reduce the crystallization of organic materials caused by Joule heating generated during device operation. As a result, the lifespan of the device may be extended. However, efficiency cannot be maximized solely by improving the organic layer. This is because both long lifespan and high efficiency can be simultaneously achieved only when an optimal combination is established among the energy levels, $T_1$ values, and intrinsic material properties (e.g., charge mobility, interfacial characteristics, etc.) of the respective layers constituting the organic layer.

Therefore, it is necessary to develop an emitting material that exhibits high thermal stability and can efficiently achieve charge balance in the emission layer. That is, in order to fully realize the excellent characteristics of an organic electronic device, the materials constituting the organic layer-such as hole-injecting materials, hole-transporting materials, light-emitting materials, electron-transporting materials, and electron-injecting materials-must be based on materials that are both stable and efficient. In particular, it is crucial to develop a material for the emission layer.

### Detailed Description of the Invention

### Technical Challenge

An object of the present invention is to provide an organic electronic device and an electronic apparatus comprising the same, which can reduce the driving voltage of the device and improve the emission efficiency and lifetime of the device.

## Means of Solving Problems

In one aspect, the present invention provides an organic electronic device and an electronic apparatus comprising the same, in which a compound represented by Formula 1, a compound represented by Formula 2, and a compound represented by Formula 3 are comprised in an emission layer.

<Formula 1>

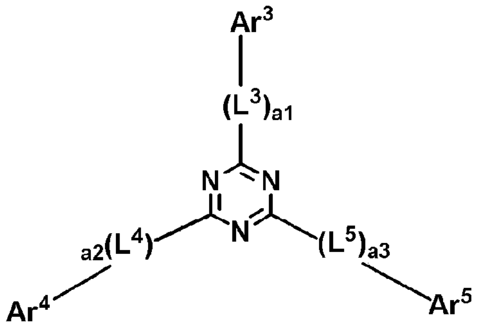

<Formula 2>

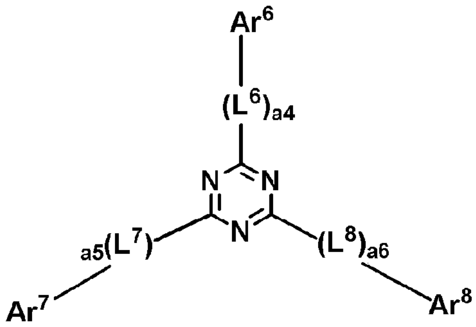

<Formula 3>

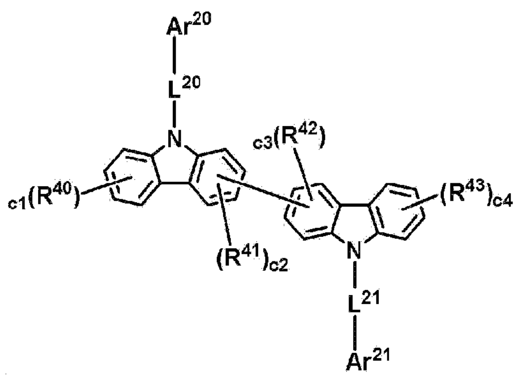

## Effect of Invention

According to the present invention, by including each of the compounds represented by Formulae 1 to 3 in an emission layer, the driving voltage of the device can be reduced, and the emission efficiency and lifetime can be improved.

## BRIEF DESCRIPTION OF THE DRAWINGS

Figures 1 to 3 illustrate an example of organic electroluminescent device according to the present invention.

[Description of Reference Numerals]

| | | | |
|---|---|---|---|
| 100, 200, 300: | organic electronic device | 110: | first electrode |
| 120: | hole injection layer | 130: | hole transport layer |
| 140: | emission layer | 150: | electron transport layer |
| 160: | electron injection layer | 170: | second electrode |
| 180: | layer for improving light efficiency | 210: | buffer layer |
| 220: | emission-auxiliary layer | 320: | first hole injection layer |
| 330: | first hole transport layer | 340: | first emission layer |
| 350: | first electron transport layer | 360: | first charge-generation layer |
| 361: | second charge-generation layer | 420: | second hole injection layer |
| 430: | second hole transport layer | 440: | second emission layer |
| 450: | second electron transport layer | CGL: | charge generation layer |

(continued)

| | | | |
|---|---|---|---|
| ST1: | first stack | ST2: | second stack |

## DETAILED DESCRIPTION

Unless otherwise stated, the term "aryl group" or "arylene group" as used herein refers to a group having 6 to 60 carbon atoms, but is not limited thereto. The aryl group or arylene group in the present invention may comprise a monocyclic ring, ring assemblies, a fused polycyclic system, a spiro compound, and the like.

As used herein, the term "fluorenyl group" refers to a fluorenyl moiety that may be substituted or unsubstituted, and the term "fluorenylene group" refers to a fluorenylene moiety that may be substituted or unsubstituted. The fluorenyl group or fluorenylene group employed in the present invention may comprise a spiro compound in which R and R' are bonded to each other in the structure shown below, and may also comprise compounds in which adjacent R" groups are linked together. The terms "substituted fluorenyl group" and "substituted fluorenylene group" mean that at least one of R, R', or R" in the following structure is a substituent other than hydrogen. In the following structure, the number of R" groups may range from 1 to 8. Throughout this specification, the fluorenyl group and fluorenylene group may collectively be referred to as a "fluorene group" or "fluorene," regardless of their valence.

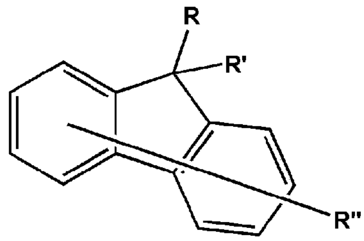

As used herein, the term "spiro compound" refers to a compound having a spiro linkage, which is a structure in which two rings are connected through a single common atom. The atom shared by the two rings is referred to as a "spiro atom," and the compound may be classified as a monospiro, dispiro, or trispiro compound depending on the number of spiro atoms present in the molecule.

As used herein, the term "heterocyclic group" comprises both aromatic rings, such as a "heteroaryl group" or a "heteroarylene group," and non-aromatic rings. Unless otherwise specified, the "heterocyclic group" refers to a ring structure containing one or more heteroatoms and having from 2 to 60 carbon atoms, but is not limited thereto. The term "heteroatom," as used herein, refers to atoms such as nitrogen (N), oxygen (O), sulfur (S), phosphorus (P), or silicon (Si), and may also include heteroatomic groups such as $SO_2$, P=O, and the like, which can replace a carbon atom in the ring structure as shown in the following compound. The "heterocyclic group" may comprise monocyclic ring, ring assemblies, fused polycyclic system, a spiro compound, and the like.

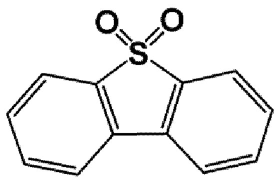

As used herein, the term "aliphatic ring group" refers to a cyclic hydrocarbon excluding aromatic hydrocarbons, and comprises, but is not limited to, monocyclic rings, ring assemblies, fused polycyclic systems, spiro compounds, and the like. Unless otherwise specified, the aliphatic ring group may comprise a ring having from 3 to 60 carbon atoms. For example, a fused ring system composed of benzene, which is an aromatic ring, and cyclohexane, which is a non-aromatic ring, corresponds to an aliphatic ring group.

The terms "alkyl halide," "halogen alkyl group," or "halo alkyl group," as used in the present invention refer to an alkyl group substituted with a halogen, unless otherwise specified. For example, it refers to an alkyl group in which some or all of the hydrogen atoms are replaced with halogen atoms.

In this specification, the 'group name' corresponding to an aryl group, an arylene group, a heterocyclic group, and the like, exemplified for each symbol and its substituent, may be expressed either as 'a functional group name reflecting the valence' or as 'the name of a parent compound'. For example, in the case of 'phenanthrene,' which is a type of aryl group, it may be described as 'phenanthryl' when referring to a monovalent group, and as 'phenanthrylene' when referring to a divalent group. Alternatively, it may also be described by its parent compound name 'phenanthrene,' regardless of

valence. Similarly, in the case of pyrimidine, it may be referred to as 'pyrimidine' regardless of its valence. Alternatively, it may be described by the name of the corresponding functional group, such as 'pyrimidinyl' for a monovalent group and 'pyrimidinylene' for a divalent group.

In addition, in the present specification, numerical and alphabetical indicators of positions may be omitted when describing the name of a compound or a substituent. For example, compounds such as pyrido[4,3-d]pyrimidine, benzofuro [2,3-d]pyrimidine, and 9,9-dimethyl-9H-fluorene may be described in a simplified manner as pyridopyrimidine, benzofurropyrimidine, and dimethylfluorene, respectively. Accordingly, both benzo[g]quinoxaline and benzo[f]quinoxaline may be generally referred to as benzoquinoxaline.

In addition, unless otherwise specified, when any compound according to the present invention is represented by the following formula, each substituent corresponding to the respective index is defined as described below.

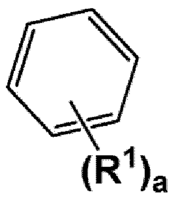

In the above formula, when a is zero, the substituent $R^1$ is absent, meaning that hydrogen atoms are bonded to all carbon atoms constituting the benzene ring. Here, chemical structures or compounds may be represented without explicitly indicating hydrogen atoms bonded to carbon atoms. In addition, when a is an integer of 1, one substituent $R^1$ is bonded to one of the carbon atoms constituting the benzene ring. When a is 2 or 3, the substituents may be bonded as exemplified below. In the case where a is an integer from 4 to 6, the substituents are similarly bonded to the carbon atoms of the benzene ring. Further, when a is greater than or equal to 2, the substituents $R^1$ may be identical or different from each other.

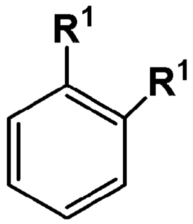

(a=2)

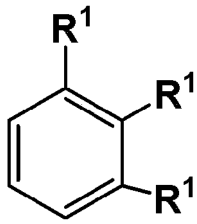

(a=3)

In addition, unless otherwise specified in the specification, the term 'ring' refers to an aryl ring, heteroaryl ring, fluorene ring, aliphatic ring, etc., and a numbermembered(atom) ring may refer to the shape of a ring. For example, naphthalene corresponds to a two-fused(condensed) ring, anthracene to a three-fused(condensed) ring, thiophene or furan corresponds to a five-membered ring, and benzene or pyridine corresponds to a six-membered ring.

In addition, unless otherwise specified in the present specification, when adjacent groups are linked to each other to form a ring, the ring may be selected from the group consisting of a $C_6$-$C_{60}$ aromatic ring group, a fluorenyl group, a $C_2$-$C_{60}$ heterocyclic group containing at least one heteroatom selected from O, N, S, Si, and P, and a $C_3$-$C_{60}$ aliphatic ring group. Here, the aromatic ring group may comprise an aryl ring, and the heterocyclic group may comprise a heteroaryl ring.

Unless otherwise specified, the term 'adjacent groups,' as used herein, comprises not only the relationships such as $R_1$ and $R_2$, $R_2$ and $R_3$, $R_3$ and $R_4$, and $R_5$ and $R_6$ but also $R_7$ and $R_8$ sharing a common carbon atom. It may further comprise cases substituents attached to different ring-forming atoms (e.g., carbon or nitrogen), such as $R_1$ and $R_7$, $R_1$ and $R_8$, or $R_4$ and $R_5$. That is, even when substituents are not directly adjacent on the same atom, one substituent may be considered adjacent to another substituent attached to a neighboring ring-forming atom. Additionally, substituents bonded to the same carbon atom forming the ring may also be regarded as adjacent groups. In the following Formula, when substituents such as $R_7$ and $R_8$, which are bonded to the same carbon atom, are connected to form a ring, a compound containing a spiro moiety may be generated.

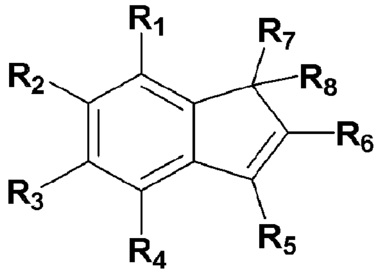
,
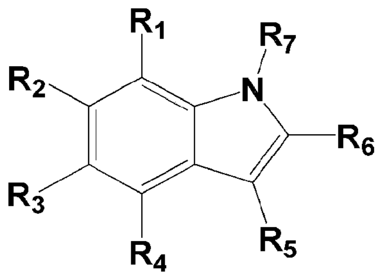

In addition, in the present specification, the expression 'adjacent groups may be linked to each other to form a ring' is used in the same sense as 'adjacent groups are selectively linked to each other to form a ring,' and refers to a case where at least one pair of adjacent groups may be bonded to form a ring structure.

In addition, unless otherwise specified in the present specification, substituents such as an aryl group, an arylene group, a fluorenyl group, a fluorenylene group, a heterocyclic group, an aliphatic ring group, an alkyl group, an alkenyl group, an alkynyl group, an alkoxyl group, an aryloxyl group, alkylthio group, arylthio group, etc., and a ring formed by adjacent groups may be each optionally substituted with one or more substituents selected from the group consisting of deuterium, halogen, a cyano group, a nitro group, siloxane group, a $C_6$-$C_{30}$ aryl group, a fluorenyl group, a $C_2$-$C_{30}$ heterocyclic group containing at least one heteroatom of O, N, S, Si and P, a $C_3$-$C_{30}$ aliphatic ring group, a $C_1$-$C_{20}$ alkyl group, a $C_2$-$C_{20}$ alkenyl group, a $C_2$-$C_{20}$ alkynyl group, a $C_1$-$C_{20}$ alkoxyl group, a $C_6$-$C_{20}$ aryloxy group, a $C_1$-$C_{20}$ alkylthio group, a $C_6$-$C_{20}$ arylthio group, a silane group unsubstituted or substituted with a $C_1$-$C_{20}$ alkyl group or a $C_6$-$C_{20}$ aryl group, and a phosphine oxide group unsubstituted or substituted with a $C_1$-$C_{20}$ alkyl group or a $C_6$-$C_{20}$ aryl group.

Hereinafter, with reference to Figures 1 to 3, the laminated structure of an organic electronic device comprising the compound according to the present invention will be described.

In the designation of reference numerals for components in the respective drawings, it should be understood that the same elements are denoted by the same reference numerals, even if they appear in different drawings. Furthermore, in the following description of the present invention, detailed explanations of well-known functions and configurations will be omitted where they may unnecessarily obscure the essence of the invention.

Terms such as "first," "second," "A," "B," "(a)," "(b)," and the like may be used to describe various components of the present invention. These terms are merely intended to distinguish one component from another and do not imply any particular order, importance, or essential characteristics. Furthermore, it should be understood that when a component is described as being "connected," "coupled," or "joined" to another component, this may include both direct connections as well as indirect connections through one or more intervening components.

Additionally, it is to be understood that when an element such as a layer, film, region, or substrate is described as being "on" or "over" another element, it may be positioned directly on the other element or with one or more intervening layers therebetween. In contrast, the expression "directly on" indicates that no intervening elements are present between the two elements.

Figures 1 to 3 respectively illustrate examples of an organic electronic device according to embodiments of the present invention.

Referring to FIG. 1, an organic electronic device 100 according to an embodiment of the present invention comprises a first electrode 110, a second electrode 170, and an organic layer disposed between the first electrode 110 and the second electrode 170 on a substrate (not shown). In some embodiments, an inorganic layer may also be interposed between the first electrode 110 and the second electrode 170.

For example, the first electrode 110 may function as an anode (positive electrode), and the second electrode 170 may function as a cathode (negative electrode). In an inverted organic electronic device, however, the first electrode may serve as a cathode, while the second electrode may serve as an anode.

The organic layer refers to a layer comprising at least one organic material. For example, the organic layer may include a hole injection layer 120, a hole transport layer 130, an emission layer 140, an electron transport layer 150, and an electron injection layer 160. In certain embodiments, the electron injection layer 160 may be an inorganic layer that does not contain any organic material.

Specifically, a hole injection layer 120, a hole transport layer 130, an emission layer 140, an electron transport layer 150, and an electron injection layer 160 may be sequentially formed on the first electrode 110.

Preferably, a layer for improving the luminous efficiency 180 may be formed on one side of the first electrode 110 or the second electrode 170, wherein the one side does not face the organic layer or inorganic layer. When the layer for improving the luminous efficiency 180 is formed, the luminous efficiency of the organic electronic device can be enhanced.

For example, the layer for improving the luminous efficiency 180 may be formed on the second electrode 170. As a result, in the case of a top-emission organic light emitting device, optical energy loss due to surface plasmon polaritons (SPPs) at the second electrode 170 may be reduced. In the case of a bottom-emission organic light emitting device, the

layer for improving the luminous efficiency 180 may function as a buffer layer for the second electrode 170.

A buffer layer 210 or an emission-auxiliary layer 220 may additionally be formed between the hole transport layer 130 and the emission layer 140, as will be described with reference to FIG. 2.

Referring to FIG. 2, an organic electronic device 200 according to another embodiment of the present invention may sequentially include a hole injection layer 120, a hole transport layer 130, a buffer layer 210, an emission-auxiliary layer 220, an emission layer 140, an electron transport layer 150, an electron injection layer 160, and a second electrode 170 on a first electrode 110, and a layer for improving the luminous efficiency 180 may be formed on the second electrode.

Although not illustrated in FIG. 2, an electron transport auxiliary layer may additionally be formed between the emission layer 140 and the electron transport layer 150.

In addition, according to another embodiment of the present invention, the organic layer may be in the form of multiple stacks, each of which includes a hole transport layer, an emission layer, and an electron transport layer. This will be described with reference to FIG. 3.

Referring to FIG. 3, in an organic electronic device 300 according to another embodiment of the present invention, two or more stacks of organic layers, ST1 and ST2, may be formed between the first electrode 110 and the second electrode 170. Each stack may include multiple organic layers, and a charge generation layer (CGL) may be formed between the stacks.

Specifically, the organic electronic device according to the embodiment of the present invention may comprise a first electrode 110, a first stack ST1, a charge generation layer CGL, a second stack ST2, and a second electrode 170 and a layer for improving light efficiency 180.

The first stack ST1 is an organic layer formed on the first electrode 110, and may comprise a first hole injection layer 320, a first hole transport layer 330, a first emission layer 340, and a first electron transport layer 350. The second stack ST2 may comprise a second hole injection layer 420, a second hole transport layer 430, a second emission layer 440, and a second electron transport layer 450. As such, the first stack and the second stack may have the same or different stacked structures of organic layers.

The charge generation layer CGL may be formed between the first stack ST1 and the second stack ST2. The charge generation layer CGL may comprise a first charge generation layer 360 and a second charge generation layer 361. It is positioned between the first emission layer 340 and the second emission layer 440 to enhance the current efficiency of each emission layer and facilitate charge distribution.

The first emission layer 340 may comprise a light-emitting material that comprises a blue host doped with a blue fluorescent dopant, and the second emission layer 440 may comprise a light-emitting material that comprises a green host doped with both a greenish-yellow dopant and a red dopant. However, the materials of the first emission layer 340 and the second emission layer 440 according to an embodiment of the present invention are not limited thereto.

In FIG. 3, nmay be an integer from 1 to 5, and when n is 2, a charge generation layer (CGL) and a third stack may be additionally formed on the second stack ST2.

When a plurality of emission layers are formed in a multi-layer stack structure as shown in FIG. 3, it is possible to manufacture an organic electroluminescent element that emits not only white light but also various colors, where the white light is produced by the mixing of light emitted from each emission layer.

Compound(s) represented by Formulae 1 to 3 of the present invention may be included in an organic layer. For example, the compounds represented by Formulae 1 to 3 of the present invention can be used as a material for a hole injection layer 120, 320, 420, a hole transport layer 130, 330, 430, a buffer layer 210, an emission-auxiliary layer 220, an electron transport layer 150, 350, 450, an emission layer 140, 340, 440, and/or a light efficiency improving layer 180. More preferably, they may be used as a host material in the emission layers 140, 340, or 440.

Even if the cores of the compounds are identical or similar, their band gaps, electronic properties, and interfacial characteristics may vary depending on which substituents are bonded and at which positions. Therefore, it is necessary to study the selection of the core structure and the combination with sub-substituents attached to the core. In particular, a long lifespan and high efficiency can be achieved simultaneously when the optimal combination of energy levels, **T1** values, and intrinsic material properties (such as mobility and interfacial characteristics) is realized among the layers of the organic structure.

Therefore, by using each compound represented by Formulae 1 to 3 as a material for the emission layers 140, 340, and 440, it is possible to optimize the energy levels and T1 values, intrinsic material properties (such as mobility and interfacial characteristics) between the respective layers of the organic layer, as a result, the lifetime and efficiency of an organic electronic device can be simultaneously improved.

The organic electronic device according to an embodiment of the present invention may be fabricated using various deposition methods, comprising physical vapor deposition (PVD) or chemical vapor deposition (CVD). For example, the organic electronic device may be manufactured by forming the anode 110 on the substrate by depositing a metal, a conductive metal oxide, or a mixture thereof, then forming an organic layer comprising the hole injection layer 120, the hole transport layer 130, the emission layer 140, the electron transport layer 150, and the electron injection layer 160 thereon, and finally depositing a material that can be used as the cathode 170. In addition, an emission-auxiliary layer 220

may be formed between the hole transport layer 130 and the emission layer 140, and an electron transport auxiliary layer (not shown) may additionally be formed between the emission layer 140 and the electron transport layer 150. As described above, these layers may constitute a stacked structure.

In addition, the organic layer may be manufactured with fewer layers by using various polymer materials through a solution process or solvent-based process, such as spin coating, nozzle printing, inkjet printing, slot coating, dip coating, roll-to-roll, doctor blading, screen printing, or thermal transfer, instead of deposition. Since the organic layer according to the present invention may be formed in various ways, the scope of protection of the present invention is not limited by the method of forming the organic layer.

The organic electronic device according to an embodiment of the present invention may be a top-emission type, a bottom-emission type, or a dual-emission type, depending on the materials used.

In addition, the organic electronic device according to an embodiment of the present invention may be selected from the group consisting of an organic electroluminescent device, an organic solar cell, an organic photoconductor, an organic transistor, a monochromatic illumination device, and a quantum dot display device.

Another embodiment of the present invention provides an electronic apparatus comprising a display device including the above-described organic electronic device and a control unit for controlling the display device. The electronic apparatus may be a wired or wireless communication terminal currently in use or to be developed in the future, and comprises all types of electronic devices, such as mobile communication terminals (e.g., cellular phones), navigation units, game players, various types of TVs, and computers.

Hereinafter, an organic electronic device according to one aspect of the present invention will be described.

An organic electronic device according to one aspect of the present invention comprises a first electrode, a second electrode, and an organic layer formed between the first electrode and the second electrode, wherein the organic layer comprises an emission layer, and the emission layer comprises compound represented by Formula 1, compound represented by Formula 2 and compound represented by Formula 3.

Preferably, host of an emission layer may comprise compounds represented by Formulae 1 to 3. For example, a first host may be a compound of Formula 1, a second host may be a compound of Formula 2, and a third host may be a compound of Formula 3, and host may comprise three or more types of compounds.

Hereinafter, Formula 1 to Formula 3 will be described.

<Formula 1>

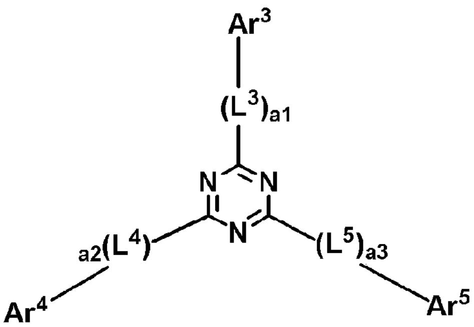

<Formula 2>

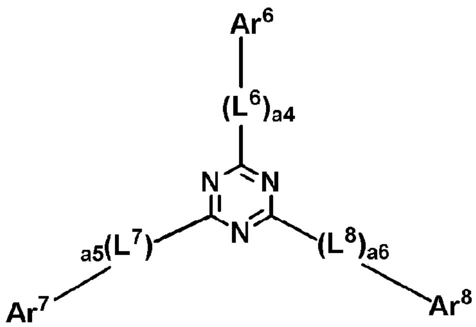

<Formula 3>

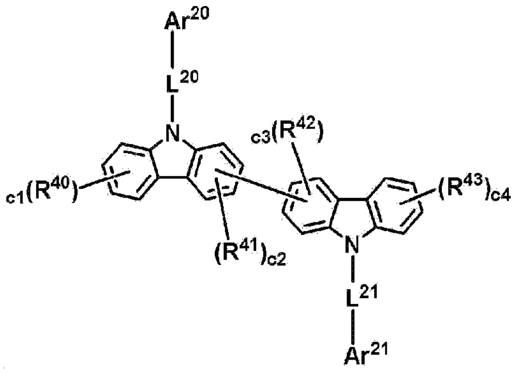

In Formula 1 to Formula 3, each of symbols may be defined as follows.

$Ar^3$ to $Ar^5$ each independently selected from the group consisting of a $C_6$-$C_{60}$ aryl group; a fluorenyl group; a $C_3$-$C_{60}$ aliphatic ring group; and a $C_2$-$C_{30}$ heterocyclic group containing at least one heteroatom of O, N, S, Si and P. With the proviso that in Formula 2, the case where at least one of $Ar^3$ to $Ar^5$ is or comprises the following substituent is excluded.

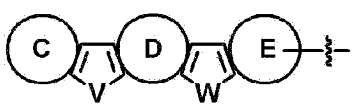

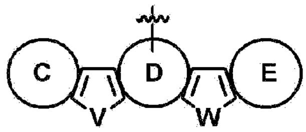

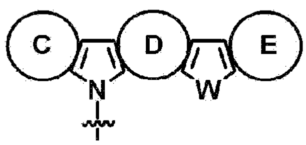

In the above structure, ring C, ring D and ring E are each independently a $C_6$-$C_{60}$ aryl ring, and V and W are each independently O, S, $N(R_{11})$ or $C(R_{12})(R_{13})$, wherein $R_{11}$ to $R_{13}$ are each independently selected from the group consisting of hydrogen; deuterium; halogen; a cyano group; a nitro group; a $C_6$-$C_{60}$ aryl group; a fluorenyl group; a $C_2$-$C_{60}$ heterocyclic group containing at least one heteroatom of O, N, S, Si and P; a $C_3$-$C_{60}$ aliphatic ring group; a $C_1$-$C_{20}$ alkyl group; a $C_2$-$C_{20}$ alkenyl group; a $C_2$-$C_{20}$ alkynyl group; a $C_1$-$C_{20}$ alkoxyl group; and a $C_6$-$C_{60}$ aryloxy group.

Therefore, substituents such as fused heterocyclic groups having fused five or more rings or fused fluorene derivatives having five or more rings are excluded from $Ar^3$ to $Ar^5$.

$L^3$ to $L^5$ are each independently selected from the group consisting of a single bond, a $C_6$-$C_{60}$ arylene group, a fluorenylene group, a $C_3$-$C_{60}$ aliphatic ring group, and a $C_2$-$C_{30}$ heterocyclic group containing at least one heteroatom of O, N, S, Si and P.

$Ar^6$ to $Ar^8$ are each independently a $C_6$-$C_{60}$ aryl group.

$L^6$ to $L^8$ are each independently a single bond, or a $C_6$-$C_{60}$ arylene group.

a1 to a6 are each an integer from 0 to 3, and when these are integers of 2 or more, each of the plurality of $L^3$ to each of the plurality of $L^8$ may be the same as or different from one another.

$Ar^{20}$ and $Ar^{21}$ each independently selected from the group consisting of a $C_6$-$C_{60}$ aryl group; a fluorenyl group; a $C_3$-$C_{60}$ aliphatic ring group; and a $C_2$-$C_{60}$ heterocyclic group containing at least one heteroatom of O, N, S, Si and P.

$L^{20}$ and $L^{21}$ are each independently selected from the group consisting of a single bond; a $C_6$-$C_{60}$ arylene group; a fluorenylene group; a $C_3$-$C_{60}$ aliphatic ring group; and a $C_2$-$C_{60}$ heterocyclic group containing at least one heteroatom of O, N, S, Si and P.

$R^{40}$ to $R^{43}$ are each independently selected from the group consisting of hydrogen; deuterium; halogen; a cyano group; a nitro group; a $C_6$-$C_{60}$ aryl group; a fluorenyl group; a $C_2$-$C_{60}$ heterocyclic group containing at least one heteroatom of O, N, S, Si and P; a $C_3$-$C_{60}$ aliphatic ring group; a $C_1$-$C_{20}$ alkyl group; a $C_2$-$C_{20}$ alkenyl group; a $C_2$-$C_{20}$ alkynyl group; a $C_1$-$C_{20}$ alkoxyl group; and a $C_6$-$C_{60}$ aryloxy group, and adjacent groups may be bonded to each other to form a ring.

When adjacent groups, for example, adjacent $R^{40}$ groups, adjacent $R^{41}$ groups, $R^{42}$ adjacent groups, $R^{43}$ adjacent groups are bonded to each other to form a ring, the ring may be selected from the group consisting of a $C_6$-$C_{60}$ aromatic ring group; a fluorenylene group; a $C_3$-$C_{60}$ heterocyclic group containing at least one heteroatom of O, N, S, Si and P; and a $C_6$-$C_{60}$ aliphatic ring.

When adjacent groups are bonded to each other to form an aromatic ring, the aromatic ring may be, for example, a $C_6$-$C_{20}$, a $C_6$-$C_{18}$, a $C_6$-$C_{16}$, a $C_6$-$C_{14}$, a $C_6$-$C_{13}$, a $C_6$-$C_{12}$, a $C_6$-$C_{10}$, a $C_6$, a $C_{10}$, a $C_{12}$, a $C_{14}$, a $C_{15}$, a $C_{16}$, or a $C_{18}$ aromatic ring, specifically, an aryl ring such as benzene, naphthalene, anthracene, phenanthrene, pyrene, etc.

When adjacent groups are bonded to each other to form an heterocyclic group, the heterocyclic group may be, for example, a $C_2$-$C_{20}$, a $C_2$-$C_{19}$, a $C_2$-$C_{18}$, a $C_2$-a $C_{17}$, a $C_2$-$C_{16}$, a $C_2$-$C_{15}$, a $C_2$-$C_{14}$, a $C_2$-$C_{13}$, a $C_2$-$C_{12}$, a $C_2$-$C_{11}$, a $C_2$-$C_{10}$, a $C_2$-$C_9$, a $C_2$-$C_8$, a $C_2$-$C_7$, a $C_2$-$C_6$, a $C_2$-$C_5$, a $C_2$-$C_4$, a $C_2$-$C_3$, a $C_2$, a $C_3$, a $C_4$, a $C_5$, a $C_6$, a $C_7$, a $C_8$, a $C_9$, a $C_{10}$, a $C_{11}$, a $C_{12}$, a $C_{13}$, a $C_{14}$, a $C_{15}$, a $C_{16}$, a $C_{17}$, a $C_{18}$, a $C_{19}$, a $C_{20}$ heterocyclic group, specifically, pyridine, pyrimidine, furan, pyrrole, indole, quinoline, quinazoline, benzoquinazoline, quinoxaline, benzofuran, naphthobenzofuran, dibenzofuran, dinaphthofuran, thiophene, benzothiophene, naphthobenzothiophene, dibenzothiophene, etc.

c1 and c4 are each integers from 0 to 4, c2 and c3 are each integers from 0 to 3, and when these are an integer of 2 or more, each of the plurality of $R^1$ to each of the plurality of $R^4$ may be the same as or different from one another.

When at least one of $Ar^3$ to $Ar^8$, $Ar^{20}$, $Ar^{21}$, $R^{40}$ to $R^{43}$ is an aryl group, the aryl group may be, for example, a $C_6$-$C_{30}$, a $C_6$-$C_{29}$, a $C_6$-$C_{28}$, a $C_6$-$C_{27}$, a $C_6$-$C_{26}$, a $C_6$-$C_{25}$, a $C_6$-$C_{24}$, a $C_6$-$C_{23}$, a $C_6$-$C_{22}$, a $C_6$-$C_{21}$, a $C_6$-$C_{20}$, a $C_6$-$C_{19}$, a $C_6$-$C_{18}$, a $C_6$-$C_{17}$, a $C_6$-$C_{16}$, a $C_6$-$C_{15}$, a $C_6$-$C_{14}$, a $C_6$-$C_{13}$, a $C_6$-$C_{12}$, a $C_6$-$C_{11}$, a $C_6$-$C_{10}$, a $C_6$, a $C_{10}$, a $C_{12}$, a $C_{13}$, a $C_{14}$, a $C_{15}$, a $C_{16}$, a $C_{17}$, or a $C_{18}$ aryl group, specifically, phenyl, biphenyl, naphthyl, terphenyl, phenanthrene, triphenylene, or the like.

When at least one of $L^3$ to $L^8$, $L^{20}$, $L^{21}$ is an arylene group, the arylene group may be, for example, a $C_6$-$C_{30}$, a $C_6$-$C_{29}$, a $C_6$-$C_{28}$, a $C_6$-$C_{27}$, a $C_6$-$C_{26}$, a $C_6$-$C_{25}$, a $C_6$-$C_{24}$, a $C_6$-$C_{23}$, a $C_6$-$C_{22}$, a $C_6$-$C_{21}$, a $C_6$-$C_{20}$, a $C_6$-$C_{19}$, a $C_6$-$C_{18}$, a $C_6$-$C_{17}$, a $C_6$-$C_{16}$, a $C_6$-$C_{15}$, a $C_6$-$C_{14}$, a $C_6$-$C_{13}$, a $C_6$-$C_{12}$, a $C_6$-$C_{11}$, a $C_6$-$C_{10}$, a $C_6$, a $C_{10}$, a $C_{12}$, a $C_{13}$, a $C_{14}$, a $C_{15}$, a $C_{16}$, a $C_{17}$, or a $C_{18}$ arylene group, specifically, phenylene, biphenyl, naphthylene, terphenyl, phenanthrene, triphenylene, or the like.

When at least one of $Ar^3$ to $Ar^5$, $Ar^{20}$, $Ar^{21}$, $L^{20}$, $L^{21}$, $L^3$ to $L^5$, $R^{40}$ to $R^{43}$ is a heterocyclic group, the heterocyclic group may be, for example, a $C_2$-$C_{30}$, a $C_2$-$C_{29}$, a $C_2$-$C_{28}$, a $C_2$-$C_{27}$, a $C_2$-$C_{26}$, a $C_2$-$C_{25}$, a $C_2$-$C_{24}$, a $C_2$-$C_{23}$, a $C_2$-$C_{22}$, a $C_2$-$C_{21}$, a $C_2$-$C_{20}$, a $C_2$-$C_{19}$, a $C_2$-$C_{18}$, a $C_2$-$C_{17}$, a $C_2$-$C_{16}$, a $C_2$-$C_{15}$, a $C_2$-$C_{14}$, a $C_2$-$C_{13}$, a $C_2$-$C_{12}$, a $C_2$-$C_{11}$, a $C_2$-$C_{10}$, a $C_2$-$C_9$, a $C_2$-$C_8$, a $C_2$-$C_7$, a $C_2$-$C_6$, a $C_2$-$C_5$, a $C_2$-$C_4$, a $C_2$-$C_3$, a $C_2$, a $C_3$, a $C_4$, a $C_5$, a $C_6$, a $C_7$, a $C_8$, a $C_9$, a $C_{10}$, a $C_{11}$, a $C_{12}$, a $C_{13}$, a $C_{14}$, a $C_{15}$, a $C_{16}$, a $C_{17}$, a $C_{18}$, a $C_{19}$, a $C_{20}$, a $C_{21}$, a $C_{22}$, a $C_{23}$, a $C_{24}$, a $C_{25}$, a $C_{26}$, a $C_{27}$, a $C_{28}$, or a $C_{29}$ heterocyclic group, specifically, pyridine, pyrimidine, pyrazine, pyridazine, triazine, furan, pyrrole, indene, indole, phenyl-indole, benzoindole, phenyl-benzoindole, pyrazinoindol, quinoline, isoquinoline, benzoquinoline, pyridoquinoline, quinazoline, benzoquinazoline, dibenzoquinazoline, phenanthroquinazoline, quinoxaline, benzoquinoxaline, dibenzoquinoxaline, benzofuran, naphthobenzofuran, dibenzofuran, dinaphthofuran, thiophene, benzothiophene, dibenzothiophene, naphthobenzothiophene, dinaphthothiophene, carbazole, phenyl-carbazole, benzocarbazole, phenylbenzocarbazole, naphthyl-benzocarbazole, dibenzocarbazole, benzofuropyridine, benzothienopyridine, benzofuropyrimidine, benzothienopyrimidine, benzothienopyrazine, benzofuropyrazine, benzoimidazole, benzothiazole, benzooxazole, benzosiloe, phenanthroline, dihydro-phenylphenazine, 10-phenyl-10H-phenoxazine, phenoxazine, phenothiazine, dibenzodioxin, benzodibenzodioxin, thianthrene, 9,9-dimethyl-9H-xanthene, 9,9-dimethyl-9H-thioxanthene, dihydrodimethylphenylacridine, spiro[fluorene-9,9'-xanthene], dibenzoselenophene, benzophosphindole and the like.

When at least one of $Ar^3$ to $Ar^5$, $L^3$ to $L^5$ is an aliphatic ring group, the aliphatic ring group, may be, for example, a $C_3$-$C_{30}$, a $C_3$-$C_{29}$, a $C_3$-$C_{28}$, a $C_3$-$C_{27}$, a $C_3$-$C_{26}$, a $C_3$-$C_{25}$, a $C_3$-$C_{24}$, a $C_3$-$C_{23}$, a $C_3$-$C_{22}$, a $C_3$-$C_{21}$, a $C_3$-$C_{20}$, a $C_3$-$C_{19}$, a $C_3$-$C_{18}$, a $C_3$-$C_{17}$, a $C_3$-$C_{16}$, a $C_3$-$C_{15}$, a $C_3$-$C_{14}$, a $C_3$-$C_{13}$, a $C_3$-$C_{12}$, a $C_3$-$C_{11}$, a $C_3$-$C_{10}$, a $C_3$-$C_8$, a $C_3$-$C_6$, a $C_6$, a $C_{10}$, a $C_{11}$, a $C_{12}$, a $C_{13}$, a $C_{14}$, a $C_{15}$, a $C_{16}$, a $C_{17}$ or a $C_{18}$ aliphatic ring group, specifically, a cyclopentanyl group, indenyl group, tetralin group, a cyclohexanyl group, a norbornyl group, an adamantyl group, etc.

When at least one of $Ar^3$ to $Ar^5$ is a fluorenyl group, or when at least one of $L^3$ to $L^5$ is a fluorenylene group, the fluorenyl group or the fluorenylene group may be 9,9-dimethyl-9H-fluorene, 9,9-diphenyl-9H-fluorene, 9,9'-spirobifluorene, spiro[benzo[b]fluorene-11,9'-fluorene], benzo[b]fluorene, 11,11-diphenyl-11H-benzo[b]fluorene, or 9-(naphthalen-2-yl)-9-phenyl-9H-fluorene.

In the above Formulae 1 to 3, $Ar^3$ to $Ar^8$, $Ar^{20}$, $Ar^{21}$, $L^3$ to $L^8$, $L^{20}$, $L^{21}$, $R^{40}$ to $R^{43}$ may each be substituted with substituent. For example, when at least one of $Ar^3$ to $Ar^8$, $L^3$ to $L^8$, $L^6$ to $L^8$, $Ar^{20}$, $Ar^{21}$, $L^{20}$, $L^{21}$, $R^{40}$ to $R^{43}$ is a substituent containing H, the H may be replaced with another substituent.

$Ar^3$ to $Ar^5$, $Ar^{20}$, $Ar^{21}$, $L^3$ to $L^5$, $L^{20}$, $L^{21}$, $R^{40}$ to $R^{43}$ may be each substituted with one or more substituents selected from the group consisting of deuterium; halogen; a silane group unsubstituted or substituted with a $C_1$-$C_{20}$ alkyl group or a $C_6$-$C_{20}$ aryl group; a phosphine oxide substituted or unsubstituted with a $C_1$-$C_{20}$ alkyl group or a $C_6$-$C_{20}$ aryl group; siloxane group; a cyano group; a nitro group; a $C_1$-$C_{20}$ alkylthio group; a $C_1$-$C_{20}$ alkoxy group; a $C_6$-$C_{30}$ aryloxy group; a $C_6$-$C_{30}$ arylthio group; a $C_1$-$C_{20}$ alkyl halide group; a $C_1$-$C_{20}$ alkyl group; a $C_2$-$C_{20}$ alkenyl group; a $C_2$-$C_{20}$ alkynyl group; a $C_6$-$C_{30}$ aryl group; a $C_6$-$C_{30}$ aryl group substituted with deuterium; a fluorenyl group; a $C_2$-$C_{30}$ heterocyclic group comprising at least one heteroatom selected from the group consisting of O, N, S, Si and P; and a $C_3$-$C_{30}$ aliphatic ring group.

$Ar^6$ to $Ar^8$, $L^6$ to $L^8$ may be each substituted with one or more substituents selected from the group consisting of deuterium; a cyano group; a $C_6$-$C_{30}$ aryl group; and a $C_6$-$C_{30}$ aryl group substituted with deuterium.

When at least one of $Ar^3$ to $Ar^8$, $Ar^{20}$, $Ar^{21}$, $L^3$ to $L^8$, $L^{20}$, $L^{21}$, $R^{40}$ to $R^{43}$ is substituted with an aryl group, the aryl group may be, for example, a $C_6$-$C_{30}$, a $C_6$-$C_{29}$, a $C_6$-$C_{28}$, a $C_6$-$C_{27}$, a $C_6$-$C_{26}$, a $C_6$-$C_{25}$, a $C_6$-$C_{24}$, a $C_6$-$C_{23}$, a $C_6$-$C_{22}$, a $C_6$-$C_{21}$, a $C_6$-$C_{20}$, a $C_6$-$C_{19}$, a $C_6$-$C_{16}$, a $C_6$-$C_{17}$, a $C_6$-$C_{16}$, a $C_6$-$C_{15}$, a $C_6$-$C_{14}$, a $C_6$-$C_{13}$, a $C_6$-$C_{12}$, a $C_6$-$C_{11}$, a $C_6$-$C_{10}$, a $C_6$, a $C_{10}$, a $C_{12}$, a $C_{13}$, a $C_{14}$, a $C_{15}$, a $C_{16}$, a $C_{17}$, or a $C_{18}$ aryl group.

When at least one of $Ar^3$ to $Ar^5$, $L^3$ to $L^8$ is substituted with an aliphatic ring group, the aliphatic ring group may be, for example, a $C_3$-$C_{30}$, a $C_3$-$C_{29}$, a $C_3$-$C_{28}$, a $C_3$-$C_{27}$, a $C_3$-$C_{26}$, a $C_3$-$C_{25}$, a $C_3$-$C_{24}$, a $C_3$-$C_{23}$, a $C_3$-$C_{22}$, a $C_3$-$C_{21}$, a $C_3$-$C_{20}$, a $C_3$-$C_{19}$, a $C_3$-$C_{18}$, a $C_3$-$C_{17}$, a $C_3$-$C_{16}$, a $C_3$-$C_{15}$, a $C_3$-$C_{14}$, a $C_3$-$C_{13}$, a $C_3$-$C_{12}$, a $C_3$-$C_{11}$, a $C_3$-$C_{10}$, a $C_3$-$C_8$, a $C_3$-$C_6$, a $C_6$, a $C_{10}$, a $C_{11}$, a $C_{12}$, a $C_{13}$, a $C_{14}$, a $C_{15}$, a $C_{16}$, a $C_{17}$ or a $C_{18}$ aliphatic ring group.

When at least one of $Ar^3$ to $Ar^5$, $L^3$ to $L^8$ is substituted with a fluorenyl group, the fluorenyl group may be 9,9-dimethyl-9H-fluorene, 9,9-diphenyl-9H-fluorene, 9,9'-spirobifluorene, spiro[benzo[b]fluorene-11,9'-fluorene], benzo[b]fluorene, 11,11-diphenyl-11H-benzo[b]fluorene, or 9-(naphthalen-2-yl)-9-phenyl-9H-fluorene.

When at least one of $Ar^3$ to $Ar^5$, $Ar^{20}$, $Ar^{21}$, $L^3$ to $L^5$, $L^{20}$, $L^{21}$, $R^{40}$ to $R^{43}$ is substituted with a heterocyclic group, the heterocyclic group may be, for example, a $C_2$-$C_{30}$, a $C_2$-$C_{29}$, a $C_2$-$C_{28}$, a $C_2$-$C_{27}$, a $C_2$-$C_{26}$, a $C_2$-$C_{25}$, a $C_2$-$C_{24}$, a $C_2$-$C_{23}$, a $C_2$-$C_{22}$, a $C_2$-$C_{21}$, a $C_2$-$C_{20}$, a $C_2$-$C_{19}$, a $C_2$-$C_{18}$, a $C_2$-$C_{17}$, a $C_2$-$C_{16}$, a $C_2$-$C_{15}$, a $C_2$-$C_{14}$, a $C_2$-$C_{13}$, a $C_2$-$C_{12}$, a $C_2$-$C_{11}$, a $C_2$-$C_{10}$, a $C_2$-$C_9$, a $C_2$-$C_8$, a $C_2$-$C_7$, a $C_2$-$C_6$, a $C_2$-$C_5$, a $C_2$-$C_4$, a $C_2$-$C_3$, a $C_2$, a $C_3$, a $C_4$, a $C_5$, a $C_6$, a $C_7$, a $C_8$, a $C_9$, a $C_{10}$, a $C_{11}$, a $C_{12}$, a $C_{13}$, a $C_{14}$, a $C_{15}$, a $C_{16}$, a $C_{17}$, a $C_{18}$, a $C_{19}$, a $C_{20}$, a $C_{21}$, a $C_{22}$, a $C_{23}$, a $C_{24}$, a $C_{25}$, a $C_{26}$, a $C_{27}$, a $C_{28}$, or a $C_{29}$ heterocyclic group.

When at least one of $Ar^3$ to $Ar^5$, $L^3$ to $L^8$ is substituted with an alkyl group, the alkyl group may be, for example, a $C_1$-$C_{20}$, a $C_1$-$C_{10}$, a $C_1$-$C_4$, a $C_1$, a $C_2$, a $C_3$, or a $C_4$ alkyl group, for example, methyl, ethyl, t-butyl, etc.

When at least one of $Ar^3$ to $Ar^5$, $L^3$ to $L^8$ is substituted with an alkyl halide group, the alkyl halide group may be, for example, a $C_1$-$C_{20}$, a $C_1$-$C_{10}$, a $C_1$-$C_4$, a $C_1$, a $C_2$, a $C_3$, or a $C_4$ alkyl halide group, for example, trifluoromethyl group.

In Formula 1, at least one of $L^3$ to $L^5$ may be represented by Formula L-1 or Formula L-2, but is not limited thereto.

<Formula L-1> <Formula L-2>

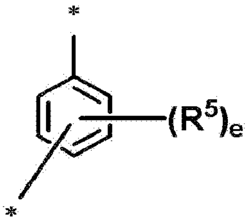
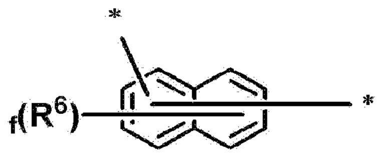

In Formula L-1 and L-2, each symbol may be defined as follows.

$R^5$ and $R^6$ are each independently selected from the group consisting of deuterium; halogen; a silane group unsubstituted or substituted with a $C_1$-$C_{20}$ alkyl group or a $C_6$-$C_{20}$ aryl group; a phosphine oxide substituted or unsubstituted with a $C_1$-$C_{20}$ alkyl group or a $C_6$-$C_{20}$ aryl group; siloxane group; a cyano group; a nitro group; a $C_1$-$C_{20}$ alkylthio group; a $C_1$-$C_{20}$ alkoxy group; a $C_6$-$C_{30}$ aryloxy group; a $C_6$-$C_{30}$ arylthio group; a $C_1$-$C_{20}$ alkyl halide group; a $C_1$-$C_{20}$ alkyl group; a $C_2$-$C_{20}$ alkenyl group; a $C_2$-$C_{20}$ alkynyl group; a $C_6$-$C_{30}$ aryl group; a $C_6$-$C_{30}$ aryl group substituted with deuterium; a fluorenyl group; a $C_2$-$C_{30}$ heterocyclic group comprising at least one heteroatom selected from the group consisting of O, N, S, Si and P; and a $C_3$-$C_{17}$ aliphatic ring group; and adjacent groups may be bonded to each other to form a ring.

e is integer from 0 to 4, f is integer from 0 to 6, and when any of them is an integer of 2 or more, each of the plurality of $R^5$, the plurality of $R^6$ may be the same as or different from one another.

Formula L-1 may be selected from the group consisting of Formula L-1-1 to Formula L-1-3.

<Formula L-1-1> <Formula L-1-2> <Formula L-1-3>

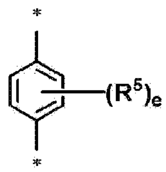
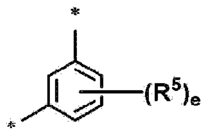
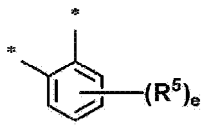

In Formula L-1-1 to Formula L-1-3, $R^5$ and e are the same as defined for Formula L-1.

Formula L-2 may be represented by one of Formula L-2-1 to Formula L-2-10.

<Formula L-2-1> <Formula L-2-2> <Formula L-2-3> <Formula L-2-4>

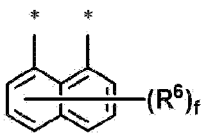
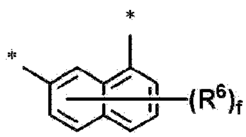
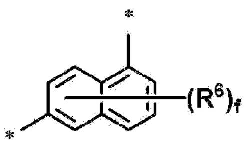
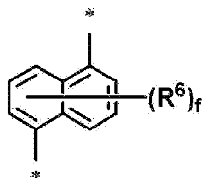

<Formula L-2-5> <Formula L-2-6> <Formula L-2-7>

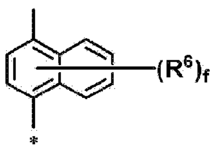
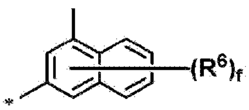
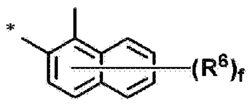

<Formula L-2-8>

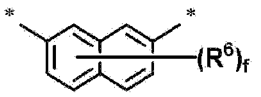

<Formula L-2-9>

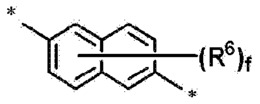

<Formula L-2-10>

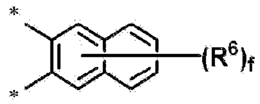

In Formula L-2-1 to Formula L-2-10, $R^6$ and f are the same as defined for Formula L-2.

In Formula 1, at least one of $Ar^3$ to $Ar^5$ may be selected from the group consisting of Formula Ar-1 to Formula Ar-12, but is not limited thereto.

<Formula Ar-1>

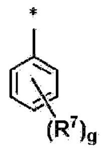

<Formula Ar-2>

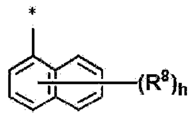

<Formula Ar-3>

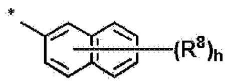

<Formula Ar-4>

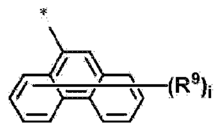

<Formula Ar-5>

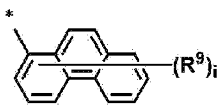

<Formula Ar-6>

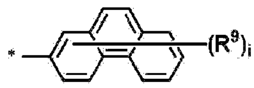

<Formula Ar-7>

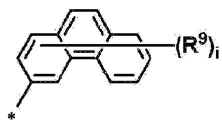

<Formula Ar-8>

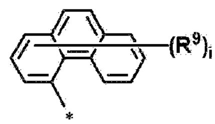

<Formula Ar-9>

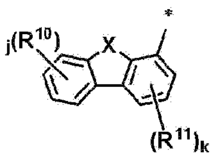

<Formula Ar-10>

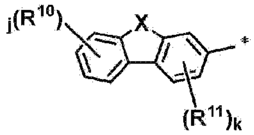

<Formula Ar-11>

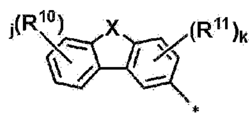

<Formula Ar-12>

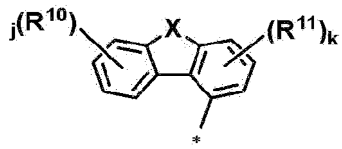

In Formula Ar-1 to Formula Ar-12, each symbol may be defined as follows.

$R^7$ to $R^{11}$ are each independently selected from the group consisting of hydrogen; deuterium; halogen; a silane group unsubstituted or substituted with a $C_1$-$C_{20}$ alkyl group or a $C_6$-$C_{20}$ aryl group; a phosphine oxide substituted or unsubstituted with a $C_1$-$C_{20}$ alkyl group or a $C_6$-$C_{20}$ aryl group; siloxane group; a cyano group; a nitro group; a $C_1$-$C_{20}$ alkylthio group; a $C_1$-$C_{20}$ alkoxy group; a $C_6$-$C_{30}$ aryloxy group; a $C_6$-$C_{30}$ arylthio group; a $C_1$-$C_{20}$ alkyl halide group; a $C_1$-$C_{20}$ alkyl group; a $C_2$-$C_{20}$ alkenyl group; a $C_2$-$C_{20}$ alkynyl group; a $C_6$-$C_{30}$ aryl group; a $C_6$-$C_{30}$ aryl group substituted with deuterium; a fluorenyl group; a $C_2$-$C_{30}$ heterocyclic group comprising at least one heteroatom selected from the group consisting of O, N, S, Si and P; and a $C_3$-$C_{30}$ aliphatic ring group; and adjacent groups may be bonded to each other to form a ring.

X is O or S.

g is an integer from 0 to 5, and h is an integer from 0 to 7, i is an integer from 0 to 9, j is an integer from 0 to 4, and k is an integer from 0 to 3, and when these are each an integer of 2 or more, each of $R^7$ groups, each of $R^8$ groups, each of $R^9$ groups, each of $R^{10}$ groups, each of $R^{11}$ groups are the same as or different from one another.

In Formula 2, at least one of $L^6$ to $L^8$ may be represented by Formula L-3 or Formula L-4.

<Formula L-3> <Formula L-4>

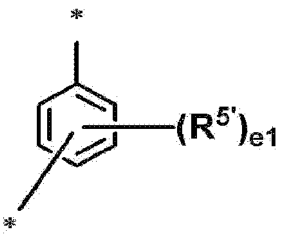

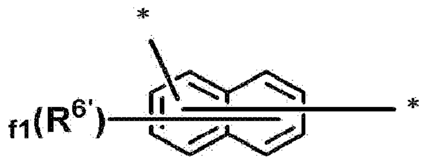

In Formula L-3 and L-4, each symbol may be defined as follows.

$R^{5'}$ and $R^{6'}$ are each independently selected from the group consisting of hydrogen; deuterium; a cyano group; a $C_6$-$C_{30}$ aryl group; and a $C_6$-$C_{30}$ aryl group substituted with deuterium, and adjacent groups may be bonded to each other to form an aromatic ring.

When adjacent groups are bonded to each other to form an aromatic ring, the aromatic ring group may be, for example, a $C_6$-$C_{20}$, a $C_6$-$C_{18}$, a $C_6$-$C_{16}$, a $C_6$-$C_{14}$, a $C_6$-$C_{13}$, a $C_6$-$C_{12}$, a $C_6$-$C_{10}$, a $C_6$, a $C_{10}$, a $C_{12}$, a $C_{14}$, a $C_{15}$, a $C_{16}$, a $C_{18}$ aromatic ring group, specifically, it may be an aryl ring such as benzene, naphthalene, anthracene, phenanthrene, pyrene, etc.

e1 is an integer from 0 to 4, and f1 is an integer from 0 to 6. When e1 and f1 are each an integer of 2 or more, each of $R^{5'}$ groups and each of $R^{6'}$ groups are the same as or different from one another.

Formula L-3 may be represented by one of Formula L-3-1 to Formula L-3-3.

<Formula L-3-1> <Formula L-3-2> <Formula L-3-3>

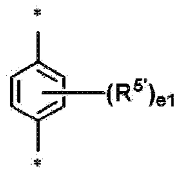

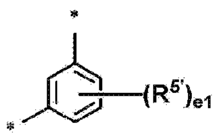

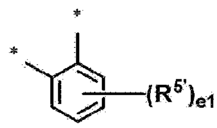

In Formula L-3-1 to Formula L-3-3, $R^{5'}$ and e1 are the same as defined for Formula L-3.

Formula L-4 may be selected from the group consisting of Formula L-4-1 to Formula L-4-10.

<Formula L-4-1> <Formula L-4-2> <Formula L-4-3> <Formula L-4-4>

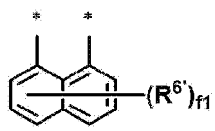

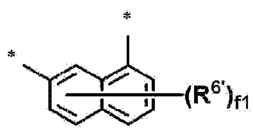

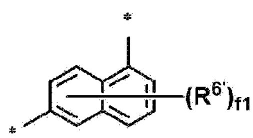

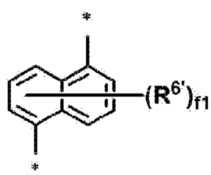

<Formula L-4-5> <Formula L-4-6> <Formula L-4-7>

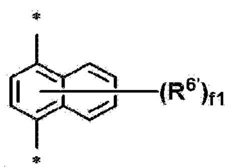

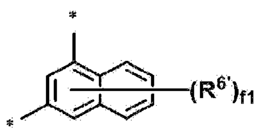

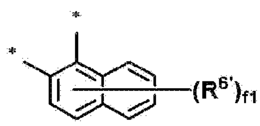

<Formula L-4-8> <Formula L-4-9> <Formula L-4-10>

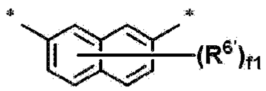

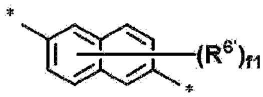

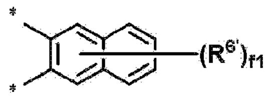

In Formula L-4-1 to Formula L-4-10, $R^{6'}$ and f1 are the same as defined for Formula L-4.

In Formula 2, at least one of $Ar^6$ to $Ar^8$ may be selected from the group consisting of Formula Ar-13 to Formula Ar-20, but is not limited thereto.

<Formula Ar-13> <Formula Ar-14> <Formula Ar-15> <Formula Ar-16>

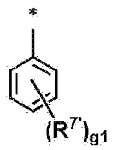

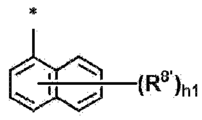

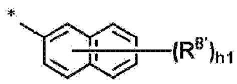

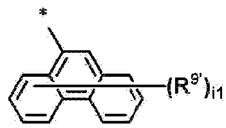

<Formula Ar-17> <Formula Ar-18> <Formula Ar-19> <Formula Ar-20>

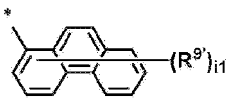

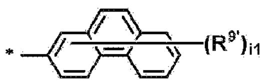

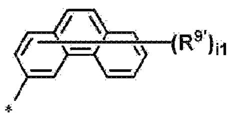

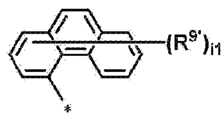

In Formula Ar-13 to Formula Ar-20, each symbol may be defined as follows.

$R^{7'}$ to $R^{9'}$ are each independently selected from the group consisting of hydrogen; deuterium; a cyano group; a $C_6$-$C_{30}$ aryl group; and a $C_6$-$C_{30}$ aryl group substituted with deuterium, and adjacent groups may be bonded to each other to form an aromatic ring.

When adjacent groups are bonded to each other to form an aromatic ring, the aromatic ring group may be, for example, a $C_6$-$C_{20}$, a $C_6$-$C_{18}$, a $C_6$-$C_{16}$, a $C_6$-$C_{14}$, a $C_6$-$C_{13}$, a $C_6$-$C_{12}$, a $C_6$-$C_{10}$, a $C_6$, a $C_{10}$, a $C_{12}$, a $C_{14}$, a $C_{15}$, a $C_{16}$, a $C_{18}$ aromatic ring group, specifically, it may be an aryl ring such as benzene, naphthalene, anthracene, phenanthrene, pyrene, etc.

g1 is an integer from 0 to 5, h1 is an integer from 0 to 7, i1 is an integer from 0 to 9, j1 is an integer from 0 to 4, and k1 is an integer from 0 to 3. When each of g1, h1, i1, j1, and k1 is an integer of 2 or more, each of the plurality of $R^{7'}$, each of the plurality of $R^{8'}$, and each of the plurality of $R^{9'}$ is the same as or different from one another.

Formula 3 may be represented by one of Formula 3-1 to Formula 3-6.

<Formula 3-1> <Formula 3-2>

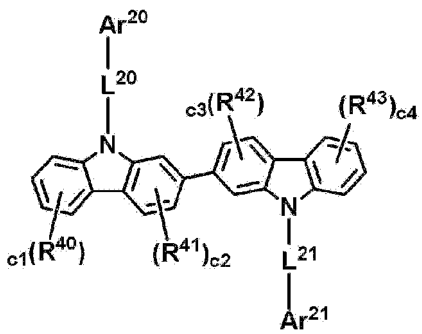

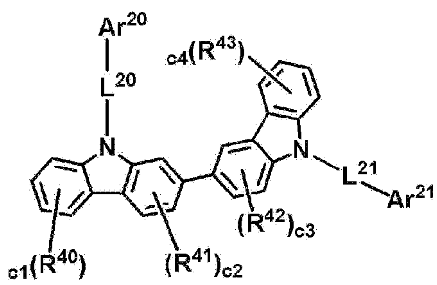

<Formula 3-3>

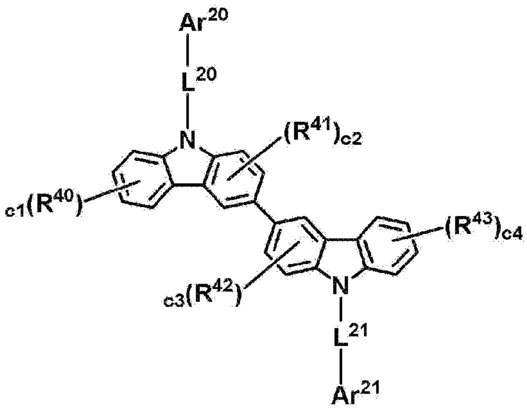

<Formula 3-4>

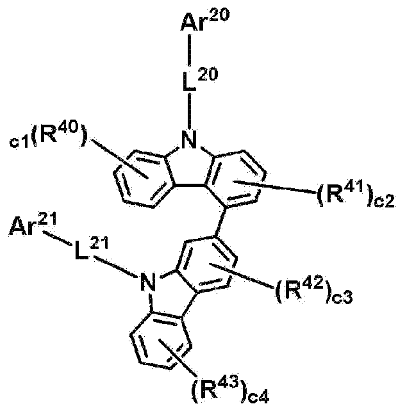

<Formula 3-5>

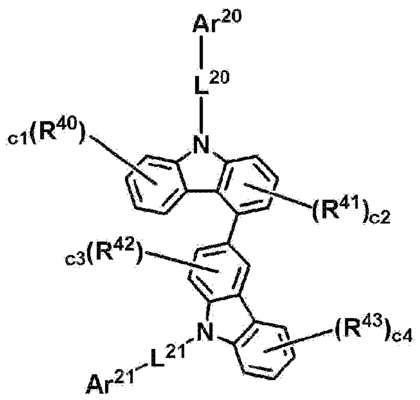

<Formula 3-6>

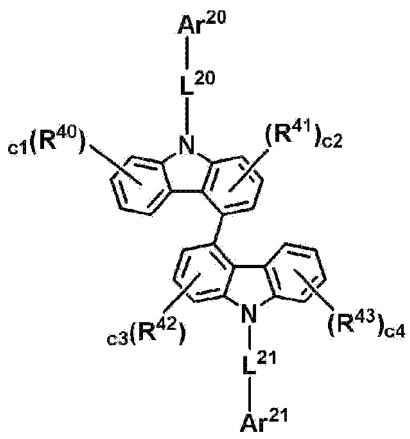

In Formula 3-1 to Formula 3-6, $Ar^{20}$, $Ar^{21}$, $L^{20}$, $L^{21}$, $R^{40}$, $R^{41}$, $R^{42}$, $R^{43}$, c1, c2, c3 and c4 are the same as defined for Formula 3.

Specifically, compound represented by Formula 1 may be one of the following compounds P2-1 to P2-104, P3-1 to 3-92, compound represented by Formula 2 may be one of the following compounds P3-1 to 3-92, but there is no limitation thereto.

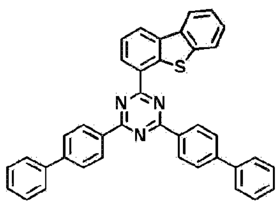

**P2-1**

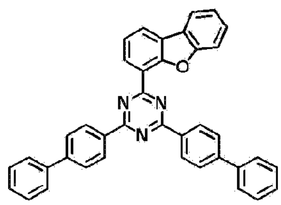

**P2-2**

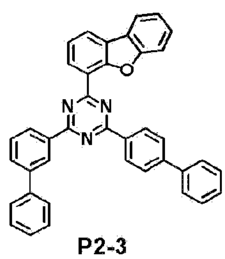

**P2-3**

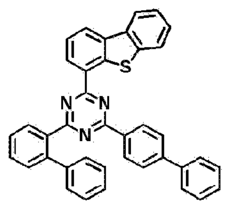

**P2-4**

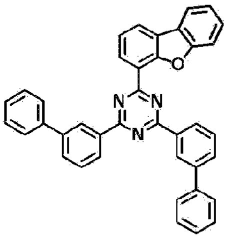

P2-5

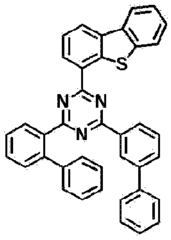

P2-6

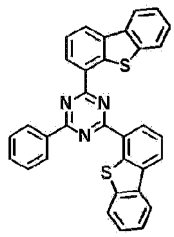

P2-7

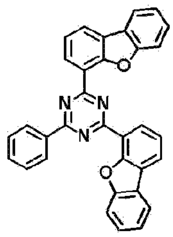

P2-8

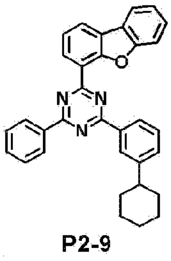

P2-9

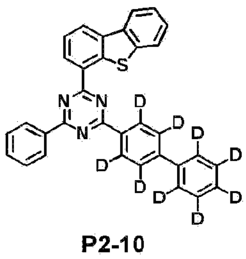

P2-10

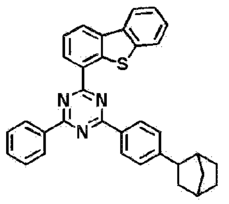

P2-11

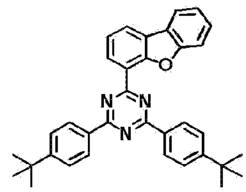

P2-12

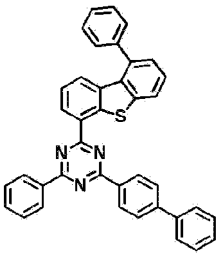

P2-13

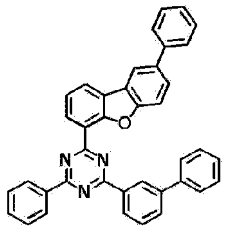

P2-14

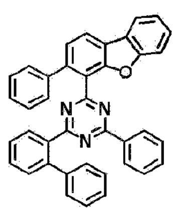

P2-15

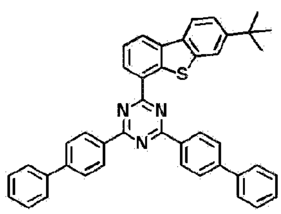

P2-16

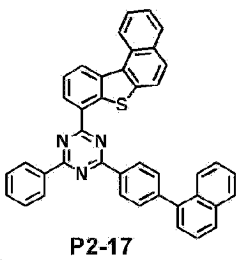

P2-17

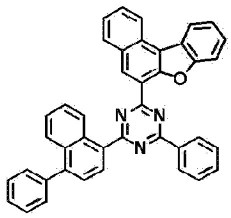

P2-18

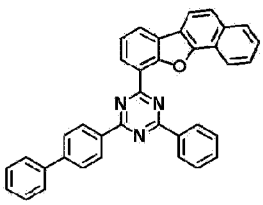

P2-19

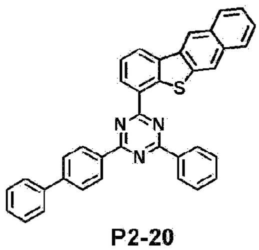

P2-20

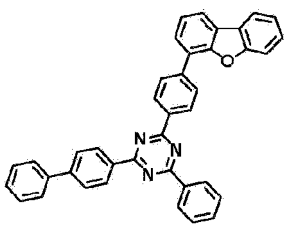

P2-21

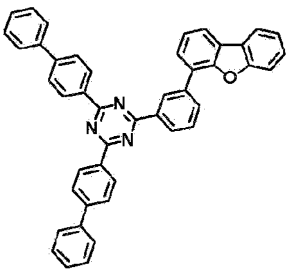

P2-22

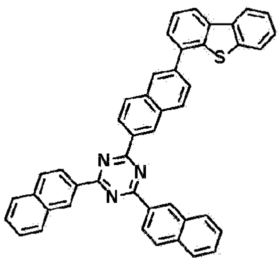

P2-23

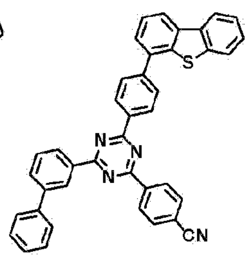

P2-24

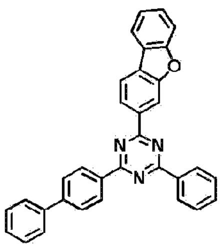

**P2-25**

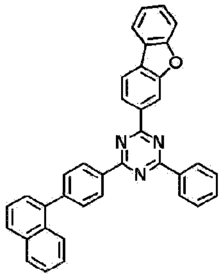

**P2-26**

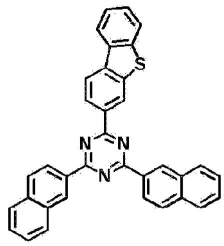

**P2-27**

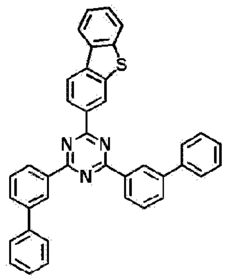

**P2-28**

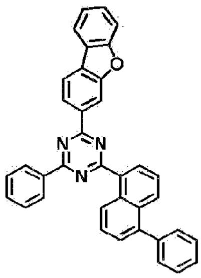

**P2-29**

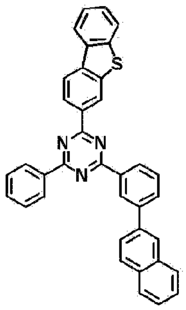

**P2-30**

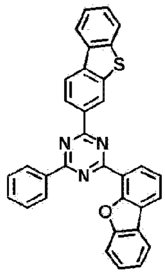

**P2-31**

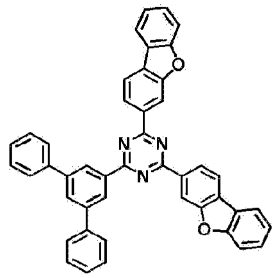

**P2-32**

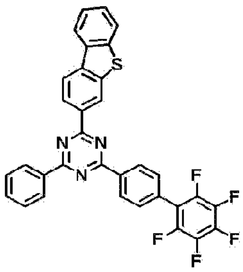

**P2-33**

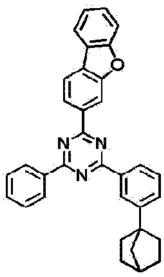

**P2-34**

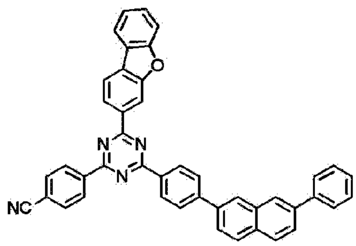

**P2-35**

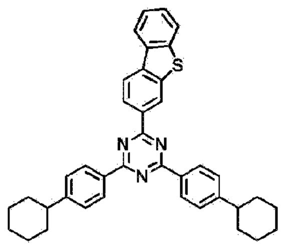

**P2-36**

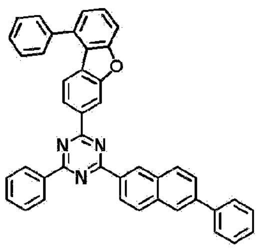

**P2-37**

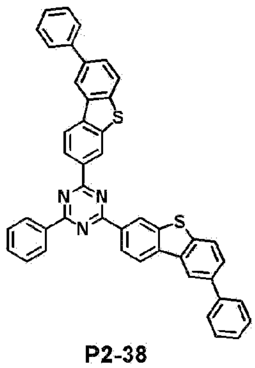

**P2-38**

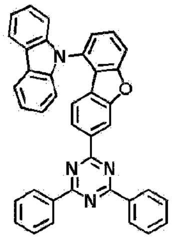

**P2-39**

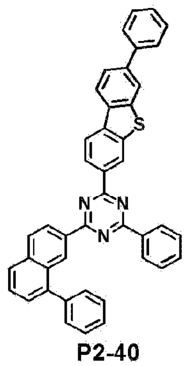

**P2-40**

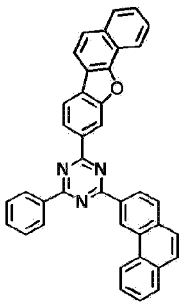

P2-41

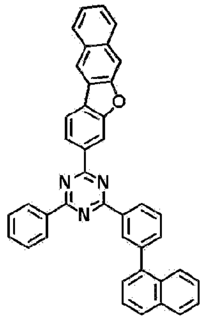

P2-42

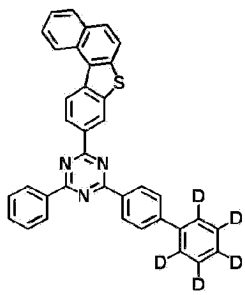

P2-43

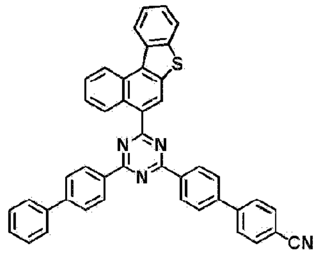

P2-44

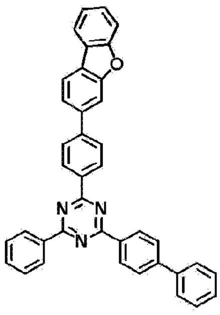

P2-45

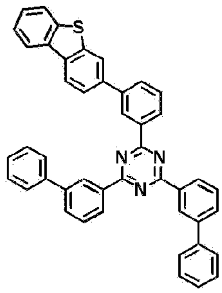

P2-46

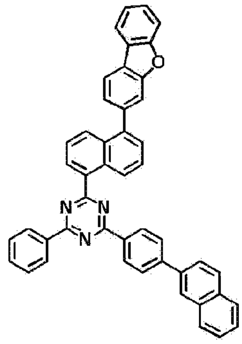

P2-47

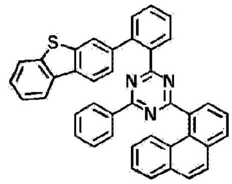

P2-48

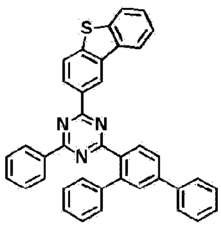

P2-49

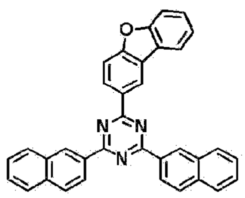

P2-50

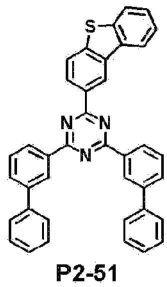

P2-51

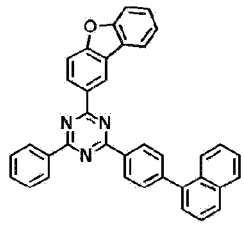

P2-52

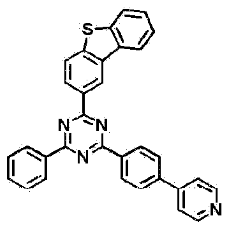

P2-53

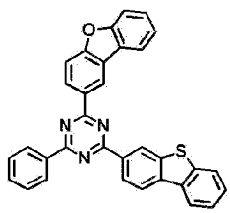

P2-54

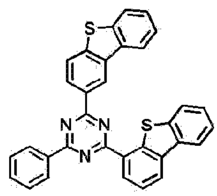

P2-55

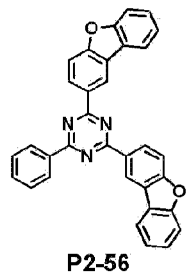

P2-56

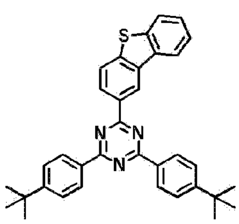

P2-57

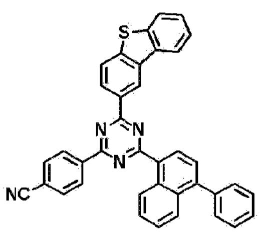

P2-58

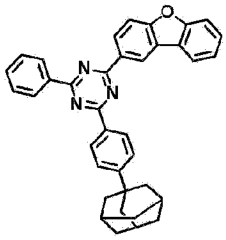

P2-59

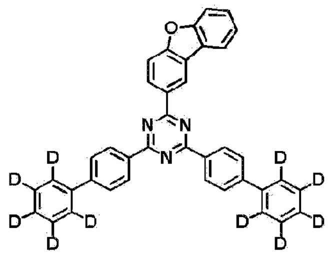

P2-60

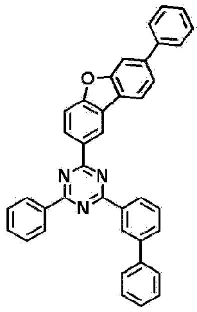

P2-61

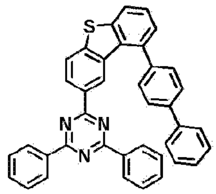

P2-62

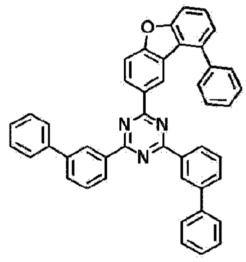

P2-63

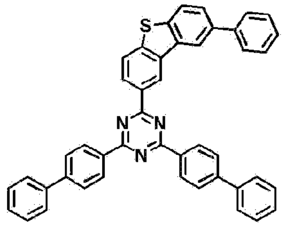

P2-64

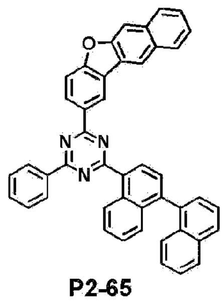

P2-65

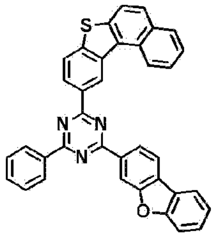

P2-66

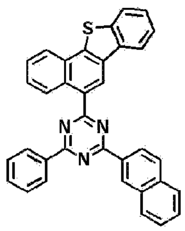

P2-67

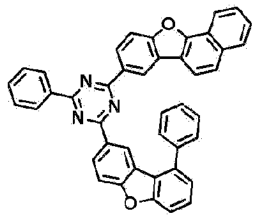

P2-68

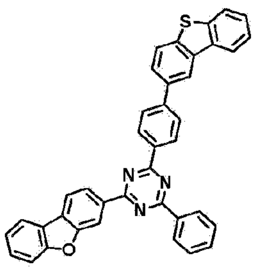

P2-69

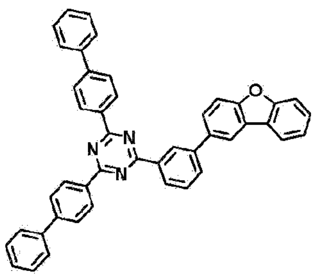

P2-70

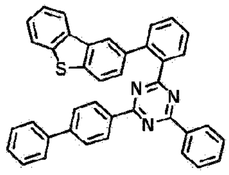

P2-71

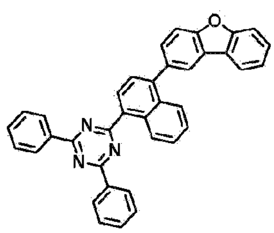

P2-72

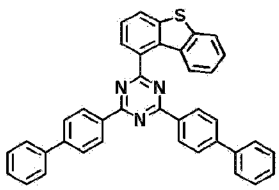

P2-73

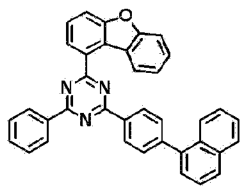

P2-74

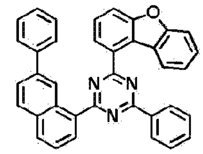

P2-75

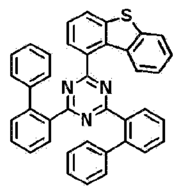

P2-76

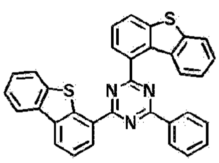

P2-77

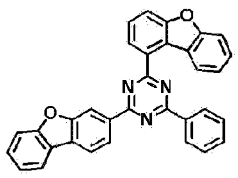

P2-78

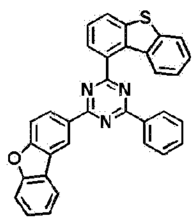

P2-79

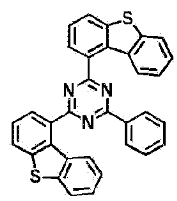

P2-80

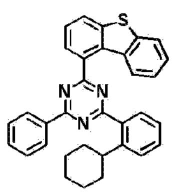
P2-81

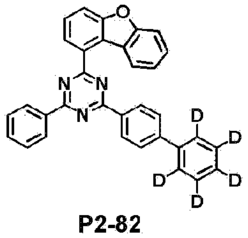
P2-82

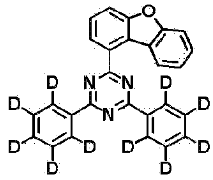
P2-83

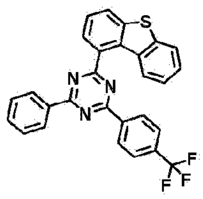
P2-84

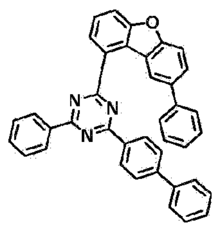
P2-85

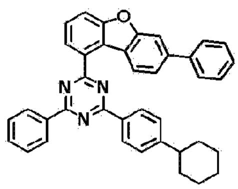
P2-86

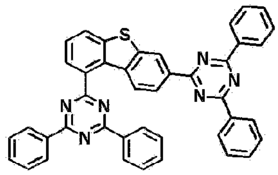
P2-87

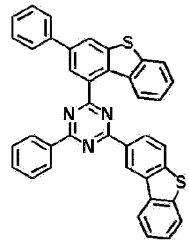
P2-88

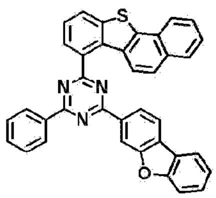
P2-89

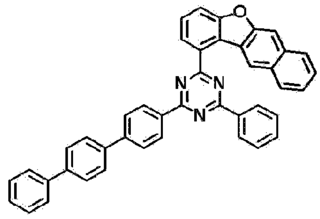
P2-90

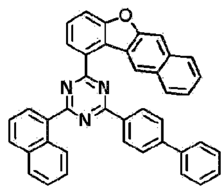
P2-91

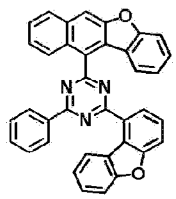
P2-92

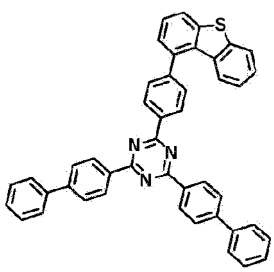
P2-93

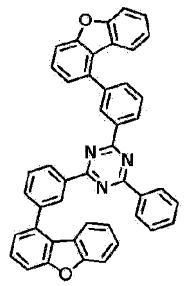
P2-94

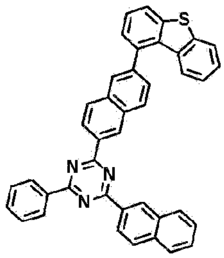
P2-95

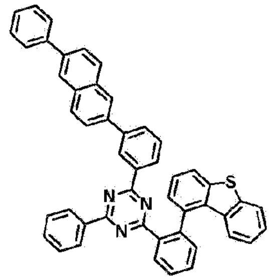
P2-96

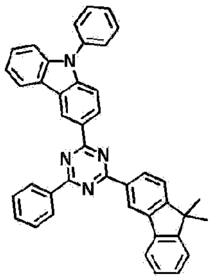
P2-97

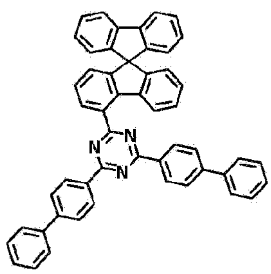
P2-98

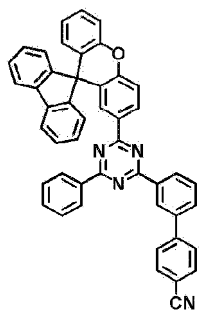
P2-99

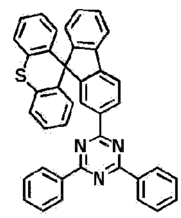
P2-100

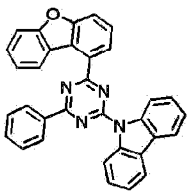
P2-101

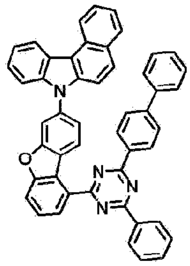
P2-102

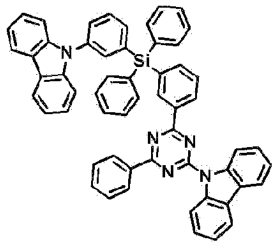
P2-103

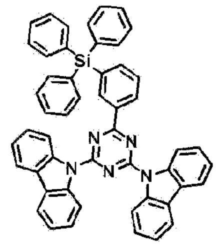
P2-104

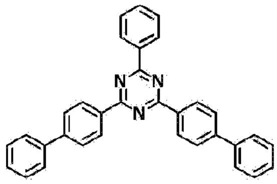
P3-1

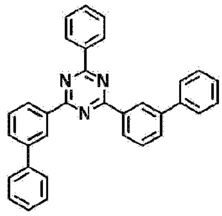
P3-2

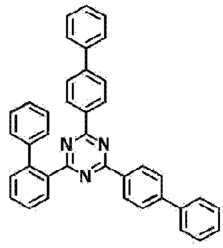
P3-3

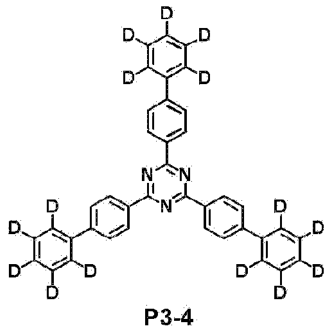
P3-4

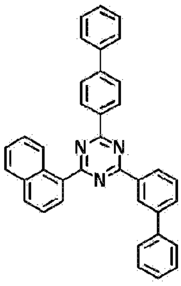
P3-5

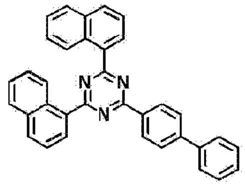
P3-6

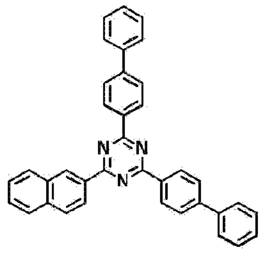
P3-7

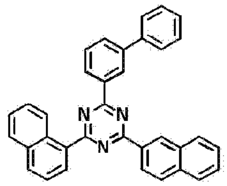
P3-8

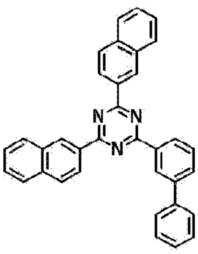
P3-9

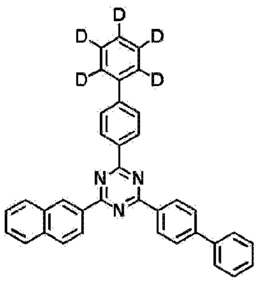
P3-10

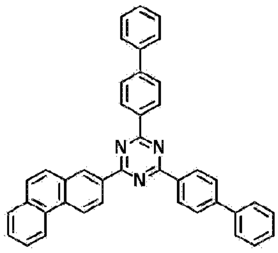
P3-11

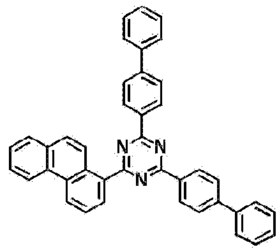
P3-12

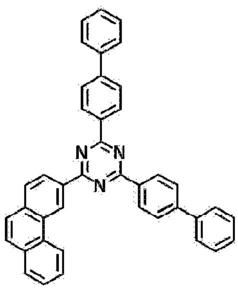
P3-13

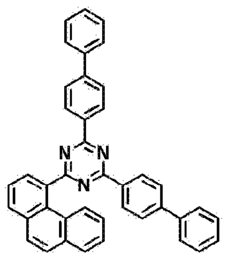
P3-14

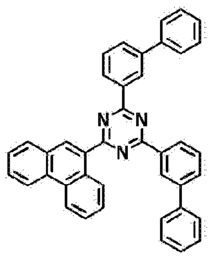
P3-15

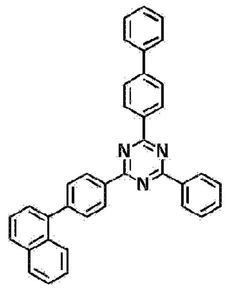
P3-16

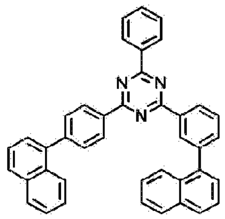
P3-17

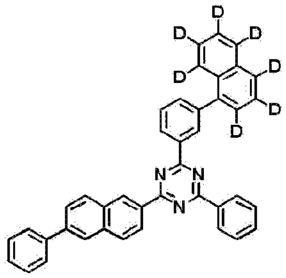
P3-18

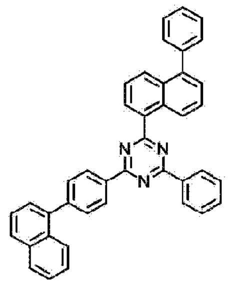
P3-19

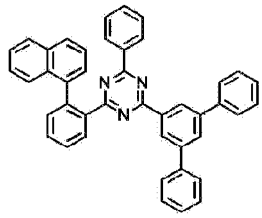
P3-20

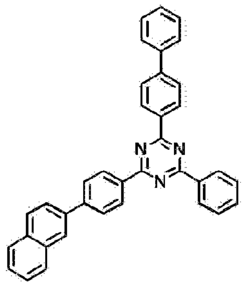
P3-21

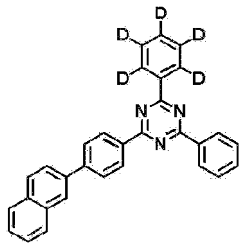
P3-22

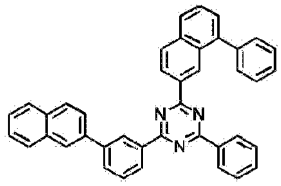
P3-23

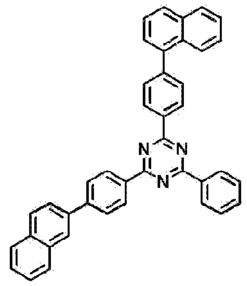
P3-24

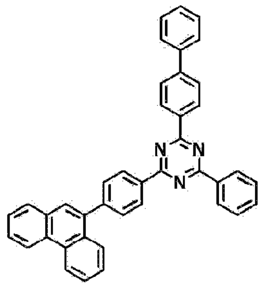
P3-25

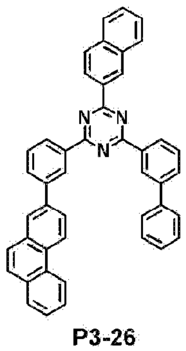
P3-26

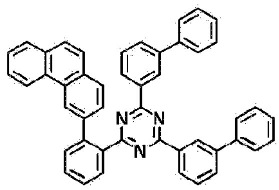
P3-27

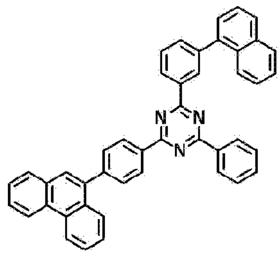
P3-28

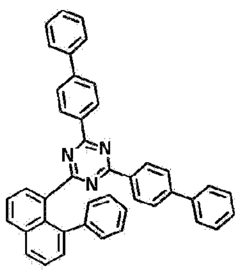
P3-29

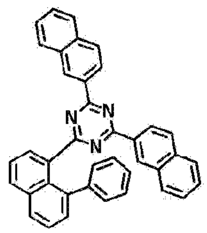
P3-30

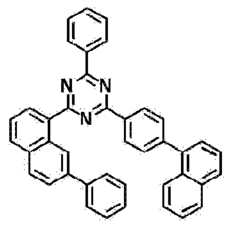
P3-31

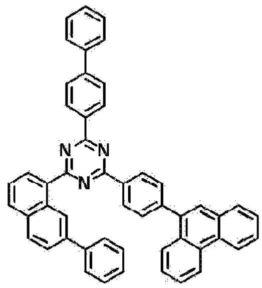
P3-32

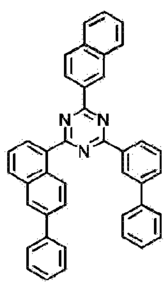
P3-33

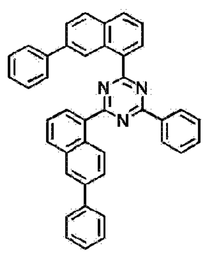
P3-34

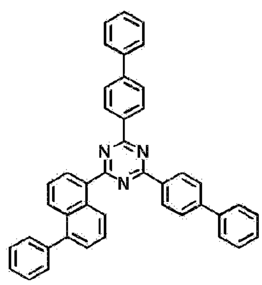
P3-35

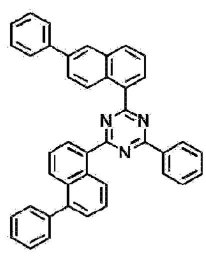
P3-36

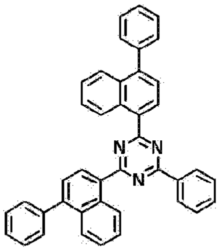
P3-37

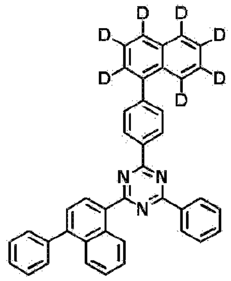
P3-38

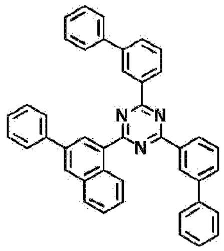
P3-39

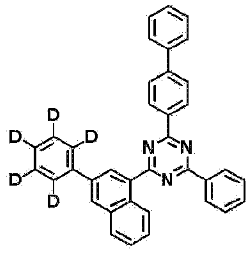
P3-40

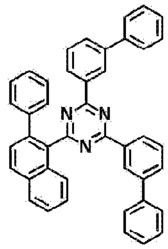
P3-41

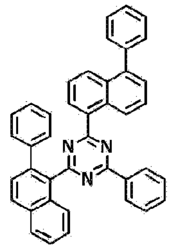
P3-42

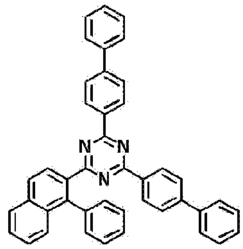
P3-43

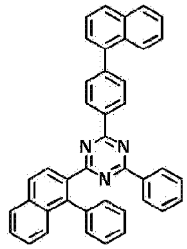
P3-44

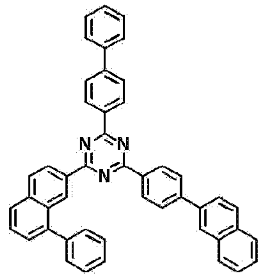
P3-45

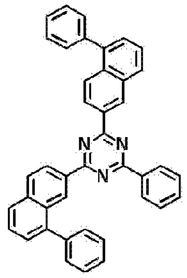
P3-46

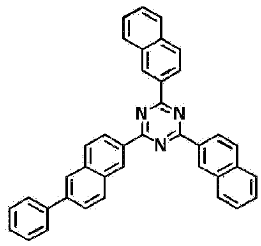
P3-47

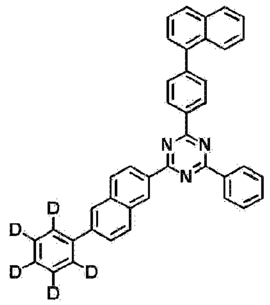
P3-48

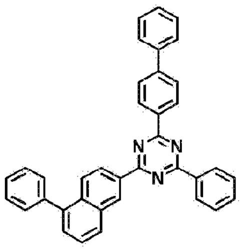
P3-49

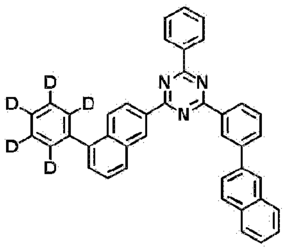
P3-50

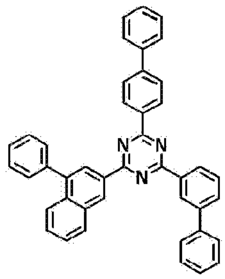
P3-51

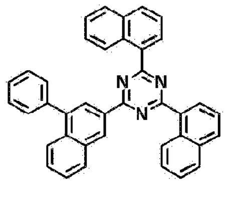
P3-52

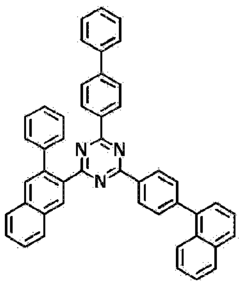
P3-53

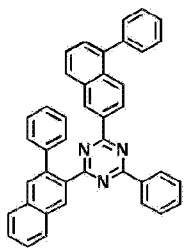
P3-54

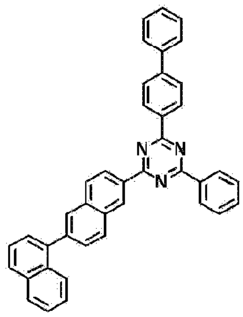
P3-55

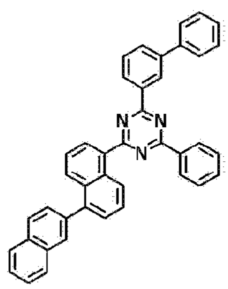
P3-56

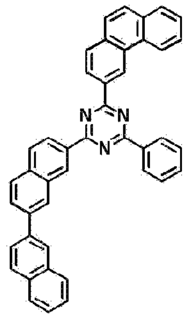
P3-57

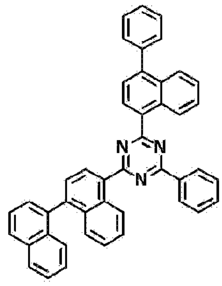
P3-58

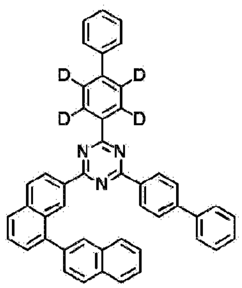
P3-59

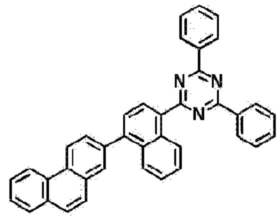
P3-60

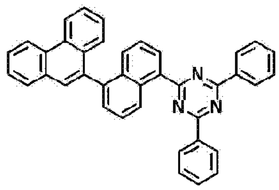
P3-61

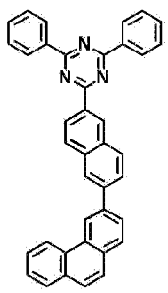
P3-62

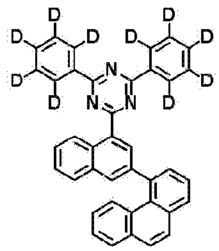
P3-63

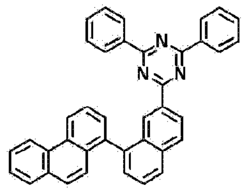
P3-64

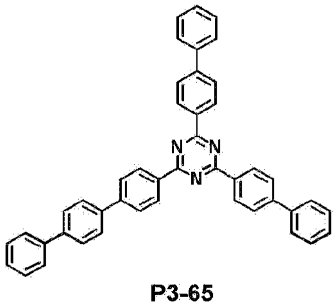
P3-65

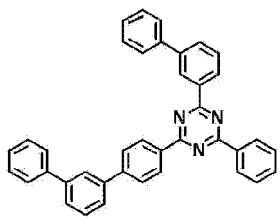
P3-66

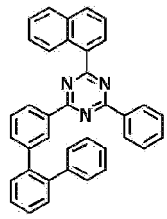
P3-67

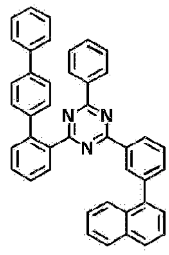
P3-68

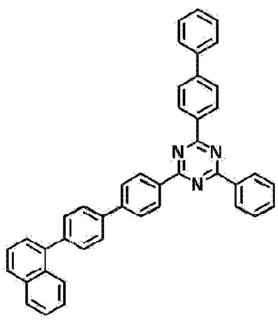
P3-69

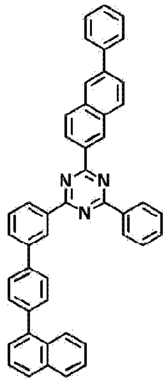
P3-70

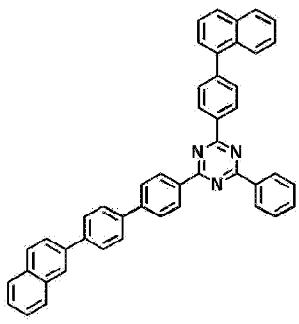
P3-71

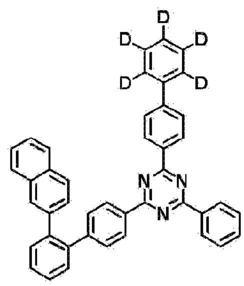
P3-72

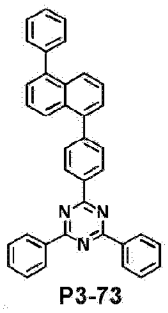

P3-73

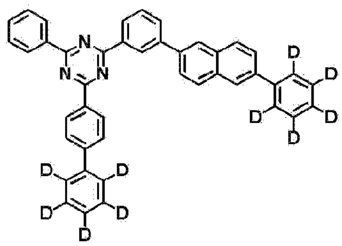

P3-74

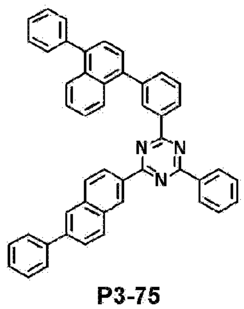

P3-75

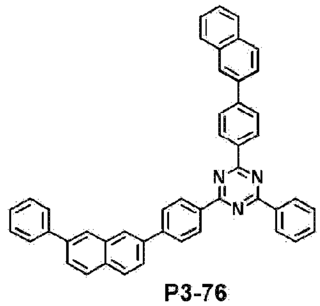

P3-76

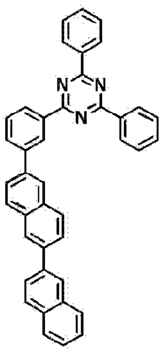

P3-77

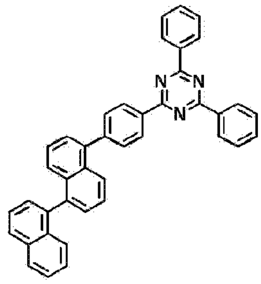

P3-78

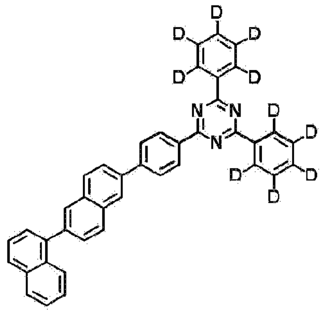

P3-79

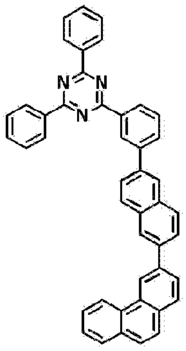

P3-80

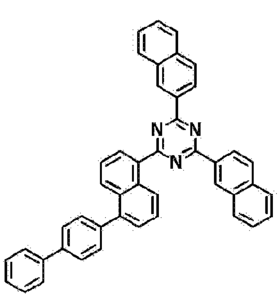

P3-81

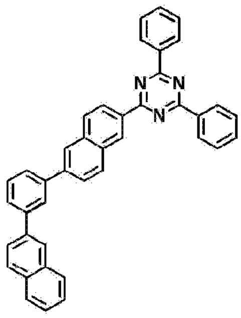

P3-82

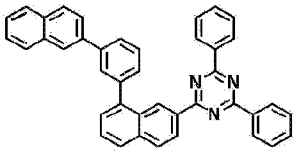

P3-83

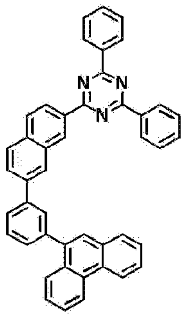

P3-84

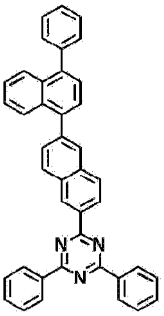

P3-85

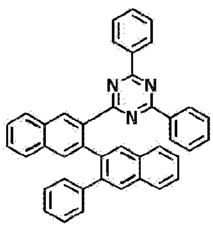

P3-86

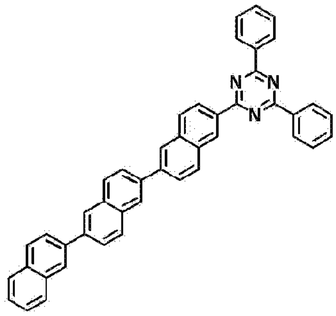

P3-87

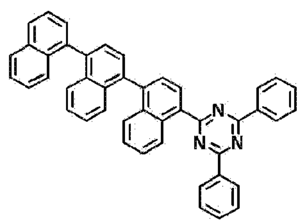

P3-88

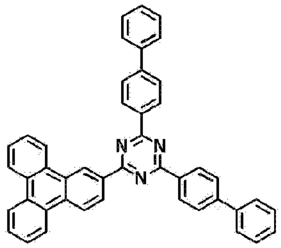
P3-89

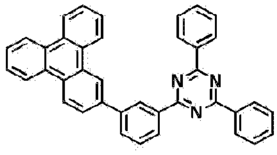
P3-90

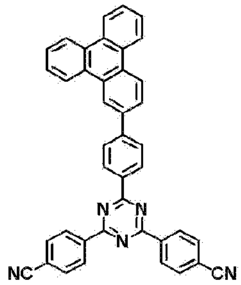
P3-91

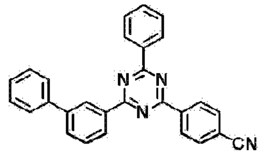
P3-92
.

Specifically, compound represented by Formula 3 may be one of the following compounds, but there is no limitation thereto.

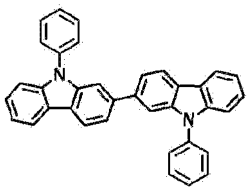
P5-1

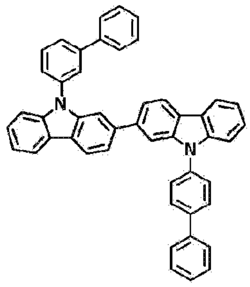
P5-2

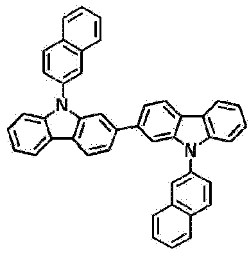
P5-3

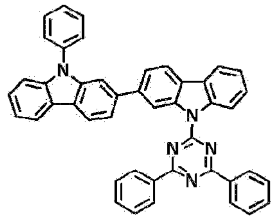
P5-4

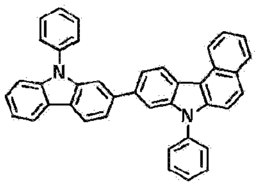
P5-5

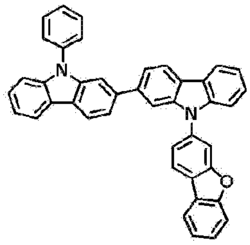
P5-6

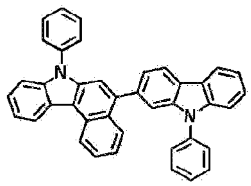
P5-7

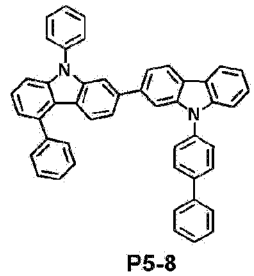
P5-8

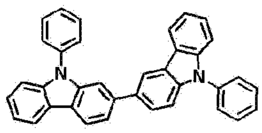
P5-9

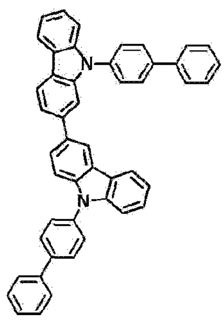
P5-10

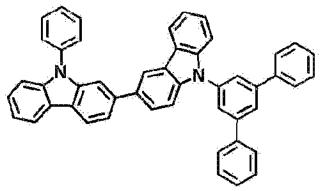
P5-11

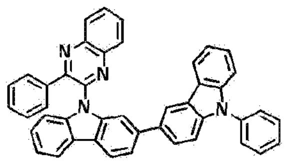
P5-12

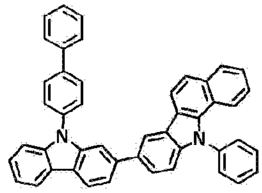

P5-13

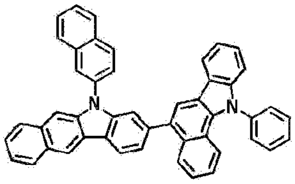

P5-14

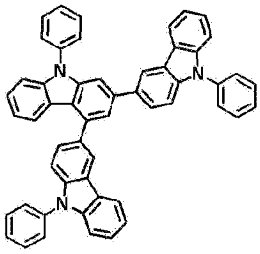

P5-15

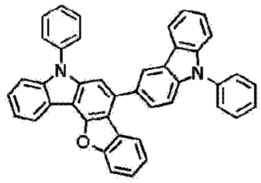

P5-16

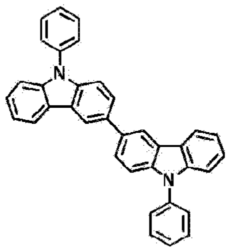

P5-17

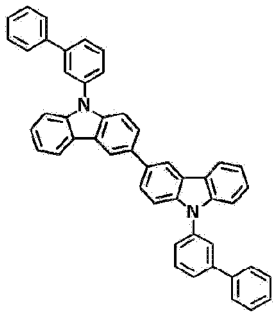

P5-18

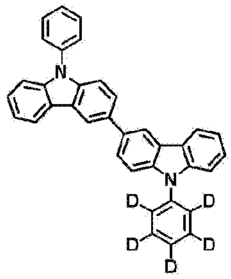

P5-19

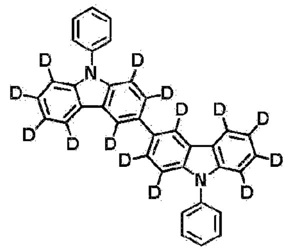

P5-20

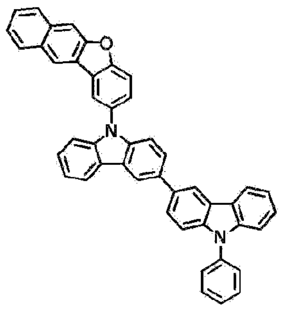

P5-21

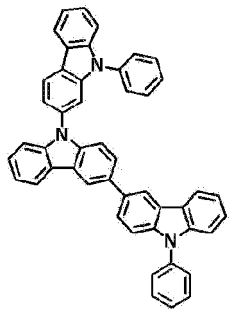

P5-22

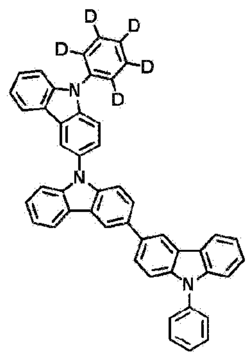

P5-23

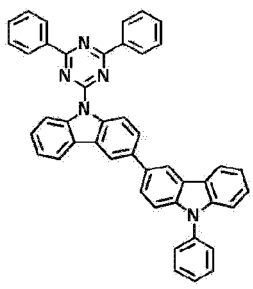

P5-24

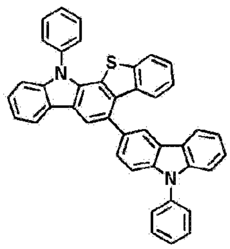

P5-25

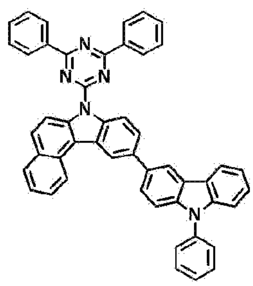

P5-26

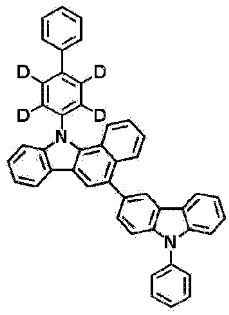

P5-27

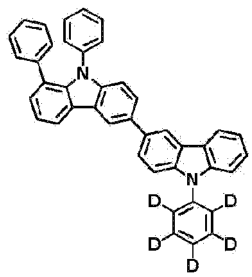

P5-28

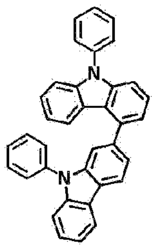

P5-29

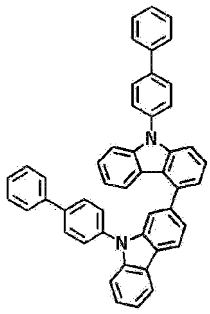

P5-30

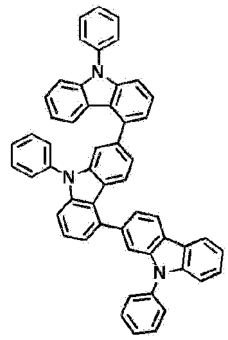

P5-31

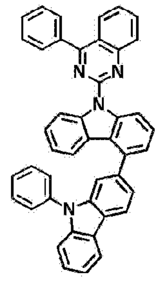

P5-32

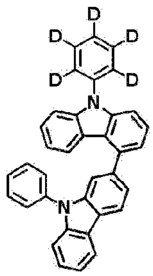

P5-33

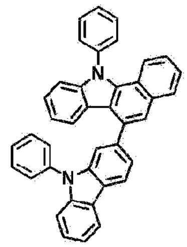

P5-34

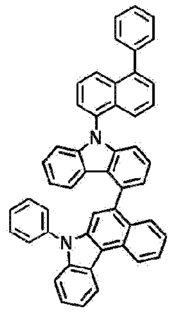

P5-35

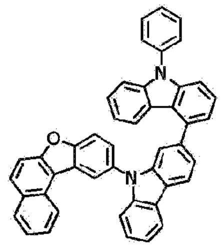

P5-36

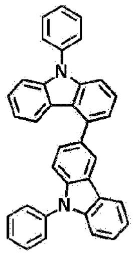

P5-37

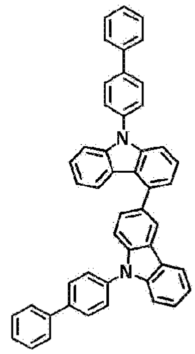

P5-38

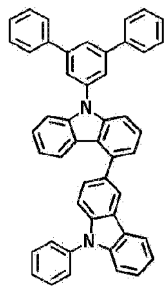

P5-39

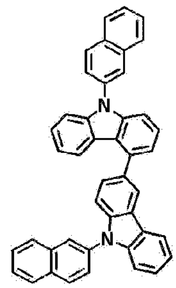

P5-40

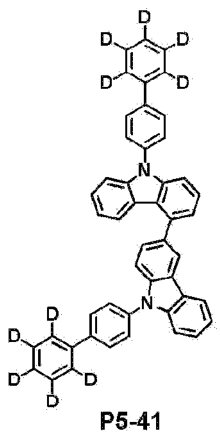

P5-41

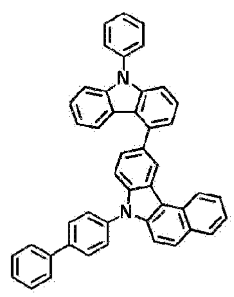

P5-42

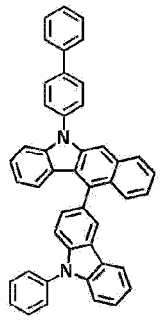

P5-43

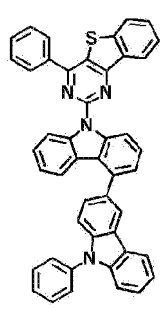

P5-44

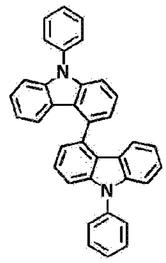

P5-45

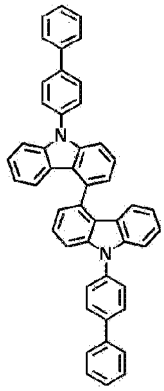

P5-46

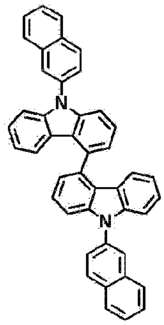

P5-47

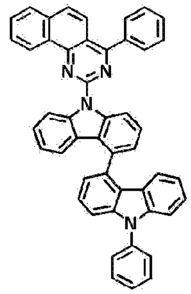

P5-48

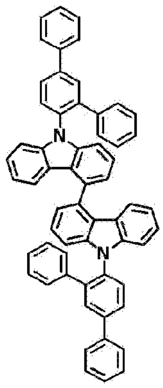

P5-49

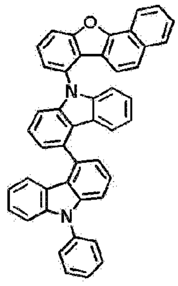

P5-50

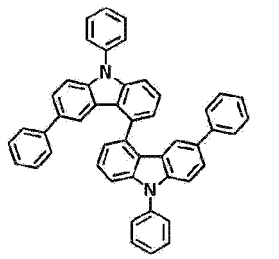

P5-51

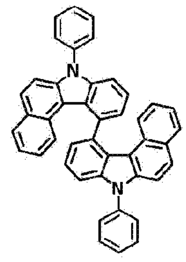

P5-52

The reorganization energy of a compound used as a host may affect the performance of an organic light-emitting device, and the reorganization energy will be described below.

Reorganization energy is the energy lost due to changes in molecular geometry during charge (electron or hole) transfer. It is dependent on molecular geometry and tends to be smaller when the difference between the potential energy surfaces (PES) of the neutral and charged states is smaller. The RE value can be obtained using the following equation.

$$\mathrm{RE_{hole}} : \lambda^{+} = (E_{\mathrm{NOCE}} - E_{\mathrm{COCE}}) + (E_{\mathrm{CONE}} - E_{\mathrm{NONE}})$$

$$\mathrm{RE_{elec}} : \lambda^{-} = (E_{\mathrm{NOAE}} - E_{\mathrm{AOAE}}) + (E_{\mathrm{AONE}} - E_{\mathrm{NONE}})$$

NONE: Neutral geometry of neutral molecular (= NO opt.)
NOAE: Anion geometry of neutral molecular
NOCE: Cation geometry of neutral molecular
AONE: Neutral geometry of Anion molecular
AOAE: Anion geometry of Anion molecular (= AO opt.)
CONE: Neutral geometry of cation molecular
COCE: Cation geometry of cation molecular (= CO opt.)

Reorganization energy and charge mobility have an inverse relationship. When r and *T* are held constant, the RE value directly influences the mobility of each material.

The relationship between reorganization energy (RE) and mobility can be expressed as the following equation, and it is described based on the charge transfer matrix element.

$$\mu = k\frac{r^2}{2k_BT/e}$$

$$k = \left(\frac{4\pi^2}{h}\right)\frac{t^2}{\sqrt{4\pi\lambda k_BT}}\exp\left[-\frac{\lambda}{4k_BT}\right]$$

$\lambda$ : Reorganization energy
$\mu$ : mobility
r : dimer displacement
t : intermolecular

As shown in the equation above, charge mobility increases as the RE value decreases.

To calculate the reorganization energy, a simulation tool that can compute the potential energy of a molecule based on its geometry is necessary. For example, Gaussian09 (hereinafter referred to as G09) and the Jaguar (hereinafter referred to as JG) module in Schrödinger Materials Science can be used. Both G09 and JG are quantum mechanical (QM) computational tools used for analyzing molecular properties, and they are capable of optimizing molecular structures and computing the single-point energy for a given molecular structure.

Quantum mechanical (QM) calculations performed on molecular structures require substantial computational resources. For example, such calculations may be executed using two cluster servers, each comprising four node workstations and one master workstation. Each node workstation is capable of performing molecular QM calculations via parallel processing based on symmetric multiprocessing (SMP), utilizing CPUs having 36 or more cores.

Using Gaussian 09 (G09), molecular structures optimized for neutral and charged states are calculated along with their corresponding potential energies (NONE and COCE), which are necessary for determining the reorganization energy. Subsequently, by altering only the charge of each of the two optimized structures, the potential energy of the neutral-state-optimized structure under the charged state (NOCE) and the potential energy of the charged-state-optimized structure under the neutral state (CONE) are calculated. The reorganization energy is then determined based on the following relationship.

$$\mathrm{RE_{charge}} : \lambda = (E_{\mathrm{NOCE}} - E_{\mathrm{COCE}}) + (E_{\mathrm{CONE}} - E_{\mathrm{NONE}})$$

Since Schrödinger provides a function for automatically performing the aforementioned calculation process, the JG module is capable of sequentially calculating the potential energies of each state and determining the rearrangement energy (RE) value by simply inputting the molecular structure (NO) of the ground state.

Hereinafter, the present invention will be described in further detail with reference to specific examples regarding the synthesis of compounds represented by Formula 1 to Formula 3 and the fabrication of an organic electronic device. However, the present invention is not limited to the following examples.

[Synthesis example 1] Compound of Formula 1

Compound represented by Formula 1 (Final Product 2) according to the present invention may be synthesized as shown in Reaction Scheme 1 below, but is not limited thereto.

<Reaction Scheme 1>

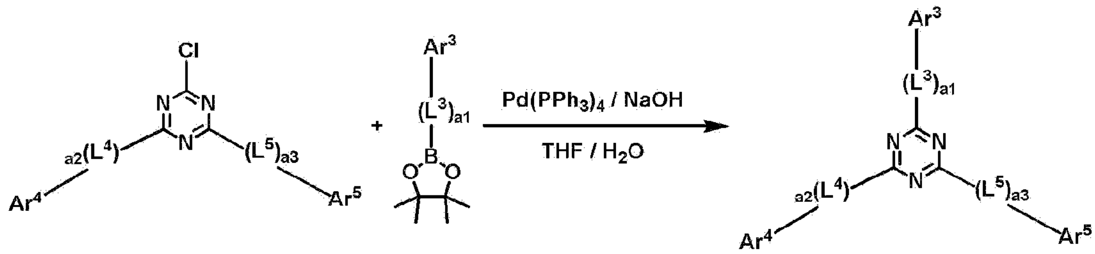


Sub3 Sub4 Final Product 2

1. Synthesis example of P2-1

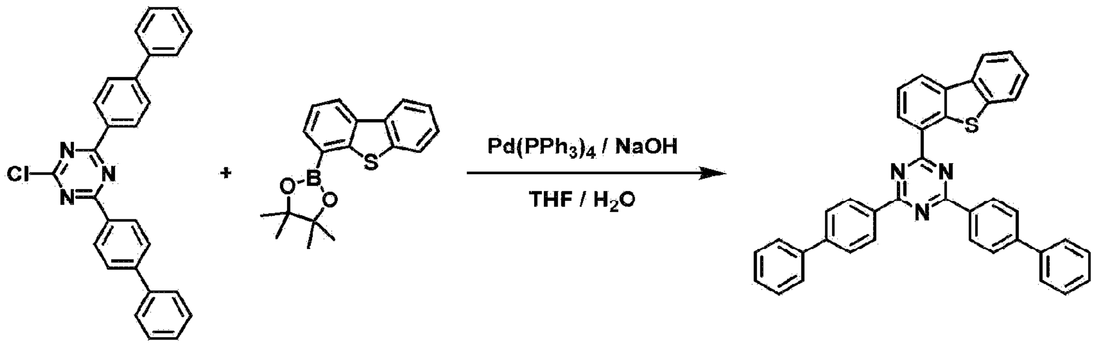


Sub3-1 Sub4-1 P2-1

Sub3-1 (13.5 g, 32.2 mmol) was dissolved in tetrahydrofuran (THF) (161 mL), followed by the addition of Sub4-1 (10.0 g, 32.2 mmol), NaOH (3.9 g, 96.7 mmol), $Pd(PPh_3)_4$ (2.23 g, 1.93 mmol), and water (81 mL). The reaction mixture was stirred at 80 °C. After completion of the reaction, the mixture was extracted with $CH_2Cl_2$ and water. The organic layer was dried over $MgSO_4$ and concentrated. Then, the concentrate was purified by silica gel column chromatography and recrystallized to obtain 14.5 g of the product. (Yield: 79%)

2. Synthesis example of P2-19

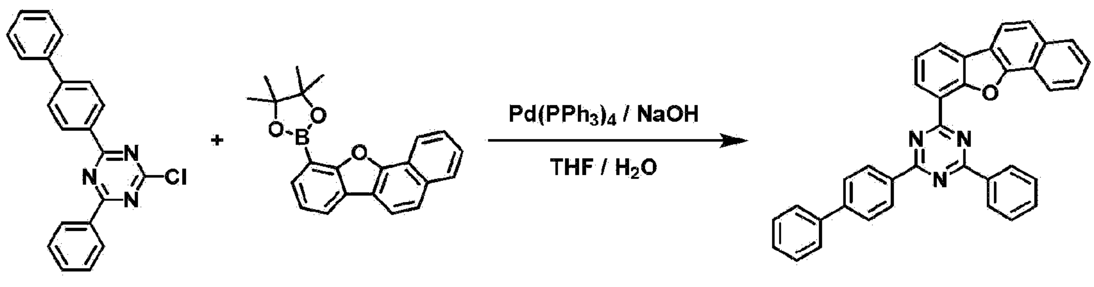


Sub3-19 Sub4-19 P2-19

Sub3-19 (10.0 g, 29.1 mmol) was dissolved in THF (145 mL), and Sub4-19 (10.0 g, 29.1 mmol), NaOH (3.5 g, 87.2 mmol), $Pd(PPh_3)_4$ (2.01 g, 1.74 mmol), and water (73 mL) were added thereto. The synthesis was carried out in the same manner as in the synthesis example of P2-1 to obtain 11.6 g of the product. (Yield: 76%)

3. Synthesis example of P2-68

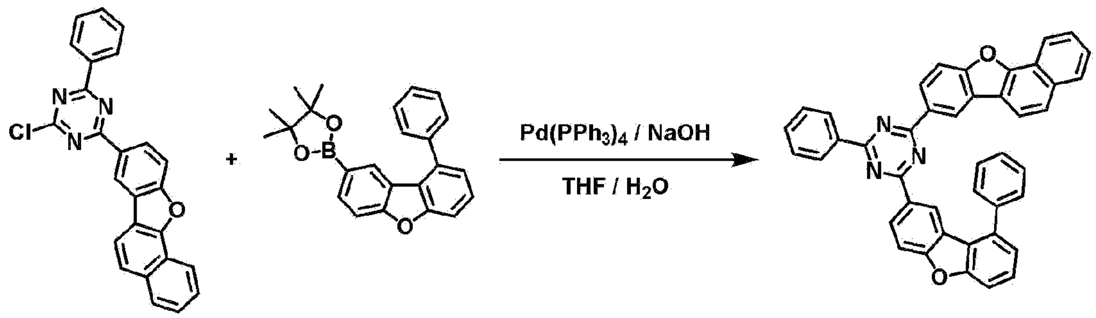


Sub3-68 Sub4-68 P2-68

Sub3-68 (11.0 g, 27.0 mmol) was dissolved in THF (135 mL), and Sub4-68 (10.0 g, 27.0 mmol), NaOH (3.2 g, 81.0 mmol), $Pd(PPh_3)_4$ (1.87 g, 1.62 mmol), and water (68 mL) were added thereto. The synthesis was carried out in the same manner as in the synthesis example of P2-1 to obtain 12.8 g of the product. (Yield: 77%)

4. Synthesis example of P2-72

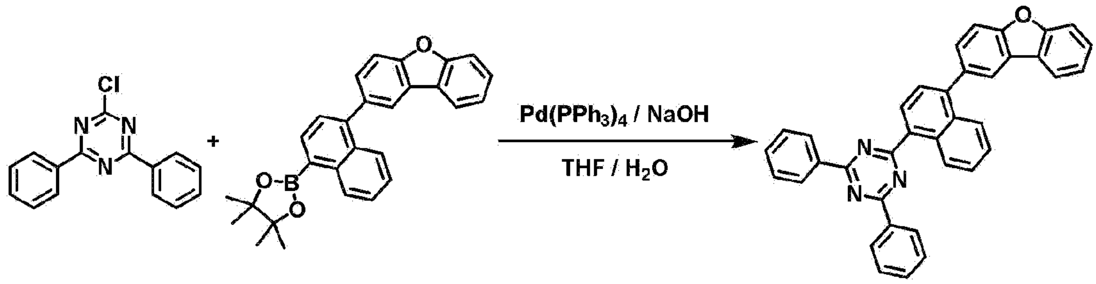


Sub2-41 Sub4-72 P2-72

Sub2-41 (6.4 g, 23.8 mmol) was dissolved in THF (119 mL), and Sub4-72 (10.0 g, 23.8 mmol), NaOH (2.9 g, 71.4 mmol), $Pd(PPh_3)_4$ (1.65 g, 1.43 mmol), and water (59 mL) were added thereto. The synthesis was carried out in the same manner as in the synthesis example of P2-1 to obtain 9.0 g of the product. (Yield: 72%)

5. Synthesis example of P2-97

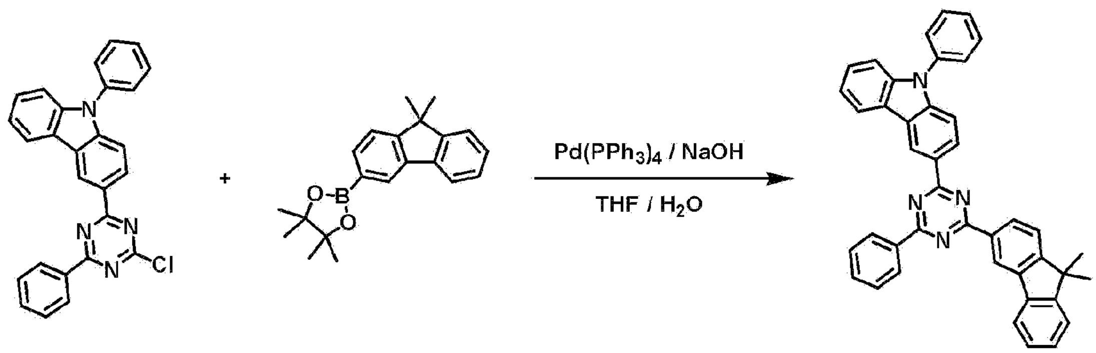


Sub3-97 Sub4-97 P2-97

Sub3-97 (13.5 g, 31.2 mmol) was dissolved in THF (156 mL), and Sub4-97 (10.0 g, 31.2 mmol), NaOH (3.7 g, 93.7 mmol), $Pd(PPh_3)_4$ (2.17 g, 1.87 mmol), and water (78 mL) were added thereto. The synthesis was carried out in the same manner as in the synthesis example of P2-1 to obtain 13.8 g of the product. (Yield: 75%)

The FD-MS (Field Desorption-Mass Spectrometry) values of the compound of Formula 1 of the present invention

prepared according to the above synthesis example are shown in Table 1 below.

[Table 1]

| Compound | FD-MS | Compound | FD-MS |
|---|---|---|---|
| P2-1 | m/z=567.18($C_{39}H_{25}N_3S$=567.71) | P2-2 | m/z=551.2($C_{39}H_{25}N_3O$=551.65) |
| P2-3 | m/z=551.2($C_{39}H_{25}N_3O$=551.65) | P2-4 | m/z=567.18($C_{39}H_{25}N_3S$=567.71) |
| P2-5 | m/z=551.2($C_{39}H_{25}N_3O$=551.65) | P2-6 | m/z=551.2($C_{39}H_{25}N_3O$=551.65) |
| P2-7 | m/z=521.1($C_{33}H_{19}N_3S_2$=521.66) | P2-8 | m/z=489.15($C_{33}H_{19}N_3O_2$=489.53) |
| P2-9 | m/z=481.22($C_{33}H_{27}N_3O$=481.6) | P2-10 | m/z=500.2($C_{33}H_{12}D_9N_3S$=500.67) |
| P2-11 | m/z=509.19($C_{34}H_{27}N_3S$=509.67) | P2-12 | m/z=511.26($C_{35}H_{33}N_3O$=511.67) |
| P2-13 | m/z=567.18($C_{39}H_{25}N_3S$=567.71) | P2-14 | m/z=551.2($C_{39}H_{25}N_3O$=551.65) |
| P2-15 | m/z=551.2($C_{39}H_{25}N_3O$=551.65) | P2-16 | m/z=623.24($C_{43}H_{33}N_3S$=623.82) |
| P2-17 | m/z=591.18($C_{41}H_{25}N_3S$=591.73) | P2-18 | m/z=575.2($C_{41}$ $H_{2S}N_3O$=575.67) |
| P2-19 | m/z=525.18($C_{37}H_{23}N_3O$=525.61) | P2-20 | m/z=541.16($C_{37}H_{23}N_3S$=541.67) |
| P2-21 | m/z=551.2($C_{39}H_{25}N_3O$=551.65) | P2-22 | m/z=627.23($C_{45}H_{29}N_3O$=627.75) |
| P2-23 | m/z=641.19($C_{45}H_{27}N_3S$=641.79) | P2-24 | m/z=592.17($C_{40}H_{24}N_4S$=592.72) |
| P2-25 | m/z=475.17($C_{33}H_{21}$ $N_3O$=475.55) | P2-26 | m/z=525.18($C_{37}H_{23}N_3O$=525.61) |
| P2-27 | m/z=515.15($C_{35}H_{21}N_3S$=515.63) | P2-28 | m/z=567.18($C_{39}H_{25}N_3S$=567.71) |
| P2-29 | m/z=525.18($C_{37}H_{23}N_3O$=525.61) | P2-30 | m/z=541.16($C_{37}H_{23}N_3S$=541.67) |
| P2-31 | m/z=505.12($C_{33}H_{19}N_3OS$=505.6) | P2-32 | m/z=641.21($C_{45}H_{27}N_3O_2$=641.73) |
| P2-33 | m/z=581.1($C_{33}H_{16}F_5N_3S$=581.56) | P2-34 | m/z=493.22($C_{34}H_{27}N_3O$=493.61) |
| P2-35 | m/z=626.21($C_{44}H_{26}N_4O$=626.72) | P2-36 | m/z=579.27($C_{39}H_{37}N_3S$=579.81) |
| P2-37 | m/z=601.22($C_{43}H_{27}N_3O$=601.71) | P2-38 | m/z=673.16($C_{45}H_{27}N_3S_2$=673.85) |
| P2-39 | m/z=564.20($C_{39}H_{24}N_4O$=564.65) | P2-40 | m/z=617.19($C_{43}H_{27}N_3S$=617.77) |
| P2-41 | m/z=549.18($C_{39}H_{23}N_3O$=549.63) | P2-42 | m/z=575.2($C_{41}H_{25}N_3O$=575.67) |
| P2-43 | m/z=546.19($C_{37}H_{18}D_5N_3S$=546.7) | P2-44 | m/z=642.19($C_{44}H_{26}N_4S$=642.78) |
| P2-45 | m/z=551.2($C_{39}H_{25}N_3O$=551.65) | P2-46 | m/z=643.21($C_{45}H_{29}N_3S$=643.81) |
| P2-47 | m/z=651.23($C_{47}H_{29}N_3O$=651.77) | P2-48 | m/z=591.18($C_{41}H_{25}N_3S$=591.73) |
| P2-49 | m/z=567.18($C_{39}H_{25}N_3S$=567.71) | P2-50 | m/z=499.17($C_{35}H_{21}N_3O$=499.57) |
| P2-51 | m/z=567.18($C_{39}H_{25}N_3S$=567.71) | P2-52 | m/z=525.18($C_{37}H_{23}N_3O$=525.61) |
| P2-53 | m/z=492.14($C_{32}H_{20}N_4S$=492.6) | P2-54 | m/z=505.12($C_{33}H_{19}N_3OS$=505.6) |
| P2-55 | m/z=521.1($C_{33}H_{19}N_3S_2$=521.66) | P2-56 | m/z=489.15($C_{33}H_{19}N_3O_2$=489.53) |
| P2-57 | m/z=527.24($C_{35}H_{33}N_3S$=527.73) | P2-58 | m/z=566.16($C_{3B}H_{22}N_4S$=566.68) |
| P2-59 | m/z=533.25($C_{37}H_{31}N_3O$=533.67) | P2-60 | m/z=561.26($C_{39}H_{15}D_{10}N_3O$=561.71) |
| P2-61 | m/z=551.2($C_{39}H_{25}N_3O$=551.65) | P2-62 | m/z=567.18($C_{39}H_{25}N_3S$=567.71) |
| P2-63 | m/z=627.23($C_{45}H_{29}N_3O$=627.75) | P2-64 | m/z=643.21($C_{45}H_{29}N_3S$=643.81) |
| P2-65 | m/z=625.22($C_{45}H_{27}N_3O$=625.73) | P2-66 | m/z=555.14($C_{37}H_{21}N_3OS$=555.65) |
| P2-67 | m/z=515.15($C_{35}H_{21}N_3S$=515.63) | P2-68 | m/z=615.19($C_{43}H_{25}N_3O_2$=615.69) |
| P2-69 | m/z=581.16($C_{39}H_{23}N_3OS$=581.69) | P2-70 | m/z=627.23($C_{45}H_{29}N_3O$=627.75) |
| P2-71 | m/z=567.18($C_{39}H_{25}N_3S$=567.71) | P2-72 | m/z=525.18($C_{37}H_{23}N_3O$=525.61) |
| P2-73 | m/z=567.18($C_{39}H_{25}N_3S$=567.71) | P2-74 | m/z=525.18($C_{37}H_{23}N_3O$=525.61) |
| P2-75 | m/z=525.18($C_{37}H_{23}N_3O$=525.61) | P2-76 | m/z=567.18($C_{39}H_{25}N_3S$=567.71) |

(continued)

| Compound | FD-MS | Compound | FD-MS |
|---|---|---|---|
| P2-77 | m/z=521.1($C_{33}H_{19}N_3S_2$=521.66) | P2-78 | m/z=489.15($C_{33}H_{19}N_3O_2$=489.53) |
| P2-79 | m/z=505.12($C_{33}H_{19}N_3OS$=505.6) | P2-80 | m/z=521.1($C_{33}H_{19}N_3S_2$=521.66) |
| P2-81 | m/z=497.19($C_{33}H_{27}N_3S$=497.66) | P2-82 | m/z=480.2($C_{33}H_{16}D_5N_3O$=480.58) |
| P2-83 | m/z=409.2($C_{27}H_7D_{10}N_3O$=409.51) | P2-84 | m/z=483.1($C_{28}H_{16}F_3N_3S$=483.51) |
| P2-85 | m/z=551.2($C_{39}H_{25}N_3O$=551.65) | P2-86 | m/z=557.25($C_{39}H_{31}$ $N_3O$=557.7) |
| P2-87 | m/z=646.19($C_{42}H_{26}N_6S$=646.77) | P2-88 | m/z=597.13($C_{39}H_{23}N_3S_2$=597.75) |
| P2-89 | m/z=555.14($C_{37}H_{21}$ $N_3OS$=555.65) | P2-90 | m/z=601.22($C_{43}H_{27}N_3O$=601.71) |
| P2-91 | m/z=575.2($C_{41}H_{2S}N_3O$=575.67) | P2-92 | m/z=539.16($C_{37}H_{21}N_3O_2$=539.59) |
| P2-93 | m/z=643.21($C_{45}H_{29}N_3S$=643.81) | P2-94 | m/z=641.21($C_{45}H_{27}N_3O_2$=641.73) |
| P2-95 | m/z=591.18($C_{41}H_{25}N_3S$=591.73) | P2-96 | m/z=693.22($C_{49}H_{31}N_3S$=693.87) |
| P2-97 | m/z=590.25($C_{42}H_{30}N_4$=590.73) | P2-98 | m/z=699.27($C_{52}H_{33}N_3$=699.86) |
| P2-99 | m/z=664.23($C_{47}H_{28}N_4O$=664.77) | P2-100 | m/z=579.18($C_{40}H_{25}N_3S$=579.72) |
| P2-101 | m/z=488.16($C_{33}H_{20}N_4O$=488.55) | P2-102 | m/z=690.24($C_{49}H_{30}N_4O$=690.81) |
| P2-103 | m/z=821.3($C_{57}H_{39}N_5Si$=822.06) | P2-104 | m/z=745.27($C_{51}H_{35}N_5Si$=745.96) |

[Synthesis example 2] Compound of Formula 2

Compound represented by Formula 2 (Final Product 2) according to the present invention may be synthesized as shown in Reaction Scheme 2 below, but is not limited thereto.

<Reaction Scheme 2>

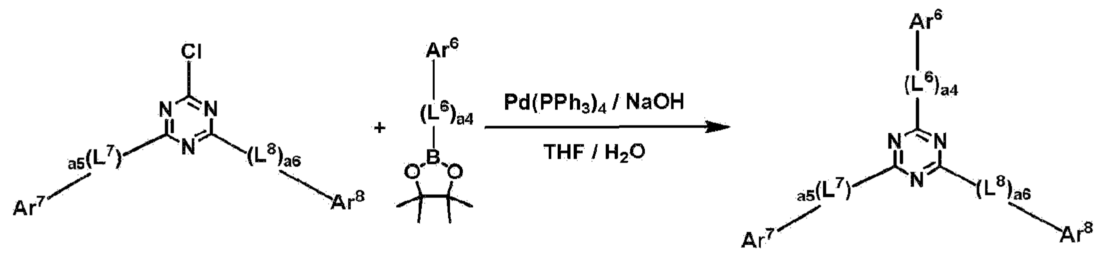


Sub5 Sub6 Final Product 3

1. Synthesis example of P3-1

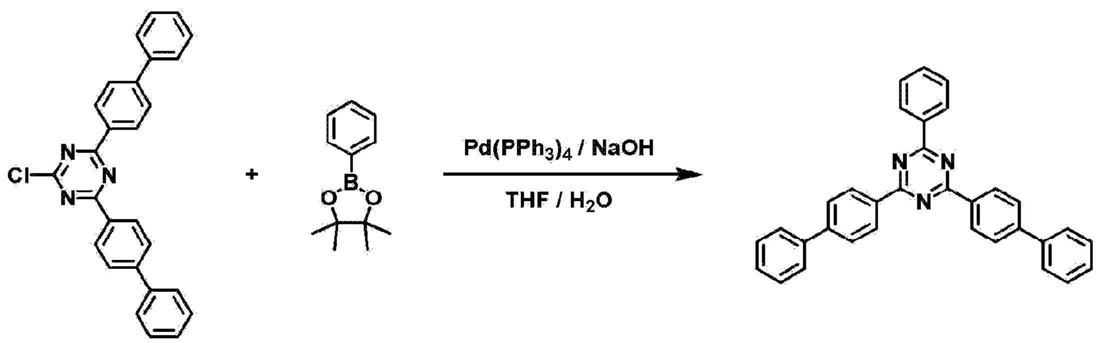


Sub3-1 Sub6-1 P3-1

Sub3-1 (5.0 g, 24.5 mmol) was dissolved in tetrahydrofuran (THF) (123 mL), and Sub6-1 (10.3 g, 24.5 mmol), NaOH (2.9 g, 73.5 mmol), $Pd(PPh_3)_4$ (1.70 g, 1.47 mmol), and water (61 mL) were added thereto. The mixture was stirred at 80 °C. After completion of the reaction, the mixture was extracted with $CH_2Cl_2$ and water. The organic layer was dried over $MgSO_4$ and concentrated. Then, the concentrate was purified by silica gel column chromatography and recrystallized to obtain 10.1 g of the product. (Yield: 89%)

2. Synthesis example of P3-25

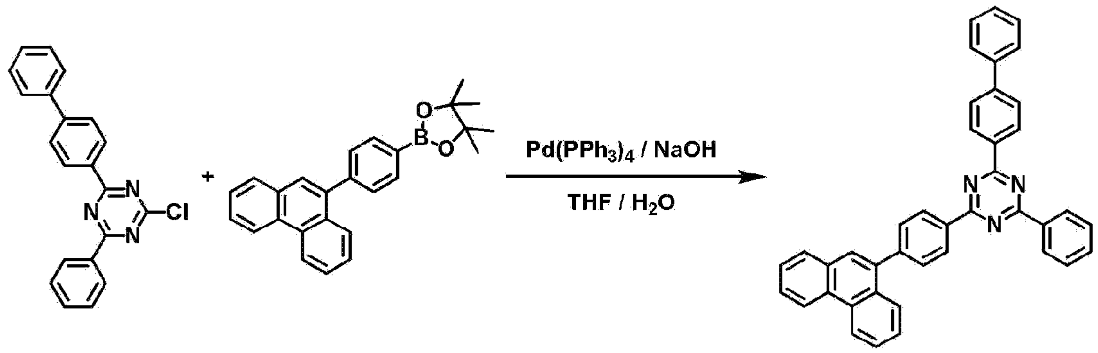


Sub3-19 Sub6-25 P3-25

Sub3-19 (9.0 g, 26.3 mmol) was dissolved in THF (131 mL), and Sub6-25 (10.0 g, 26.3 mmol), NaOH (3.2 g, 78.9 mmol), $Pd(PPh_3)_4$ (1.82 g, 1.58 mmol), and water (66 mL) were added thereto. The synthesis was carried out in the same manner as in the synthesis example of P3-1 to obtain 10.2 g of the product. (Yield: 84%)

3. Synthesis example of P3-48

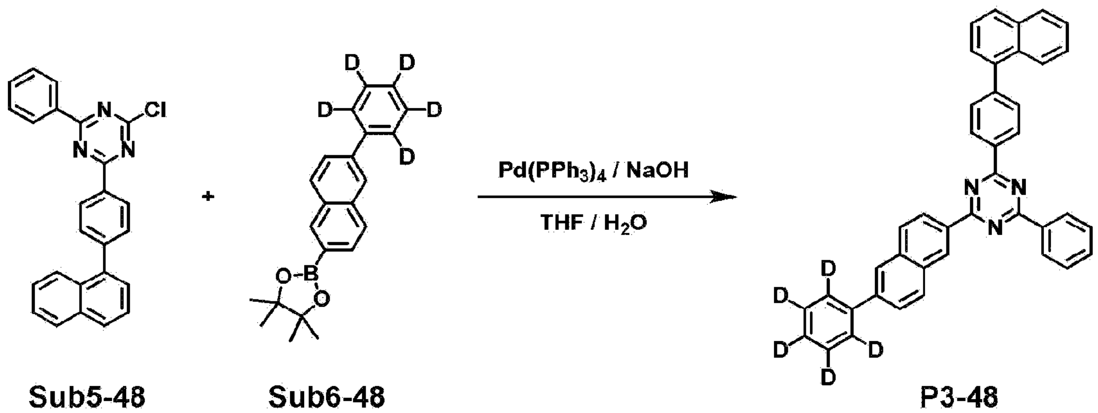


Sub5-48 Sub6-48 P3-48

Sub5-48 (11.7 g, 29.8 mmol) was dissolved in THF (149 mL), and Sub6-48 (10.0 g, 29.8 mmol), NaOH (3.6 g, 89.5 mmol), $Pd(PPh_3)_4$ (2.07 g, 1.79 mmol), and water (75mL) were added thereto. The synthesis was carried out in the same manner as in the synthesis example of P3-1 to obtain 13.4 g of the product. (Yield: 79%)

4. Synthesis example of P3-75

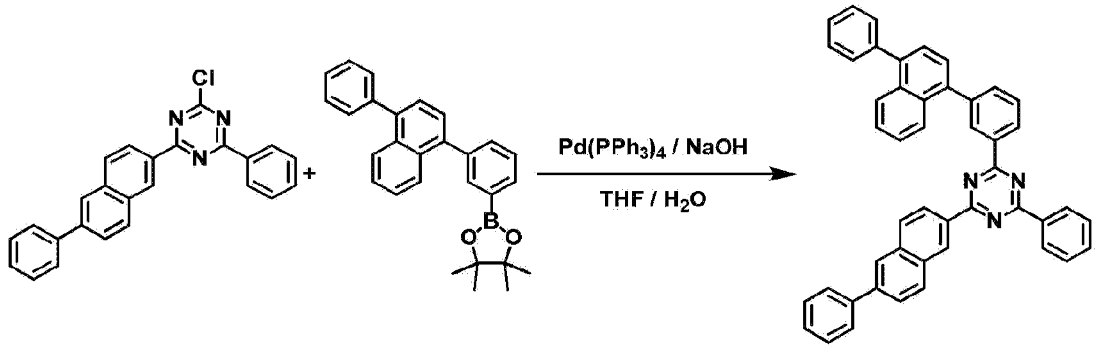


Sub5-75 Sub6-75 P3-75

Sub5-75 (9.7 g, 24.6 mmol) was dissolved in THF (123 mL), and Sub6-75 (10.0 g, 24.6 mmol), NaOH (3.0 g, 73.8 mmol), $Pd(PPh_3)_4$ (1.71 g, 1.48 mmol), and water (62 mL) were added thereto. The synthesis was carried out in the same manner as in the synthesis example of P3-1 to obtain 12.9 g of the product. (Yield: 82%)

5. Synthesis example of P3-91

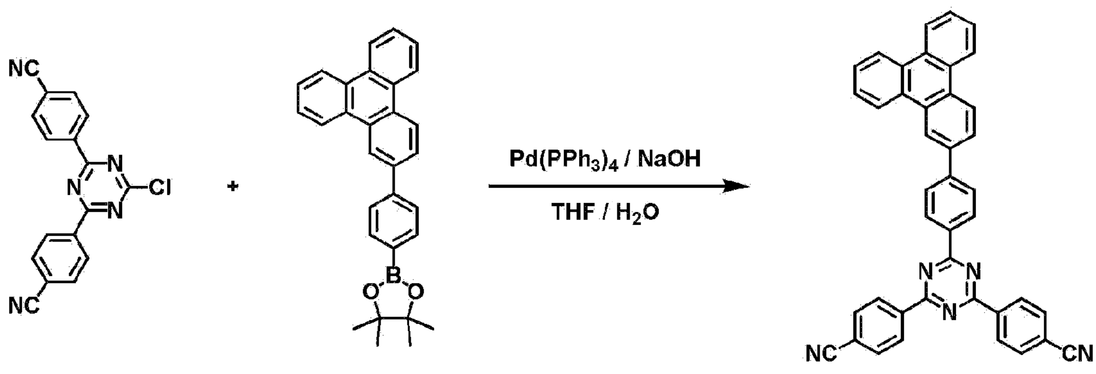


Sub5-91 Sub6-91 P3-91

Sub5-91 (7.4 g, 23.2 mmol) was dissolved in THF (116 mL), and Sub6-91 (10.0 g, 23.2 mmol), NaOH (2.8 g, 69.7 mmol), $Pd(PPh_3)_4$ (1.61 g, 1.39 mmol), and water (58 mL) were added thereto. The synthesis was carried out in the same manner as in the synthesis example of P3-1 to obtain 11.6 g of the product. (Yield: 85%)

The FD-MS (Field Desorption-Mass Spectrometry) values of the compound of Formula 2 of the present invention prepared according to the above synthesis example are shown in Table 2 below.

[Table 2]

| Compound | FD-MS | Compound | FD-MS |
|---|---|---|---|
| P3-1 | m/z=461.19($C_{33}H_{23}N_3$=461.57) | P3-2 | m/z=461.19($C_{33}H_{23}N_3$=461.57) |
| P3-3 | m/z=537.22($C_{39}H_{27}N_3$=537.67) | P3-4 | m/z=552.31($C_{39}H_{12}D_{15}N_3$=552.76) |
| P3-5 | m/z=511.2($C_{37}H_{25}N_3$=511.63) | P3-6 | m/z=485.19($C_{35}H_{23}N_3$=485.59) |
| P3-7 | m/z=511.2($C_{37}H_{25}N_3$=511.63) | P3-8 | m/z=485.19($C_{35}H_{23}N_3$=485.59) |
| P3-9 | m/z=485.19($C_{35}H_{23}N_3$=485.59) | P3-10 | m/z=516.24($C_{37}H_{20}D_5N_3$=516.66) |
| P3-11 | m/z=561.22($C_{41}H_{27}N_3$=561.69) | P3-12 | m/z=561.22($C_{41}H_{27}N_3$=561.69) |
| P3-13 | m/z=561.22($C_{41}H_{27}N_3$=561.69) | P3-14 | m/z=561.22($C_{41}H_{27}N_3$=561.69) |
| P3-15 | m/z=561.22($C_{41}H_{27}N_3$=561.69) | P3-16 | m/z=511.2($C_{37}H_{25}N_3$=511.63) |
| P3-17 | m/z=511.2($C_{37}H_{25}N_3$=511.63) | P3-18 | m/z=568.26($C_{41}H_{20}D_7N_3$=568.73) |
| P3-19 | m/z=561.22($C_{41}H_{27}N_3$=561.69) | P3-20 | m/z=587.24($C_{43}H_{29}N_3$=587.73) |

(continued)

| Compound | FD-MS | Compound | FD-MS |
|---|---|---|---|
| P3-21 | m/z=511.2($C_{37}H_{25}N_3$=511.63) | P3-22 | m/z=440.2($C_{31}H_{16}D_5N_3$=440.56) |
| P3-23 | m/z=561.22($C_{41}H_{27}N_3$=561.69) | P3-24 | m/z=561.22($C_{41}H_{27}N_3$=561.69) |
| P3-25 | m/z=561.22($C_{41}H_{27}N_3$=561.69) | P3-26 | m/z=611.24($C_{45}H_{29}N_3$=611.75) |
| P3-27 | m/z=637.25($C_{47}H_{31}N_3$=637.79) | P3-28 | m/z=611.24($C_{45}H_{29}N_3$=611.75) |
| P3-29 | m/z=587.24($C_{43}H_{29}N_3$=587.73) | P3-30 | m/z=535.2($C_{39}H_{25}N_3$=535.65) |
| P3-31 | m/z=561.22($C_{41}H_{27}N_3$=561.69) | P3-32 | m/z=687.27($C_{51}H_{33}N_3$=687.85) |
| P3-33 | m/z=561.22($C_{41}H_{27}N_3$=561.69) | P3-34 | m/z=561.22($C_{41}H_{27}N_3$=561.69) |
| P3-35 | m/z=587.24($C_{43}H_{29}N_3$=587.73) | P3-36 | m/z=561.22($C_{41}H_{27}N_3$=561.69) |
| P3-37 | m/z=561.22($C_{41}H_{27}N_3$=561.69) | P3-38 | m/z=568.26($C_{41}H_{20}D_7N_3$=568.73) |
| P3-39 | m/z=587.24($C_{43}H_{29}N_3$=587.73) | P3-40 | m/z=516.24($C_{37}H_{20}D_5N_3$=516.66) |
| P3-41 | m/z=587.24($C_{43}H_{29}N_3$=587.73) | P3-42 | m/z=561.22($C_{41}H_{27}N_3$=561.69) |
| P3-43 | m/z=587.24($C_{43}H_{29}N_3$=587.73) | P3-44 | m/z=561.22($C_{41}H_{27}N_3$=561.69) |
| P3-45 | m/z=637.25($C_{47}H_{31}N_3$=637.79) | P3-46 | m/z=561.22($C_{41}H_{27}N_3$=561.69) |
| P3-47 | m/z=535.2($C_{39}H_{25}N_3$=535.65) | P3-48 | m/z=566.25($C_{41}H_{22}D_5N_3$=566.72) |
| P3-49 | m/z=511.2($C_{37}H_{25}N_3$=511.63) | P3-50 | m/z=566.25($C_{41}H_{22}D_5N_3$=566.72) |
| P3-51 | m/z=587.24($C_{43}H_{29}N_3$=587.73) | P3-52 | m/z=535.2($C_{39}H_{25}N_3$=535.65) |
| P3-53 | m/z=637.25($C_{47}H_{31}N_3$=637.79) | P3-54 | m/z=561.22($C_{41}H_{27}N_3$=561.69) |
| P3-55 | m/z=561.22($C_{41}H_{27}N_3$=561.69) | P3-56 | m/z=561.22($C_{41}H_{27}N_3$=561.69) |
| P3-57 | m/z=585.22($C_{43}H_{27}N_3$=585.71) | P3-58 | m/z=611.24($C_{45}H_{29}N_3$=611.75) |
| P3-59 | m/z=641.28($C_{47}H_{27}D_4N_3$=641.81) | P3-60 | m/z=535.2($C_{39}H_{25}N_3$=535.65) |
| P3-61 | m/z=535.2($C_{39}H_{25}N_3$=535.65) | P3-62 | m/z=535.2($C_{39}H_{25}N_3$=535.65) |
| P3-63 | m/z=545.27($C_{39}H_{15}D_{10}N_3$=545.71) | P3-64 | m/z=535.2($C_{39}H_{25}N_3$=535.65) |
| P3-65 | m/z=613.25($C_{45}H_{31}N_3$=613.76) | P3-66 | m/z=537.22($C_{39}H_{27}N_3$=537.67) |
| P3-67 | m/z=511.2($C_{37}H_{25}N_3$=511.63) | P3-68 | m/z=587.24($C_{43}H_{29}N_3$=587.73) |
| P3-69 | m/z=587.24($C_{43}H_{29}N_3$=587.73) | P3-70 | m/z=637.25($C_{47}H_{31}N_3$=637.79) |
| P3-71 | m/z=637.25($C_{47}H_{31}N_3$=637.79) | P3-72 | m/z=592.27($C_{43}H_{24}D_5N_3$=592.76) |
| P3-73 | m/z=511.2($C_{37}H_{25}N_3$=511.63) | P3-74 | m/z=597.3($C_{43}H_{19}D_{10}N_3$=597.79) |
| P3-75 | m/z=637.25($C_{47}H_{31}N_3$=637.79) | P3-76 | m/z=637.25($C_{47}H_{31}N_3$=637.79) |
| P3-77 | m/z=561.22($C_{41}H_{27}N_3$=561.69) | P3-78 | m/z=561.22($C_{41}H_{27}N_3$=561.69) |
| P3-79 | m/z=571.28($C_{41}H_{17}D_{10}N_3$=571.75) | P3-80 | m/z=611.24($C_{45}H_{29}N_3$=611.75) |
| P3-81 | m/z=611.24($C_{45}H_{29}N_3$=611.75) | P3-82 | m/z=561.22($C_{41}H_{27}N_3$=561.69) |
| P3-83 | m/z=561.22($C_{41}H_{27}N_3$=561.69) | P3-84 | m/z=611.24($C_{45}H_{29}N_3$=611.75) |
| P3-85 | m/z=561.22($C_{41}H_{27}N_3$=561.69) | P3-86 | m/z=561.22($C_{41}H_{27}N_3$=561.69) |
| P3-87 | m/z=611.24($C_{45}H_{29}N_3$=611.75) | P3-88 | m/z=611.24($C_{45}H_{29}N_3$=611.75) |
| P3-89 | m/z=611.24($C_{45}H_{29}N_3$=611.75) | P3-90 | m/z=535.2($C_{39}H_{25}N_3$=535.65) |
| P3-91 | m/z=585.2($C_{41}H_{23}N_5$=585.67) | P3-92 | m/z=410.15($C_{28}H_{18}N_4$=410.48) |

[Synthesis example of 3] Compound of Formula 3

Compound represented by Formula 3 (Final Product 5) according to the present invention may be synthesized as

shown in Reaction Scheme 3 below, but is not limited thereto.

<Reaction Scheme 3>

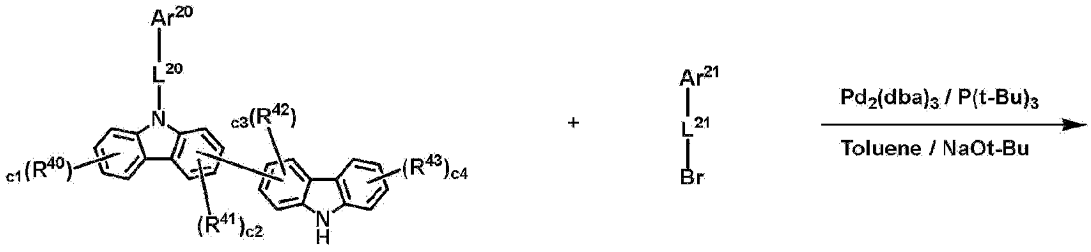


Sub9 Sub10

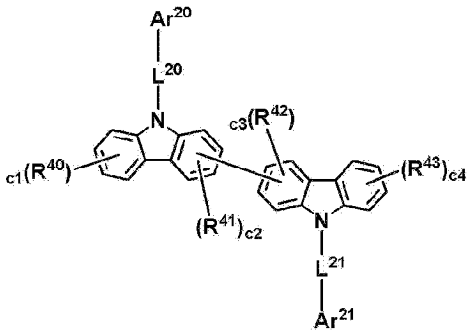

Final Product 5

1. Synthesis example of P5-1

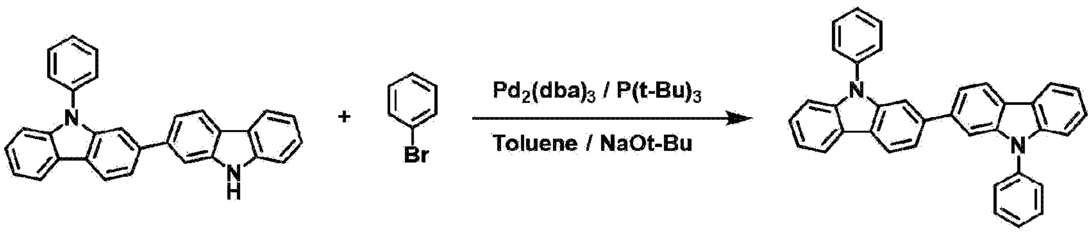


Sub9-1 Sub10-1 P5-1

Sub9-1 (10.0 g, 24.5 mmol) was dissolved in toluene (122 mL), and Sub10-1 (3.8 g, 24.5 mmol), $Pd_2(dba)_3$ (0.67 g, 0.73 mmol), $P(t-Bu)_3$ (0.30 g, 1.47 mmol), NaOt-Bu (4.7 g, 49.0 mmol) were added, and the reaction was carried out at 80 °C. Upon completion of the reaction, the mixture was extracted with $CH_2Cl_2$ and water. The organic layer was dried over $MgSO_4$ and concentrated. Then, the concentrate was purified by silica gel column chromatography and recrystallized to obtain 10.1 g of the product. (Yield: 85%)

2. Synthesis example of P5-16

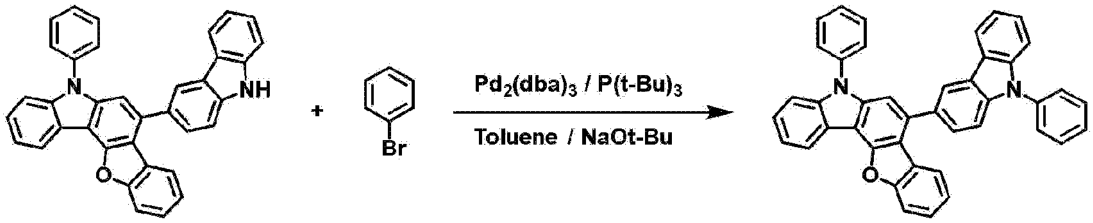


Sub9-16 Sub10-1 P5-16

Sub9-16 (10.0 g, 20.1 mmol) was dissolved in toluene (100 mL), and Sub10-1 (3.1 g, 20.1 mmol), $Pd_2(dba)_3$ (0.55 g, 0.60 mmol), $P(t\text{-}Bu)_3$ (0.24 g, 1.20 mmol), and NaOt-Bu (3.9 g, 40.1 mmol) were added thereto. The synthesis was carried out in the same manner as in the synthesis example of P5-1 to obtain 9.5 g of the product. (Yield: 82%)

3. Synthesis example of P5-23

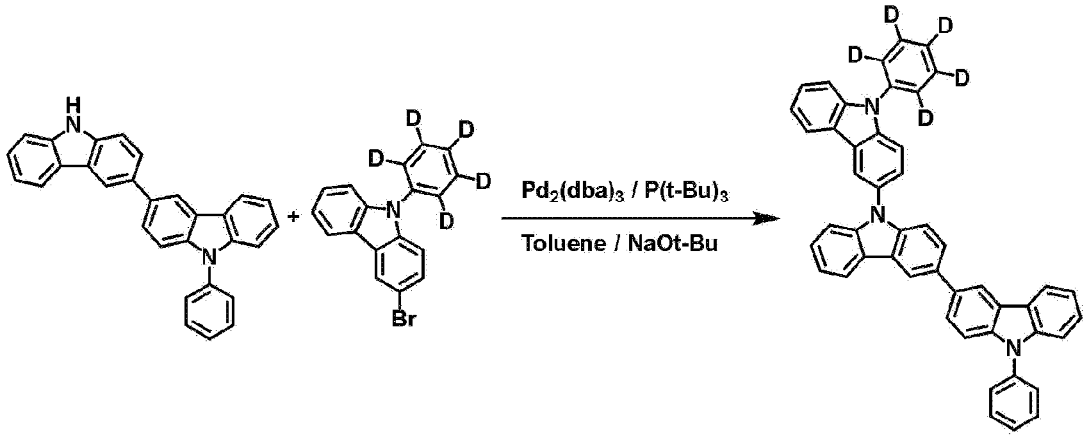


Sub9-23 Sub10-23 P5-23

Sub9-23 (10.0 g, 24.5 mmol) was dissolved in toluene (122 mL), and Sub10-23 (8.0 g, 24.5 mmol), $Pd_2(dba)_3$ (0.67 g, 0.73 mmol), $P(t\text{-}Bu)_3$ (0.30 g, 1.47 mmol), and NaOt-Bu (4.7 g, 49.0 mmol) were added thereto. The synthesis was carried out in the same manner as in the synthesis example of P5-1 to obtain 12.2 g of the product. (Yield: 76%)

4. Synthesis example of P5-42

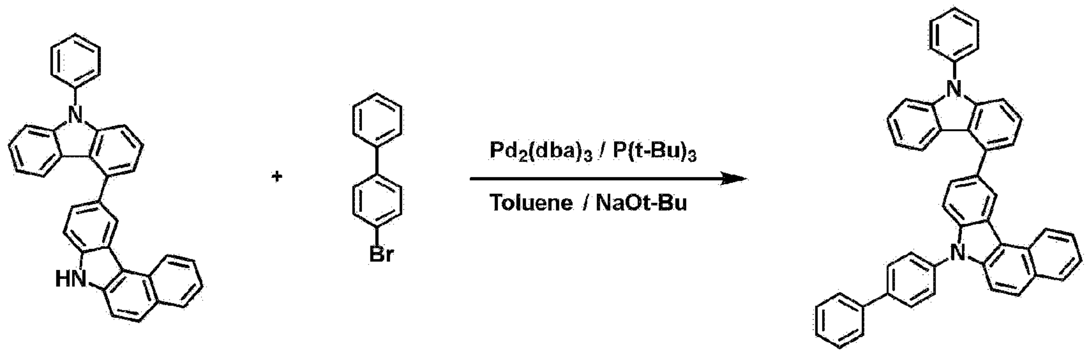


Sub9-42 Sub10-42 P5-42

Sub9-42 (10.0 g, 21.8 mmol) was dissolved in toluene (109 mL), and Sub10-42 (5.1 g, 21.8 mmol), $Pd_2(dba)_3$ (0.60 g, 0.65 mmol), $P(t\text{-}Bu)_3$ (0.26 g, 1.31 mmol), and NaOt-Bu (4.2 g, 43.6 mmol) were added thereto. The synthesis was

carried out in the same manner as in the synthesis example of P5-1 to obtain 11.2 g of the product. (Yield: 84%)

5. Synthesis example of P5-48

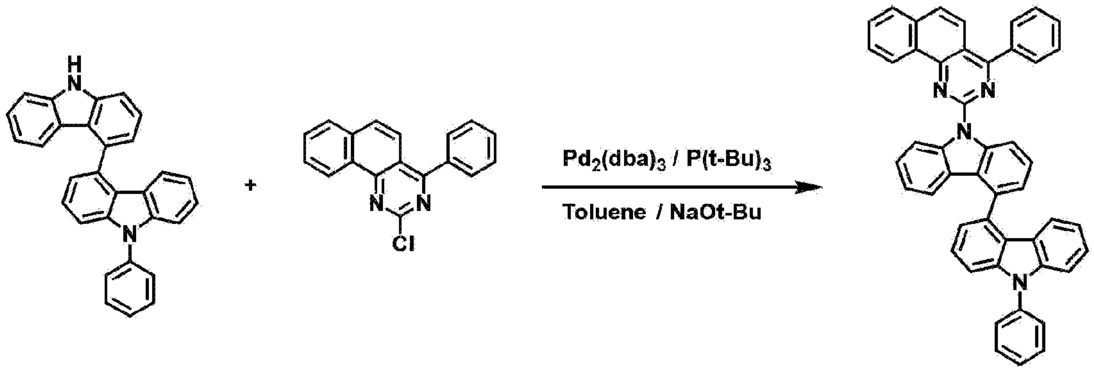


**Sub9-48** **Sub10-48** **P5-48**

Sub9-48 (10.0 g, mmol) was dissolved in toluene (122 mL), and Sub10-48 (7.1 g, 24.5 mmol), $Pd_2(dba)_3$ (0.67 g, 0.73 mmol), $P(t-Bu)_3$ (0.30 g, 1.47 mmol), and NaOt-Bu (4.7 g, 49.0 mmol) were added thereto. The synthesis was carried out in the same manner as in the synthesis example of P5-1 to obtain 11.7 g of the product. (Yield: 72%)
The FD-MS (Field Desorption-Mass Spectrometry) values of the compound of Formula 3 of the present invention prepared according to the above synthesis example are shown in Table 3 below.

[Table 3]

| Compound | FD-MS | Compound | FD-MS |
|---|---|---|---|
| P5-1 | m/z=484.19($C_{36}H_{24}N_2$=484.6) | P5-2 | m/z=636.26($C_{48}H_{32}N_2$=636.8) |
| P5-3 | m/z=584.23($C_{44}H_{28}N_2$=584.72) | P5-4 | m/z=639.24($C_{45}H_{29}N_5$=639.76) |
| P5-5 | m/z=534.21($C_{40}H_{26}N_2$=534.66) | P5-6 | m/z=574.2($C_{42}H_{26}N_2O$=574.68) |
| P5-7 | m/z=534.21($C_{40}H_{26}N_2$=534.66) | P5-8 | m/z=636.26($C_{48}H_{32}N_2$=636.8) |
| P5-9 | m/z=484.19($C_{36}H_{24}N_2$=484.6) | P5-10 | m/z=636.26($C_{48}H_{32}N_2$=636.8) |
| P5-11 | m/z=636.26($C_{48}H_{32}N_2$=636.8) | P5-12 | m/z=612.23($C_{44}H_{28}N_4$=612.74) |
| P5-13 | m/z=610.24($C_{46}H_{30}N_2$=610.76) | P5-14 | m/z=634.24($C_{48}H_{30}N_2$=634.78) |
| P5-15 | m/z=725.28($C_{54}H_{35}N_3$=725.89) | P5-16 | m/z=574.2($C_{42}H_{26}N_2O$=574.68) |
| P5-17 | m/z=484.19($C_{36}H_{24}N_2$=484.6) | P5-18 | m/z=636.26($C_{48}H_{32}N_2$=636.8) |
| P5-19 | m/z=489.23($C_{36}H_{19}D_5N_2$=489.63) | P5-20 | m/z=498.28($C_{36}H_{10}D_{14}N_2$=498.69) |
| P5-21 | m/z=624.22($C_{46}H_{28}N_2O$=624.74) | P5-22 | m/z=649.25($C_{48}H_{31}N_3$=649.8) |
| P5-23 | m/z=654.28($C_{48}H_{26}D_5N_3$=654.83) | P5-24 | m/z=639.24($C_{45}H_{29}N_5$=639.76) |
| P5-25 | m/z=590.18($C_{42}H_{26}N_2S$=590.74) | P5-26 | m/z=689.26($C_{49}H_{31}N_5$=689.82) |
| P5-27 | m/z=614.27($C_{46}H_{26}D_4N_2$=614.78) | P5-28 | m/z=565.26($C_{42}H_{23}D_5N_2$=565.73) |
| P5-29 | m/z=484.19($C_{36}H_{24}N_2$=484.6) | P5-30 | m/z=636.26($C_{48}H_{32}N_2$=636.8) |
| P5-31 | m/z=725.28($C_{54}H_{35}N_3$=725.89) | P5-32 | m/z=612.23($C_{44}H_{28}N_4$=612.74) |
| P5-33 | m/z=489.23($C_{36}H_{19}D_5N_2$=489.63) | P5-34 | m/z=534.21($C_{40}H_{26}N_2$=534.66) |
| P5-35 | m/z=660.26($C_{50}H_{32}N_2$=660.82) | P5-36 | m/z=624.22($C_{46}H_{28}N_2O$=624.74) |
| P5-37 | m/z=484.19($C_{36}H_{24}N_2$=484.6) | P5-38 | m/z=636.26($C_{48}H_{32}N_2$=636.8) |
| P5-39 | m/z=636.26($C_{48}H_{32}N_2$=636.8) | P5-40 | m/z=584.23($C_{44}H_{28}N_2$=584.72) |

(continued)

| Compound | FD-MS | Compound | FD-MS |
|---|---|---|---|
| P5-41 | m/z=646.32($C_{48}H_{22}D_{10}N_2$=646.86) | P5-42 | m/z=610.24($C_{46}H_{30}N_2$=610.76) |
| P5-43 | m/z=610.24($C_{46}H_{30}N_2$=610.76) | P5-44 | m/z=668.2($C_{46}H_{28}N_4S$=668.82) |
| P5-45 | m/z=484.19($C_{36}H_{24}N_2$=484.6) | P5-46 | m/z=636.26($C_{48}H_{32}N_2$=636.8) |
| P5-47 | m/z=584.23($C_{44}H_{28}N_2$=584.72) | P5-48 | m/z=662.25($C_{48}H_{30}N_4$=662.8) |
| P5-49 | m/z=788.32($C_{60}H_{40}N_2$=788.99) | P5-50 | m/z=624.22($C_{46}H_{28}N_2O$=624.74) |
| P5-51 | m/z=636.26($C_{48}H_{32}N_2$=636.8) | P5-52 | m/z=584.23($C_{44}H_{28}N_2$=584.72) |

Manufacturing and Evaluation of organic electronic device

[Test Example 1] Green organic electroluminescent device (phosphorescent host)

A hole injection layer having a thickness of 70 nm was formed by vacuum-depositing $N^1$-(naphthalen-2-yl)-$N^4$,$N^4$-bis(4-(naphthalen-2-yl(phenyl)amino)phenyl)-$N^1$-phenylbenzene-1,4-diamine (hereinafter abbreviated as 2-TNATA) on an ITO layer (anode) formed on a glass substrate, and then a hole transport layer was formed by vacuum-depositing N,N'-bis(1-naphthalenyl)-N,N'-bis-phenyl-(1,1'-biphenyl)-4,4'-diamine (hereinafter abbreviated as NPB) to a thickness of 70 nm on the hole injection layer.

Next, a emission-auxiliary layer was formed by vacuum-depositing tris(4-(9H-carbazol-9-yl)phenyl)amine (hereinafter abbreviated as TCTA) to a thickness of 30 nm on the hole transport layer.

Subsequently, an emission layer having a thickness of 30 nm was deposited on the emission-auxiliary layer using a mixture of the inventive compounds P2-32 (first host), P3-25 (second host), and P5-1 (third host) as hosts in a weight ratio of 5:2:3, and [tris(2-phenylpyridine)-iridium] (hereinafter abbreviated as $Ir(ppy)_3$) as a dopant, wherein the dopant was doped into the host mixture at a weight ratio of 95:5 between the host and the dopant.

Next, a hole blocking layer having a thickness of 10 nm was formed by vacuum-depositing (1,1'-bisphenyl-4-yl oleato)bis(2-methyl-8-quinolinolato)aluminum (hereinafter abbreviated as BAlq) on the emission layer, and an electron transport layer was formed by vacuum-depositing bis(10-hydroxybenzo[h]quinolinato)beryllium (hereinafter abbreviated as $BeBq_2$) to a thickness of 60 nm on the hole blocking layer.

Subsequently, an electron injection layer having a thickness of 0.2 nm was formed by depositing LiF on the electron transporting layer, followed by deposition of Al to form a cathode having a thickness of 150 nm.

[Test Example 2] to [Test Example 48], [Comparative Example 1] and [Comparative Example 2]

Organic electroluminescent devices were fabricated in the same manner as in the Test Example 1, except that a mixture of the first host, second host, and third host as listed in Table 4 was used as the host material.

<Comparative Compound A>

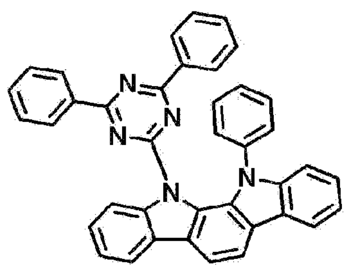

The electroluminescent (EL) characteristics of the organic electroluminescent devices fabricated according to the Test Examples of the present invention and Comparative Examples were measured by applying a forward DC voltage using a PR-650 photometer from Photo Research. The T95 lifetime was measured at a standard luminance of 2500 cd/$m^2$ using a lifetime measurement system manufactured by Mc Science. The measurement results are shown in Table 4 below.

[Table 4]

| | first host | second host | third host | Voltage (V) | Current Density (mA/cm$^2$) | Efficiency (cd/A) | Lifetime T(95) |
|---|---|---|---|---|---|---|---|
| comp.Ex(1) | P2-39 | Comp. compd A | P5-17 | 5.2 | 16.4 | 30.5 | 101.4 |
| comp.Ex(2) | P2-32 | P2-70 | P5-17 | 5.3 | 17.7 | 28.3 | 108.5 |
| Test Ex.(1) | P2-32 | P3-25 | P5-1 | 4.9 | 11.7 | 42.6 | 126.3 |
| Test Ex.(2) | P2-32 | P3-25 | P5-17 | 4.9 | 11.3 | 44.3 | 131.4 |
| Test Ex.(3) | P2-32 | P3-25 | P5-23 | 4.9 | 11.5 | 43.5 | 129.2 |
| Test Ex.(4) | P2-32 | P3-27 | P5-1 | 5.0 | 12.5 | 39.9 | 119.0 |
| Test Ex.(5) | P2-32 | P3-27 | P5-17 | 5.0 | 12.0 | 41.6 | 123.9 |
| Test Ex.(6) | P2-32 | P3-27 | P5-23 | 5.0 | 12.3 | 40.8 | 121.7 |
| Test Ex.(7) | P2-32 | P3-90 | P5-1 | 5.0 | 12.3 | 40.8 | 121.6 |
| Test Ex.(8) | P2-32 | P3-90 | P5-17 | 5.0 | 11.8 | 42.4 | 126.6 |
| Test Ex.(9) | P2-32 | P3-90 | P5-23 | 4.9 | 12.0 | 41.7 | 124.4 |
| Test Ex.(10) | P2-32 | P3-91 | P5-1 | 5.0 | 12.0 | 41.6 | 124.1 |
| Test Ex.(11) | P2-32 | P3-91 | P5-17 | 4.9 | 11.5 | 43.3 | 129.2 |
| Test Ex.(12) | P2-32 | P3-91 | P5-23 | 4.9 | 11.8 | 42.6 | 127.0 |
| Test Ex.(13) | P2-39 | P3-25 | P5-1 | 5.0 | 12.0 | 41.7 | 123.6 |
| Test Ex.(14) | P2-39 | P3-25 | P5-17 | 4.9 | 11.5 | 43.4 | 128.7 |
| Test Ex.(15) | P2-39 | P3-25 | P5-23 | 4.9 | 11.7 | 42.6 | 126.4 |
| Test Ex.(16) | P2-39 | P3-27 | P5-1 | 5.0 | 12.8 | 39.1 | 116.5 |
| Test Ex.(17) | P2-39 | P3-27 | P5-17 | 5.0 | 12.3 | 40.7 | 121.3 |
| Test Ex.(18) | P2-39 | P3-27 | P5-23 | 5.0 | 12.5 | 39.9 | 119.2 |
| Test Ex.(19) | P2-39 | P3-90 | P5-1 | 5.0 | 12.5 | 39.9 | 119.1 |
| Test Ex.(20) | P2-39 | P3-90 | P5-17 | 5.0 | 12.0 | 41.5 | 123.9 |
| Test Ex.(21) | P2-39 | P3-90 | P5-23 | 5.0 | 12.3 | 40.8 | 121.8 |
| Test Ex.(22) | P2-39 | P3-91 | P5-1 | 5.0 | 12.3 | 40.8 | 121.5 |
| Test Ex.(23) | P2-39 | P3-91 | P5-17 | 5.0 | 11.8 | 42.4 | 126.5 |
| Test Ex.(24) | P2-39 | P3-91 | P5-23 | 4.9 | 12.0 | 41.7 | 124.3 |
| Test Ex.(25) | P2-68 | P3-25 | P5-1 | 4.9 | 11.6 | 43.3 | 129.2 |
| Test Ex.(26) | P2-68 | P3-25 | P5-17 | 4.9 | 11.1 | 45.1 | 134.5 |
| Test Ex.(27) | P2-68 | P3-25 | P5-23 | 4.9 | 11.3 | 44.2 | 132.1 |
| Test Ex.(28) | P2-68 | P3-27 | P5-1 | 5.0 | 12.3 | 40.6 | 121.7 |
| Test Ex.(29) | P2-68 | P3-27 | P5-17 | 5.0 | 11.8 | 42.2 | 126.7 |
| Test Ex.(30) | P2-68 | P3-27 | P5-23 | 5.0 | 12.1 | 41.5 | 124.5 |
| Test Ex.(31) | P2-68 | P3-90 | P5-1 | 5.0 | 12.1 | 41.4 | 124.4 |
| Test Ex.(32) | P2-68 | P3-90 | P5-17 | 4.9 | 11.6 | 43.1 | 129.5 |
| Test Ex.(33) | P2-68 | P3-90 | P5-23 | 4.9 | 11.8 | 42.3 | 127.3 |
| Test Ex.(34) | P2-68 | P3-91 | P5-1 | 4.9 | 11.8 | 42.3 | 127.0 |
| Test Ex.(35) | P2-68 | P3-91 | P5-17 | 4.9 | 11.4 | 44.0 | 132.2 |
| Test Ex.(36) | P2-68 | P3-91 | P5-23 | 4.9 | 11.6 | 43.2 | 129.9 |

(continued)

| | first host | second host | third host | Voltage (V) | Current Density (mA/cm$^2$) | Efficiency (cd/A) | Lifetime T(95) |
|---|---|---|---|---|---|---|---|
| Test Ex.(37) | P3-90 | P3-25 | P5-1 | 5.0 | 12.3 | 40.8 | 121.1 |
| Test Ex.(38) | P3-90 | P3-25 | P5-17 | 5.0 | 11.8 | 42.4 | 126.0 |
| Test Ex.(39) | P3-90 | P3-25 | P5-23 | 5.0 | 12.0 | 41.7 | 123.8 |
| Test Ex.(40) | P3-90 | P3-27 | P5-1 | 5.1 | 13.1 | 38.2 | 114.1 |
| Test Ex.(41) | P3-90 | P3-27 | P5-17 | 5.1 | 12.6 | 39.8 | 118.8 |
| Test Ex.(42) | P3-90 | P3-27 | P5-23 | 5.0 | 12.8 | 39.0 | 116.7 |
| Test Ex.(43) | P3-90 | P3-90 | P5-1 | 5.0 | 12.8 | 39.0 | 116.6 |
| Test Ex.(44) | P3-90 | P3-90 | P5-17 | 5.0 | 12.3 | 40.6 | 121.4 |
| Test Ex.(45) | P3-90 | P3-90 | P5-23 | 5.0 | 12.5 | 39.9 | 119.3 |
| Test Ex.(46) | P3-90 | P3-91 | P5-1 | 5.0 | 12.5 | 39.8 | 119.0 |
| Test Ex.(47) | P3-90 | P3-91 | P5-17 | 5.0 | 12.1 | 41.5 | 123.9 |
| Test Ex.(48) | P3-90 | P3-91 | P5-23 | 5.0 | 12.3 | 40.7 | 121.7 |

As shown in Table 4, it can be seen that the driving voltage of an organic electroluminescent device can be reduced, and the efficiency and lifespan of an organic electroluminescent device are significantly improved when a mixture of the compounds of Formulae 1 to 3 of the present invention is used as the host of the emission layer (Test Examples 1 to 48), compared to using Comparative Compound A (Comparative Example 1) or using a compound belonging to Formula 1 as a second host (Comparative Example 2). Comparative Compound A used in Comparative Example 1 is a triazine compound substituted with an indolocarbazole type group, and compound P2-70 used in Comparative Example 2 is a triazine compound substituted with dibenzofuran, which is included in Formula 1 of the present invention. **In** contrast, the second host used in the examples of the present invention is a compound represented by Formula 2, which is a triazine compound substituted only with aryl groups and are not substituted with heteroaryl groups.

In the case of the mixed host, the characteristics of the organic electroluminescent device appear to vary depending on the material used as a second host, suggesting that the type of substituent on the triazine compound as a second host affects the device's performance.

The reorganization energy (RE) values vary depending on the substituents, so to investigate the effect of reorganization energy on device characteristics, the RE values of each compound were examined. Table 6 below shows the calculated $RE_{elec}$values for these compounds.

[Table 5]

| | Reorganiztion Energy |
|---|---|
| Comp. compd A | 0.404 |
| P2-70 | 0.251 |
| P3-27 | 0.212 |

As shown in Table 5, it can be seen that the RE value of compound P3-27 is smaller than those of Comparative Compound A and compound P2-70. The smaller the RE value, the better the charge injection and transport properties, facilitating charge injection from the host to the dopant and the ratio of holes to electrons is properly maintained. As a result, the overall performance of the device can be improved.

Therefore, when the compound of Formula 2 of the present invention, which is a triazine compound substituted with an aryl group, is used as s second host, electrons transported in the electron transport region can be more rapidly injected into the host compared to when using Comparative Compound A or compound P2-70, which are triazine compounds substituted with heteroaryl groups. This allows the ratio of holes to electrons to be properly maintained, resulting in an overall improvement in the device's driving voltage, efficiency, and lifespan.

The foregoing description is merely illustrative of the present invention and various modifications may be made by those of ordinary skill in the art without departing from the essential characteristics of the invention. The scope of

protection of the present invention should be interpreted based on the following claims, and all technical equivalents thereof should be construed as falling within the scope of the invention.

## Claims

**1.** An organic electronic device comprising a first electrode, a second electrode, and an organic layer formed between the first electrode and the second electrode,
wherein the organic layer comprises an emission layer, and the emission layer comprises compound represented by Formula 1, compound represented by Formula 2 and compound represented by Formula 3:

<Formula 1>

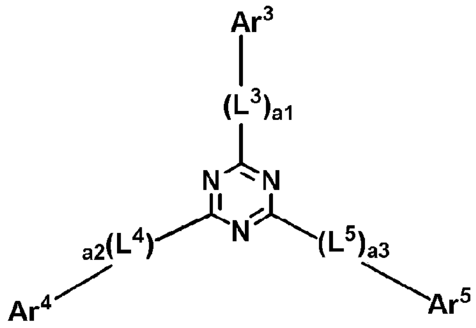

<Formula 2>

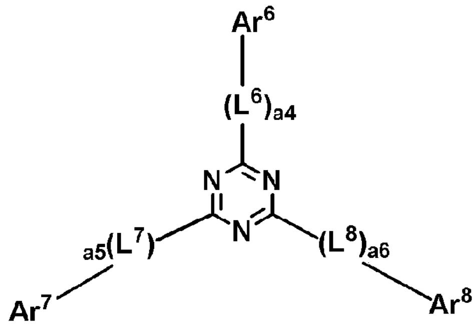

<Formula 3>

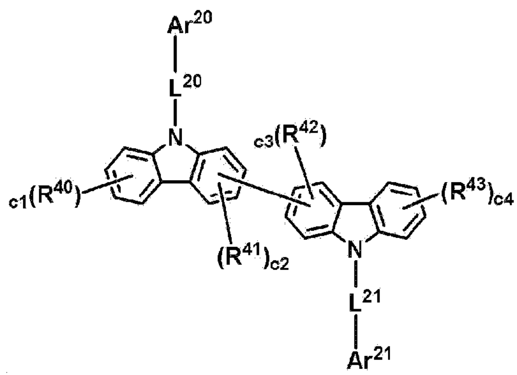

wherein:

$Ar^3$ to $Ar^5$ each independently selected from the group consisting of a $C_6$-$C_{60}$ aryl group; a fluorenyl group; a $C_3$-$C_{60}$ aliphatic ring group; and a $C_2$-$C_{30}$ heterocyclic group containing at least one heteroatom of O, N, S, Si and P,
$L^3$ to $L^5$ are each independently selected from the group consisting of a single bond; a $C_6$-$C_{60}$ arylene group; a fluorenylene group; a $C_3$-$C_{60}$ aliphatic ring group; and a $C_2$-$C_{30}$ heterocyclic group containing at least one heteroatom of O, N, S, Si and P,
$Ar^6$ to $Ar^8$ are each independently a $C_6$-$C_{60}$ aryl group,
$L^6$ to $L^8$ are each independently a single bond; or a $C_6$-$C_{60}$ arylene group,
a1 to a6 are each an integer of 0 to 3,
$Ar^{20}$ and $Ar^{21}$ each independently selected from the group consisting of a $C_6$-$C_{60}$ aryl group; a fluorenyl group; a $C_3$-$C_{60}$ aliphatic ring group; and a $C_2$-$C_{60}$ heterocyclic group containing at least one heteroatom of O, N, S, Si and P,
$L^{20}$ and $L^{21}$ are each independently selected from the group consisting of a single bond; a $C_6$-$C_{60}$ arylene group; a fluorenylene group; a $C_3$-$C_{60}$ aliphatic ring group; and a $C_2$-$C_{60}$ heterocyclic group containing at least one heteroatom of O, N, S, Si and P,

$R^{40}$ to $R^{43}$ are each independently selected from the group consisting of hydrogen; deuterium; halogen; a cyano group; a nitro group; a $C_6$-$C_{60}$ aryl group; a fluorenyl group; a $C_2$-$C_{60}$ heterocyclic group containing at least one heteroatom of O, N, S, Si and P; a $C_3$-$C_{60}$ aliphatic ring group; a $C_1$-$C_{20}$ alkyl group; a $C_2$-$C_{20}$ alkenyl group; a $C_2$-$C_{20}$ alkynyl group; a $C_1$-$C_{20}$ alkoxyl group; and a $C_6$-$C_{60}$ aryloxy group, and adjacent groups may be bonded to each other to form a ring,

c1 and c4 are each an integer of 0 to 4, and c2 and c3 are each an integer of 0 to 3,

$Ar^3$ to $Ar^5$, $Ar^{20}$, $Ar^{21}$, $L^{20}$, $L^{21}$, $L^3$ to $L^5$, $R^{40}$ to $R^{43}$ may be each substituted with one or more substituents selected from the group consisting of deuterium; halogen; a silane group unsubstituted or substituted with a $C_1$-$C_{20}$ alkyl group or a $C_6$-$C_{20}$ aryl group; a phosphine oxide substituted or unsubstituted with a $C_1$-$C_{20}$ alkyl group or a $C_6$-$C_{20}$ aryl group; siloxane group; a cyano group; a nitro group; a $C_1$-$C_{20}$ alkylthio group; a $C_1$-$C_{20}$ alkoxy group; a $C_6$-$C_{30}$ aryloxy group; a $C_6$-$C_{30}$ arylthio group; a $C_1$-$C_{20}$ alkyl halide group; a $C_1$-$C_{20}$ alkyl group; a $C_2$-$C_{20}$ alkenyl group; a $C_2$-$C_{20}$ alkynyl group; a $C_6$-$C_{30}$ aryl group; a fluorenyl group; a $C_2$-$C_{30}$ heterocyclic group comprising at least one heteroatom selected from the group consisting of O, N, S, Si and P; and a $C_3$-$C_{30}$ aliphatic ring group,

$Ar^6$ to $Ar^8$, $L^6$ to $L^8$ may be each substituted with one or more substituents selected from the group consisting of deuterium; a cyano group; a $C_6$-$C_{30}$ aryl group; and a $C_6$-$C_{30}$ aryl group substituted with deuterium, and

with the proviso that in Formula 2, the case where at least one of $Ar^3$ to $Ar^5$ comprises the following substituent is excluded:

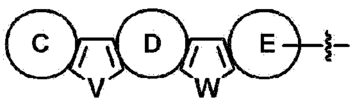
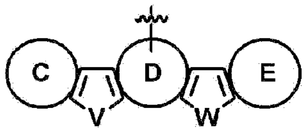
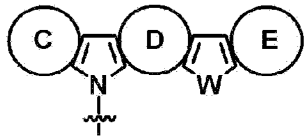

wherein, ring C, ring D and ring E are each independently a $C_6$-$C_{60}$ aryl ring, and V and W are each independently O, S, $N(R_{11})$ or $C(R_{12})(R_{13})$, wherein $R_{11}$ to $R_{13}$ are each independently selected from the group consisting of hydrogen; deuterium; halogen; a cyano group; a nitro group; a $C_6$-$C_{60}$ aryl group; a fluorenyl group; a $C_2$-$C_{60}$ heterocyclic group containing at least one heteroatom of O, N, S, Si and P; a $C_3$-$C_{60}$ aliphatic ring group; a $C_1$-$C_{20}$ alkyl group; a $C_2$-$C_{20}$ alkenyl group; a $C_2$-$C_{20}$ alkynyl group; a $C_1$-$C_{20}$ alkoxyl group; and a $C_6$-$C_{60}$ aryloxy group.

2. The organic electronic device of claim 1, wherein compound represented by Formula 1 is one of the following compounds:

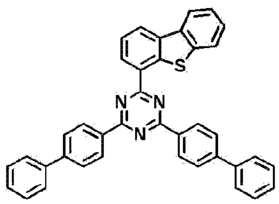
P2-1

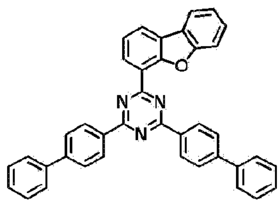
P2-2

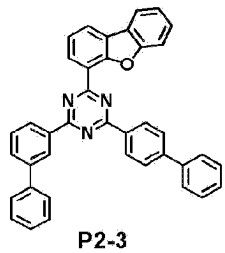
P2-3

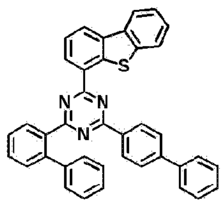
P2-4

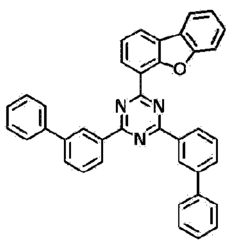
P2-5

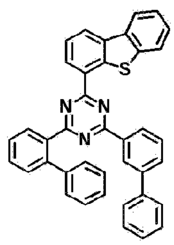
P2-6

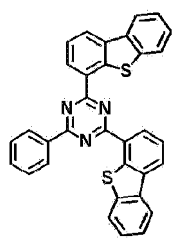
P2-7

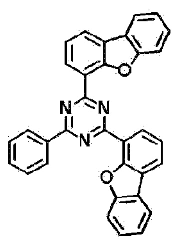
P2-8

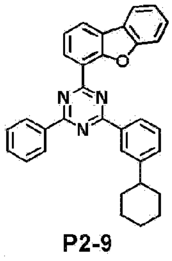
P2-9

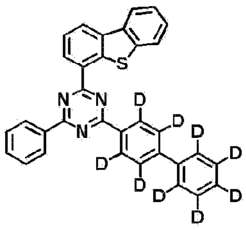
P2-10

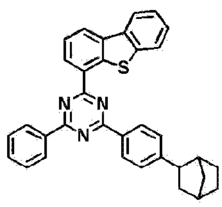
P2-11

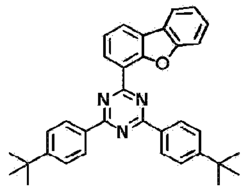
P2-12

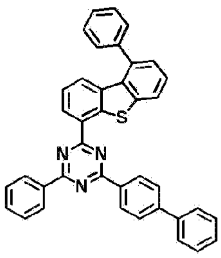
P2-13

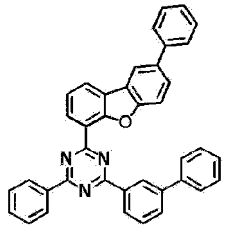
P2-14

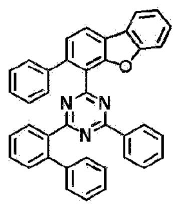
P2-15

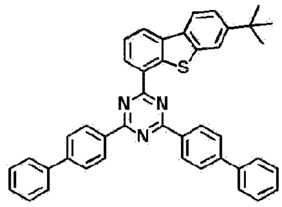
P2-16

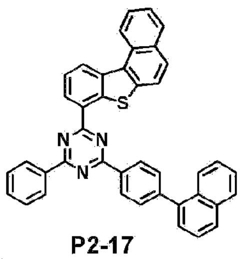
P2-17

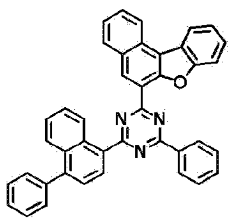
P2-18

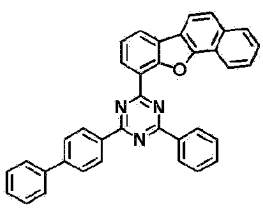
P2-19

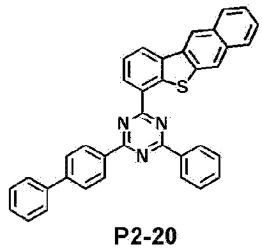
P2-20

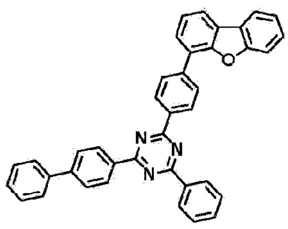
P2-21

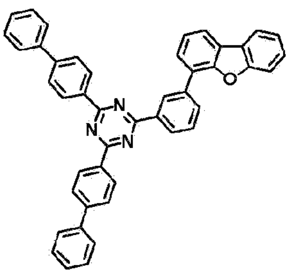
P2-22

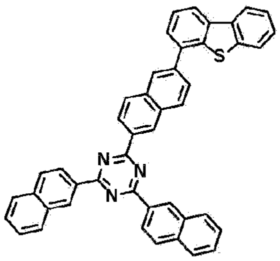
P2-23

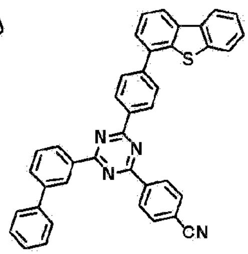
P2-24

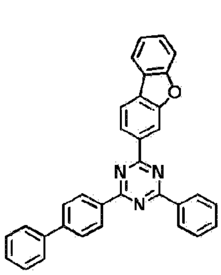
P2-25

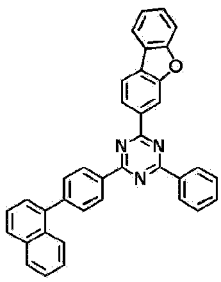
P2-26

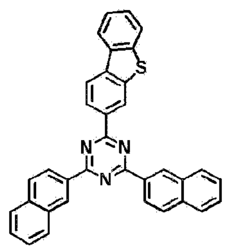
P2-27

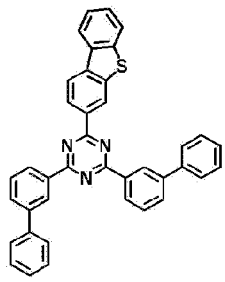
P2-28

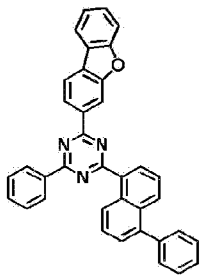
P2-29

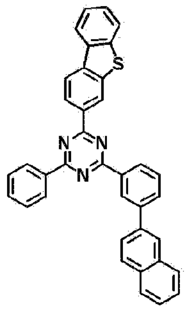
P2-30

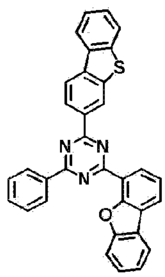
P2-31

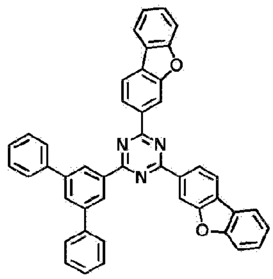
P2-32

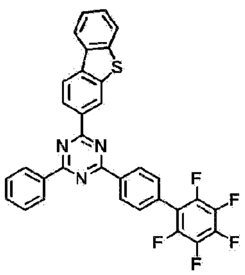
P2-33

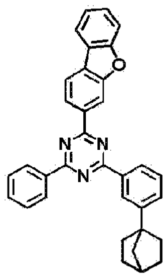
P2-34

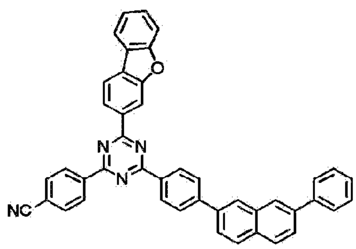
P2-35

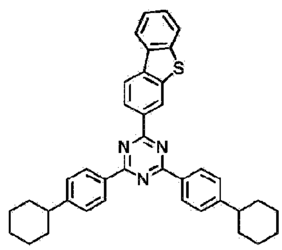
P2-36

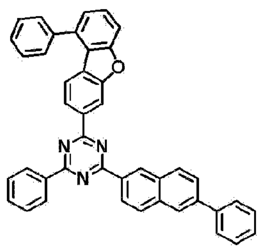
P2-37

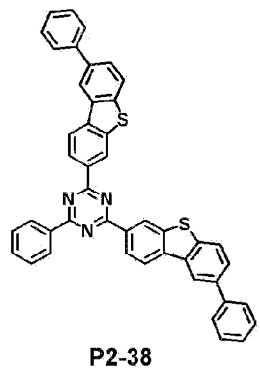
P2-38

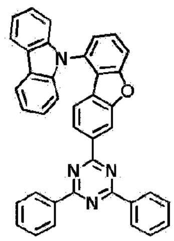
P2-39

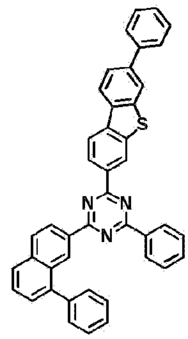
P2-40

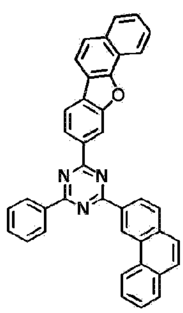
P2-41

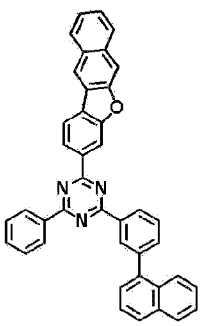
P2-42

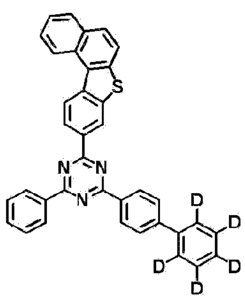
P2-43

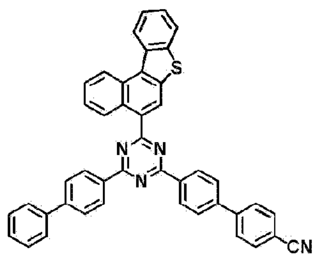
P2-44

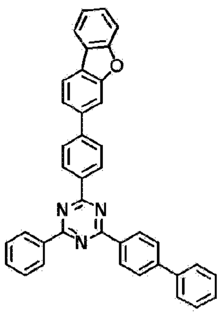
P2-45

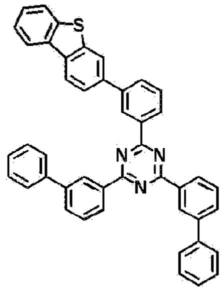
P2-46

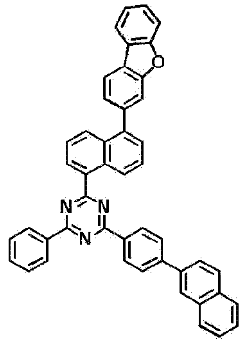
P2-47

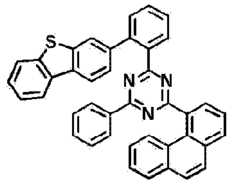
P2-48

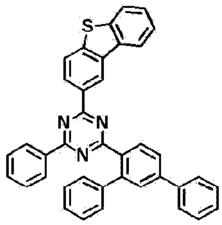
P2-49

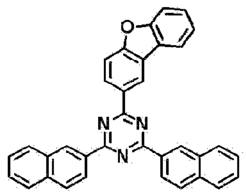
P2-50

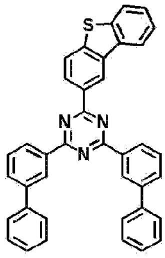
P2-51

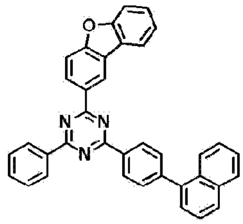
P2-52

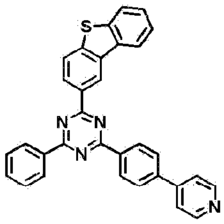
P2-53

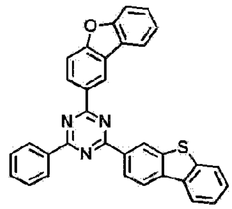
P2-54

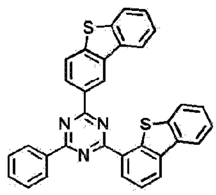
P2-55

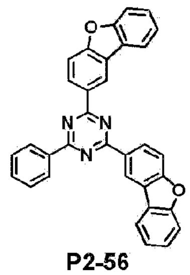
P2-56

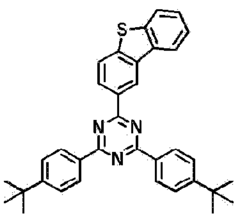
P2-57

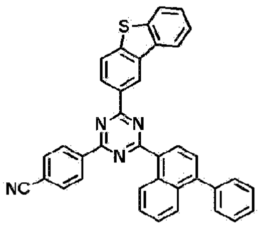
P2-58

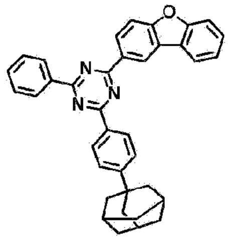
P2-59

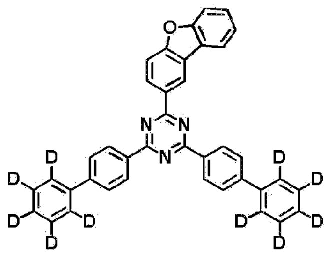
P2-60

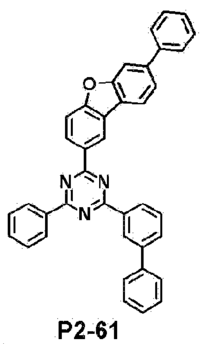
P2-61

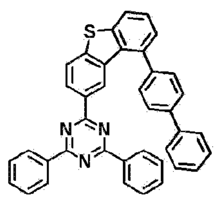
P2-62

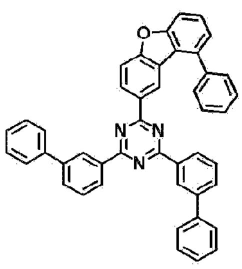
P2-63

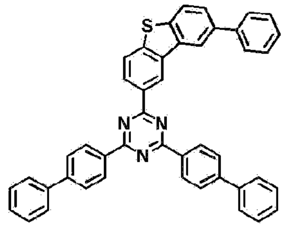
P2-64

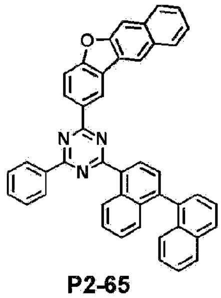
P2-65

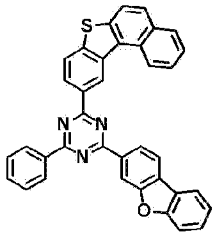
P2-66

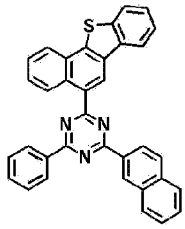
P2-67

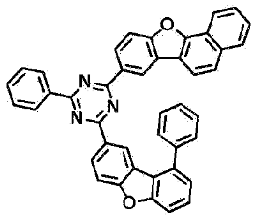
P2-68

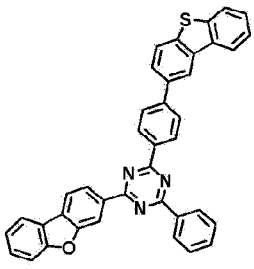
P2-69

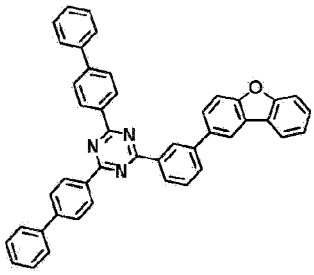
P2-70

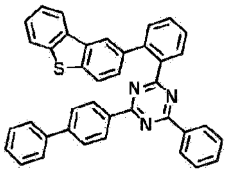
P2-71

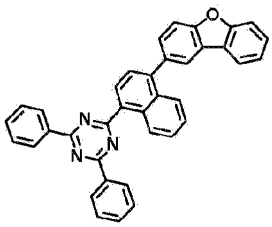
P2-72

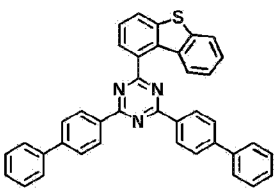
P2-73

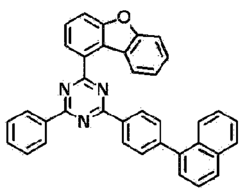
P2-74

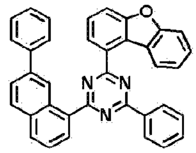
P2-75

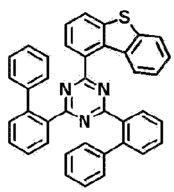
P2-76

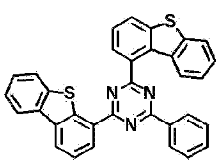
P2-77

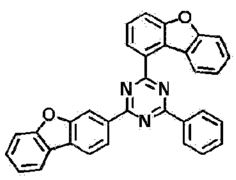
P2-78

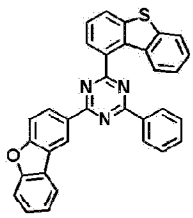
P2-79

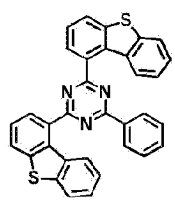
P2-80

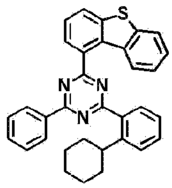
P2-81

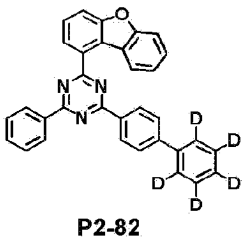
P2-82

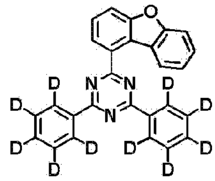
P2-83

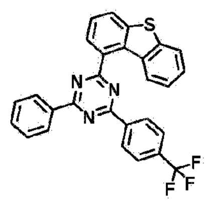
P2-84

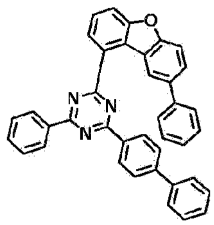
P2-85

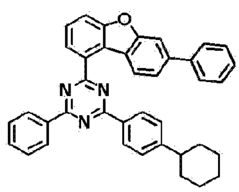
P2-86

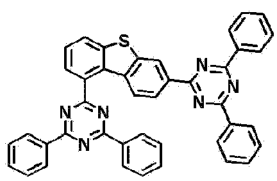
P2-87

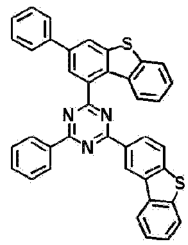
P2-88

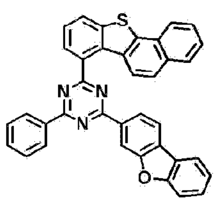
P2-89

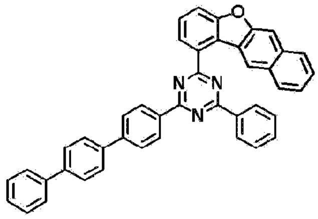
P2-90

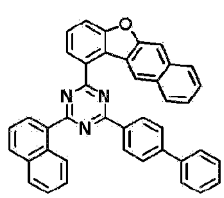
P2-91

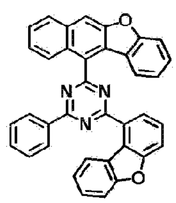
P2-92

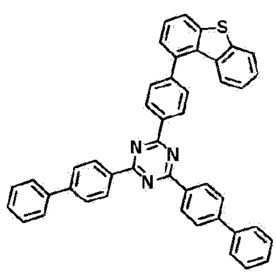
P2-93

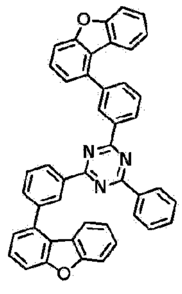
P2-94

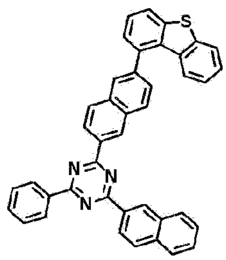
P2-95

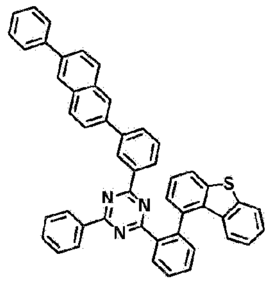
P2-96

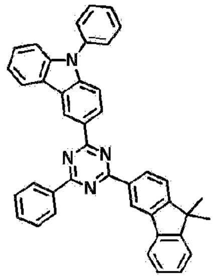
P2-97

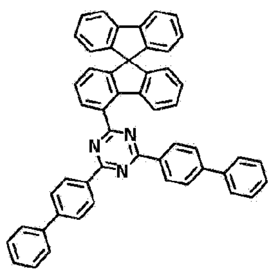
P2-98

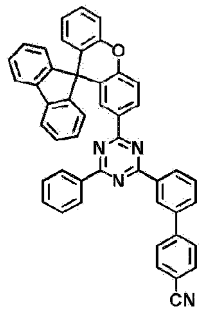
P2-99

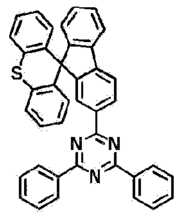
P2-100

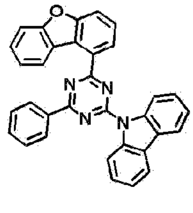
P2-101

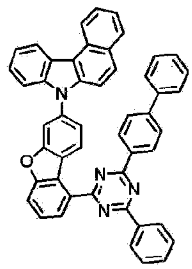
P2-102

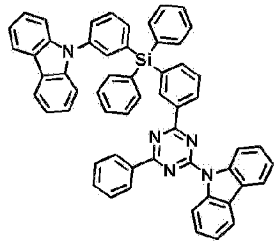
P2-103

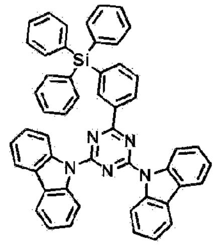
P2-104

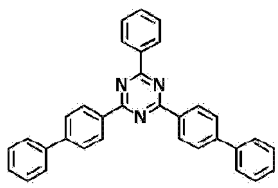
P3-1

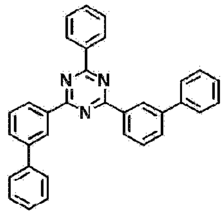
P3-2

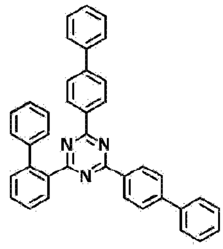
P3-3

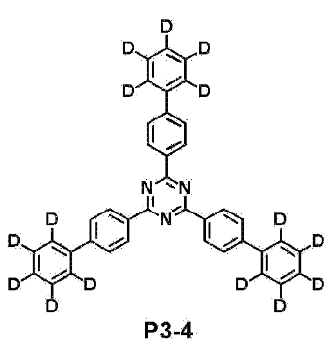
P3-4

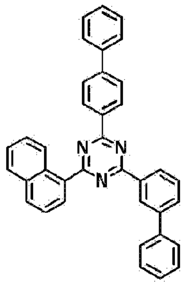
P3-5

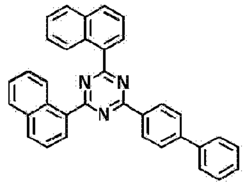
P3-6

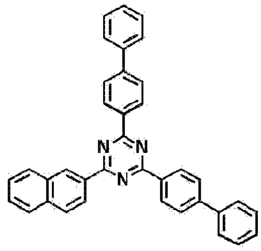
P3-7

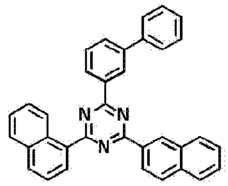
P3-8

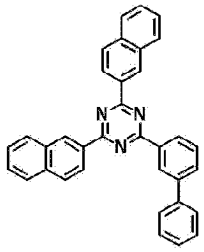
P3-9

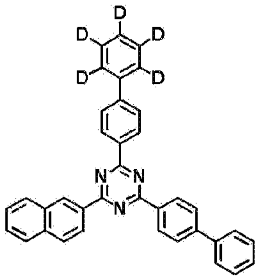
P3-10

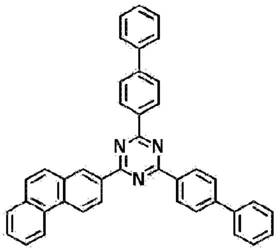
P3-11

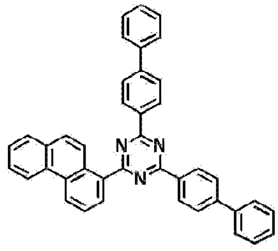
P3-12

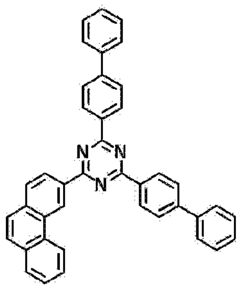
P3-13

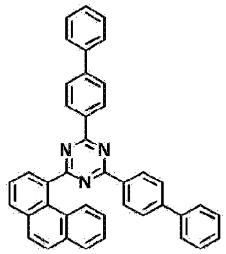
P3-14

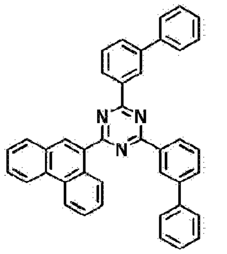
P3-15

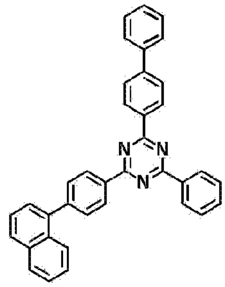
P3-16

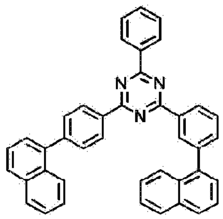
P3-17

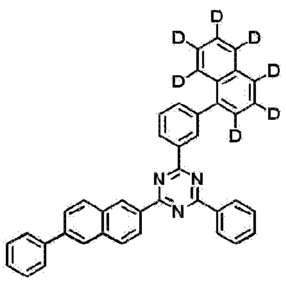
P3-18

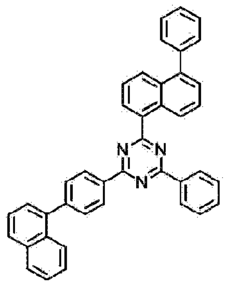
P3-19

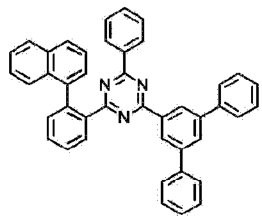
P3-20

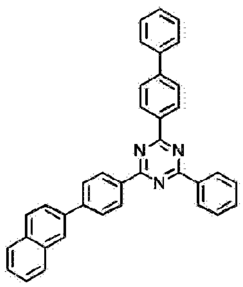
P3-21

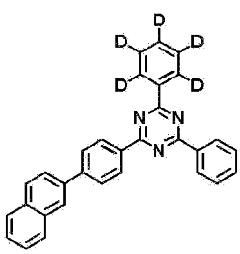
P3-22

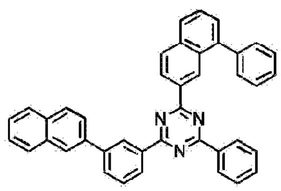
P3-23

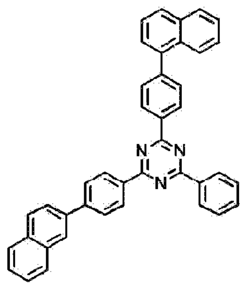
P3-24

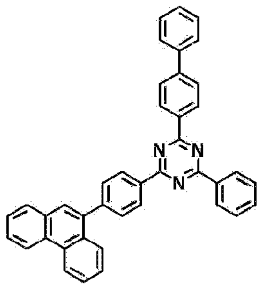
P3-25

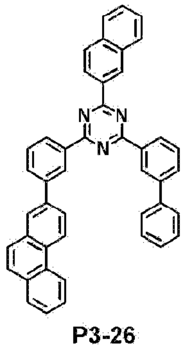
P3-26

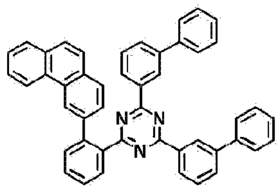
P3-27

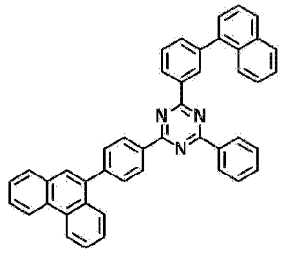
P3-28

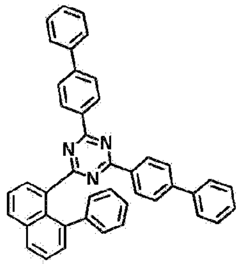
P3-29

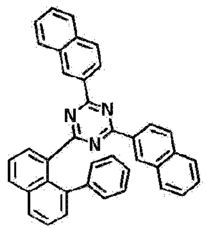
P3-30

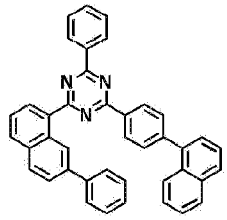
P3-31

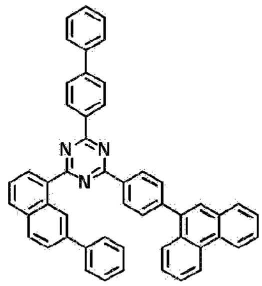
P3-32

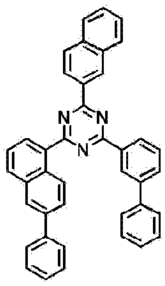
P3-33

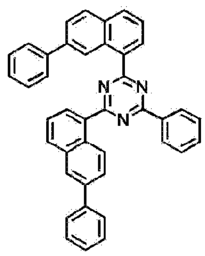
P3-34

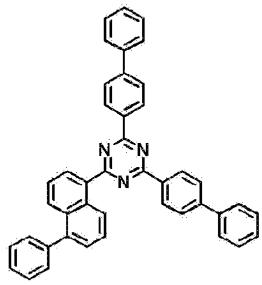
P3-35

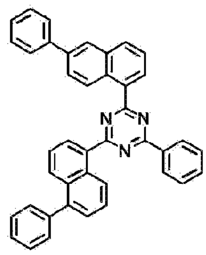
P3-36

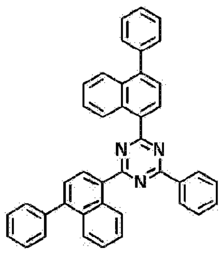
P3-37

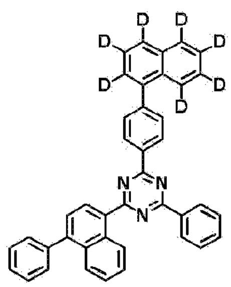
P3-38

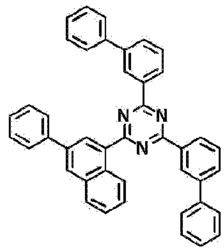
P3-39

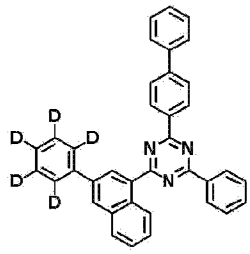
P3-40

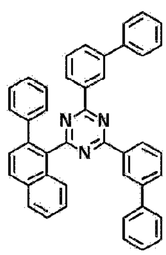
P3-41

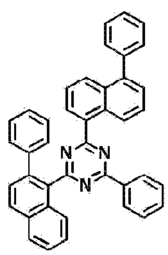
P3-42

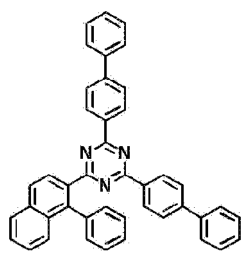
P3-43

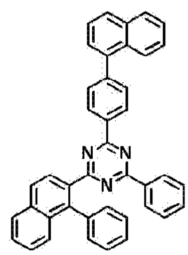
P3-44

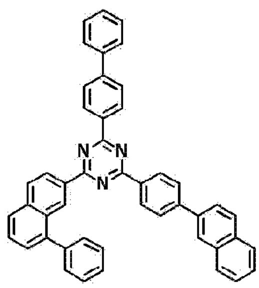
P3-45

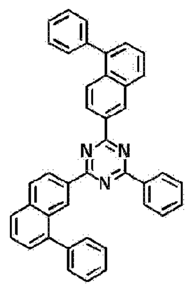
P3-46

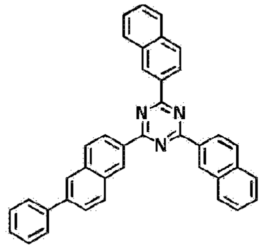
P3-47

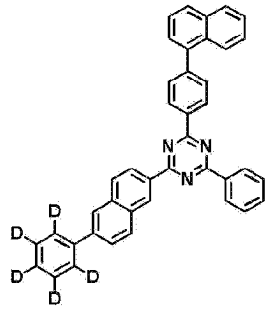
P3-48

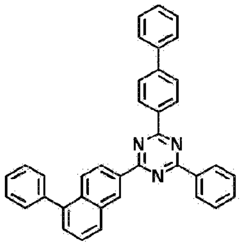
P3-49

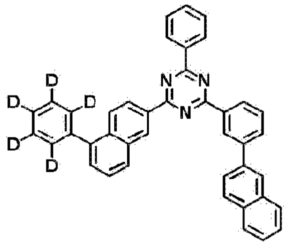
P3-50

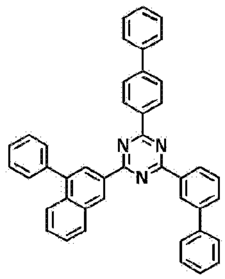
P3-51

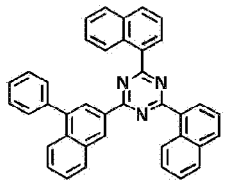
P3-52

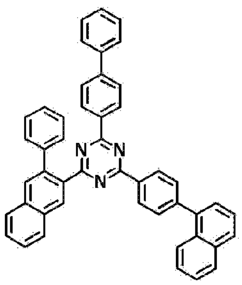
P3-53

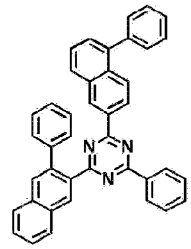
P3-54

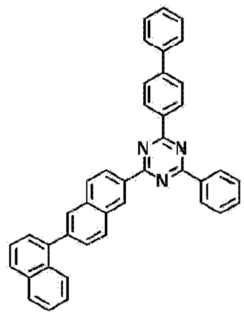
P3-55

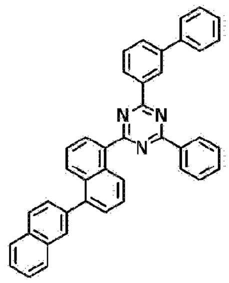
P3-56

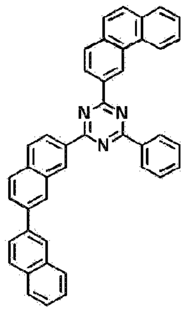
P3-57

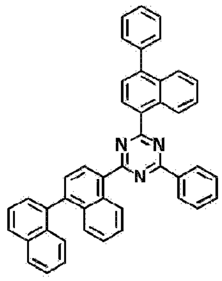
P3-58

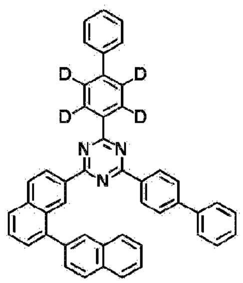
P3-59

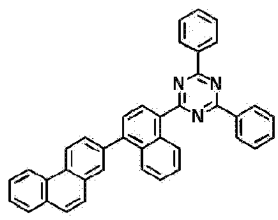
P3-60

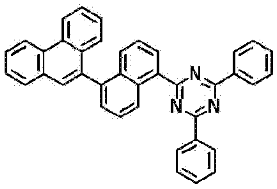
P3-61

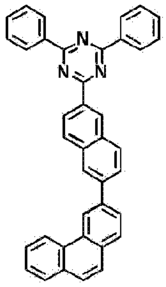
P3-62

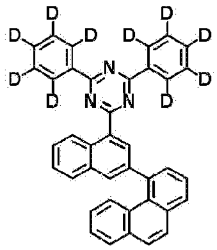
P3-63

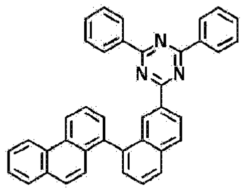
P3-64

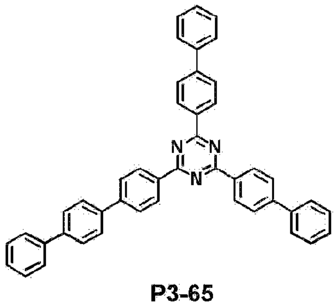
P3-65

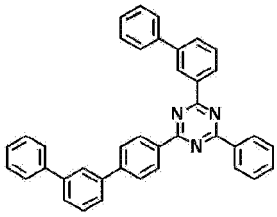
P3-66

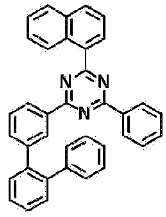
P3-67

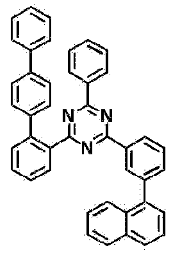
P3-68

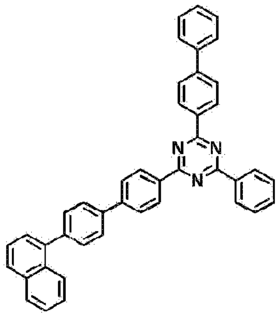
P3-69

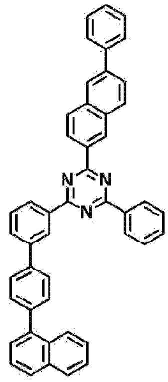
P3-70

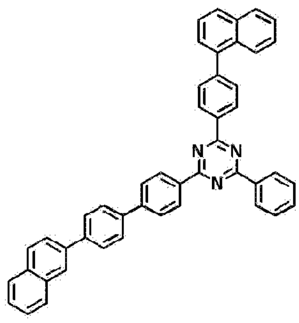
P3-71

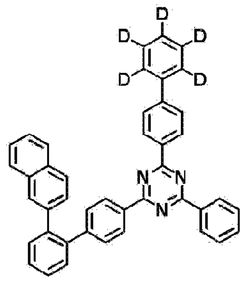
P3-72

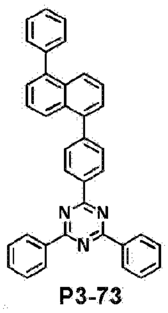
P3-73

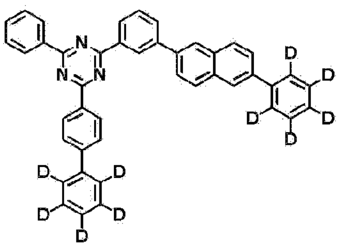
P3-74

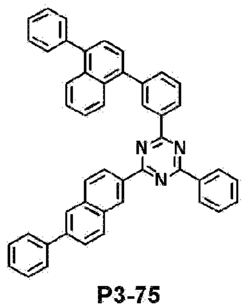
P3-75

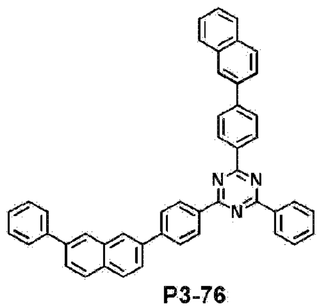
P3-76

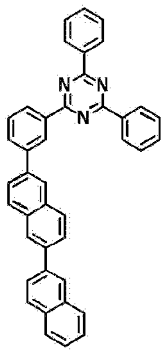
P3-77

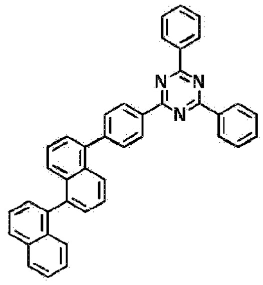
P3-78

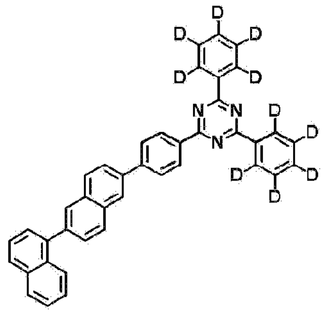
P3-79

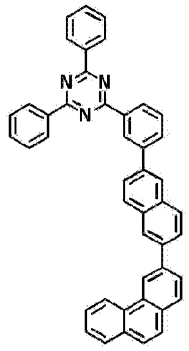
P3-80

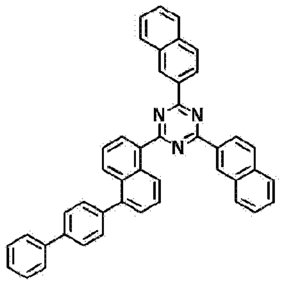
P3-81

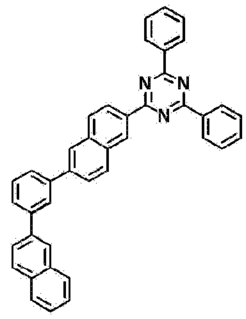
P3-82

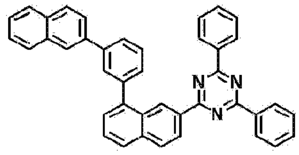
P3-83

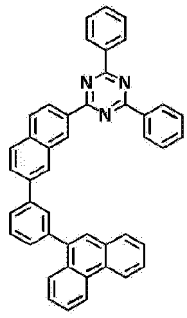
P3-84

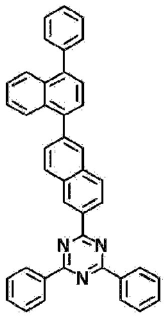
P3-85

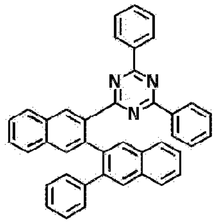
P3-86

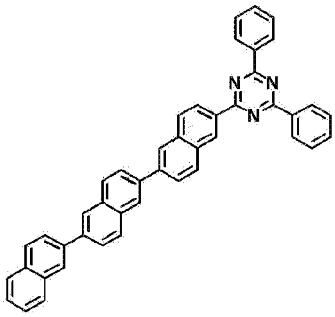
P3-87

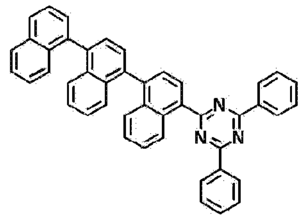
P3-88

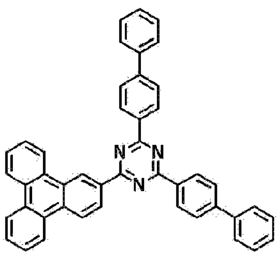
P3-89

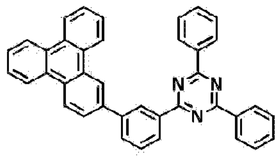
P3-90

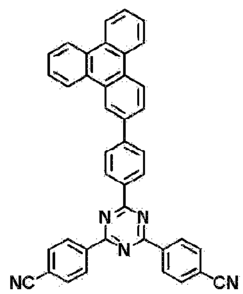
P3-91

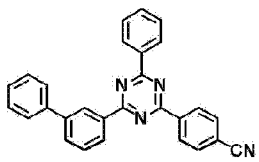
P3-92.

3. The organic electronic device of claim 1, wherein compound represented by Formula 2 is one of the following compounds:

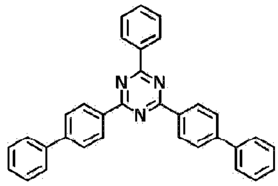
P3-1

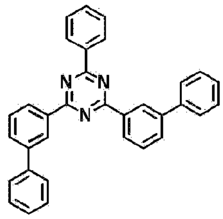
P3-2

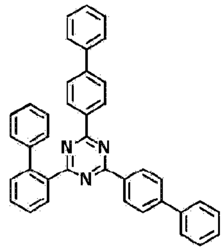
P3-3

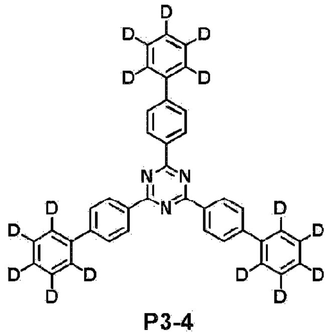
P3-4

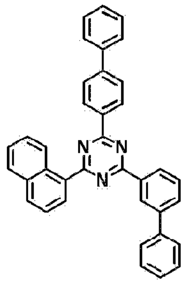
P3-5

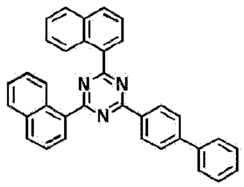
P3-6

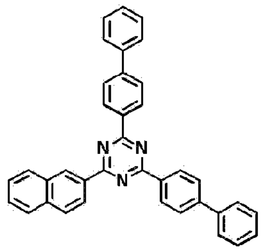
P3-7

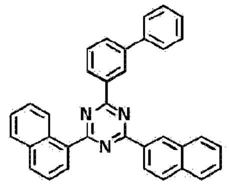
P3-8

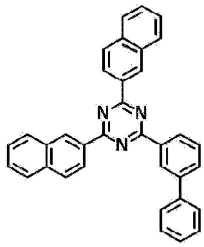
P3-9

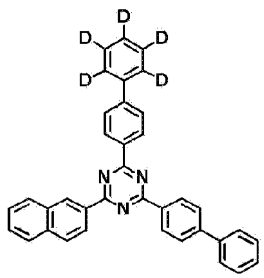
P3-10

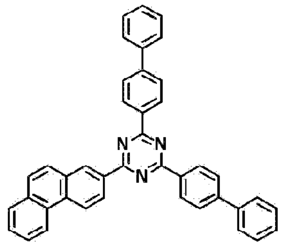
P3-11

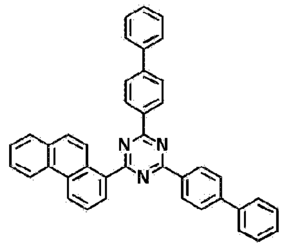
P3-12

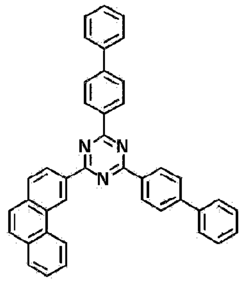
P3-13

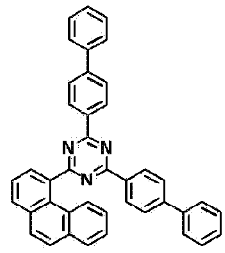
P3-14

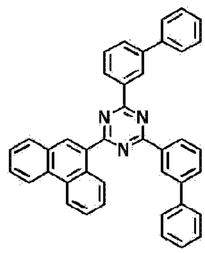
P3-15

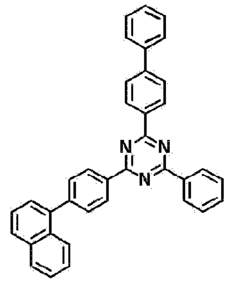
P3-16

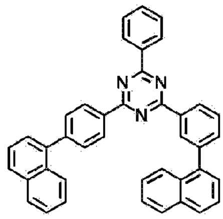
P3-17

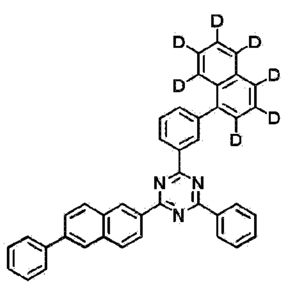
P3-18

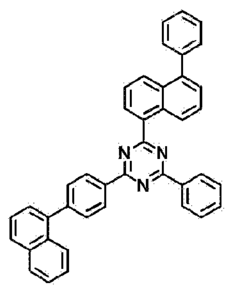
P3-19

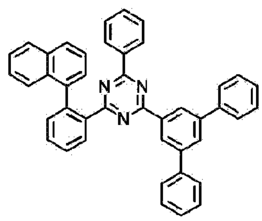
P3-20

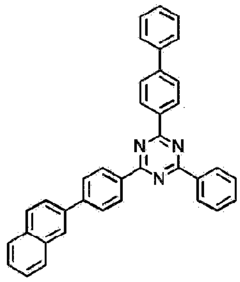
P3-21

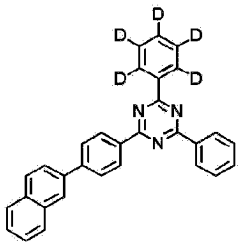
P3-22

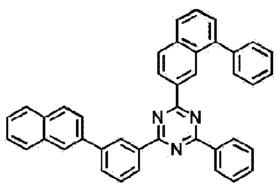
P3-23

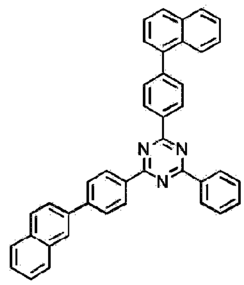
P3-24

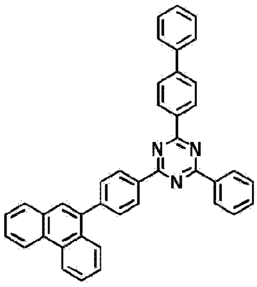
P3-25

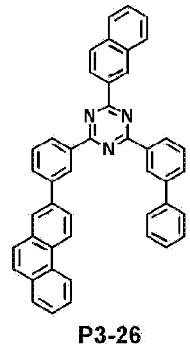
P3-26

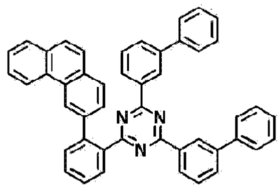
P3-27

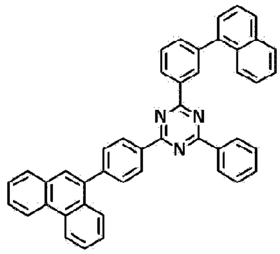
P3-28

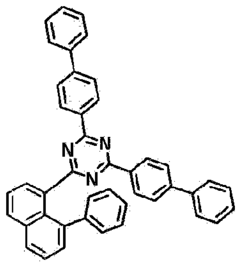
P3-29

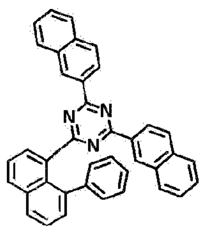
P3-30

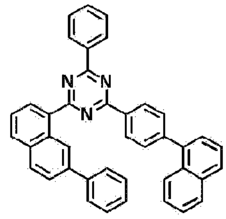
P3-31

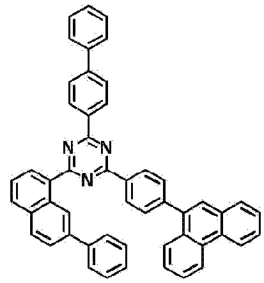
P3-32

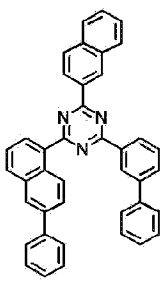
P3-33

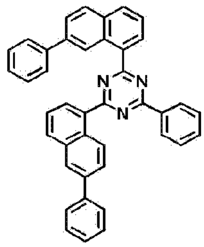
P3-34

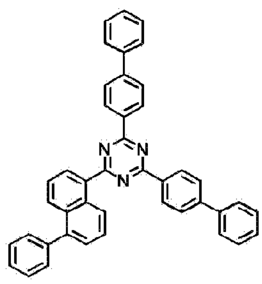
P3-35

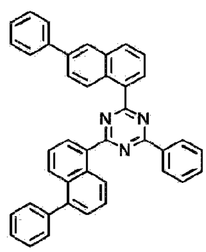
P3-36

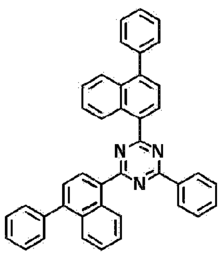
P3-37

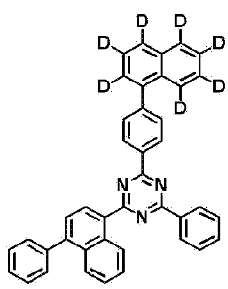
P3-38

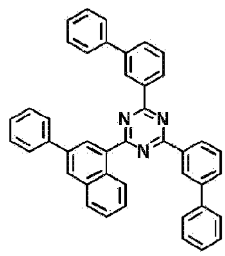
P3-39

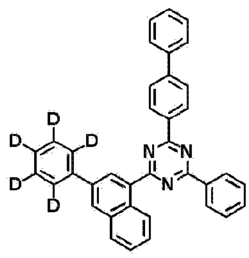
P3-40

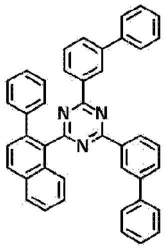
P3-41

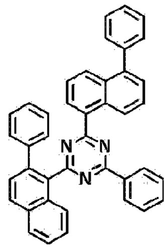
P3-42

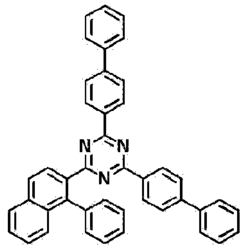
P3-43

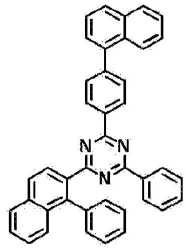
P3-44

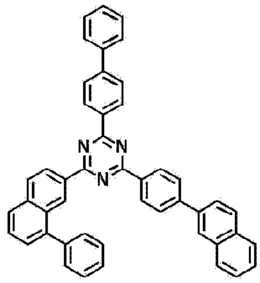
P3-45

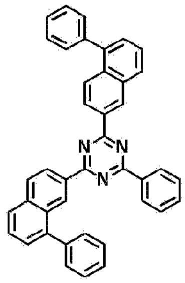
P3-46

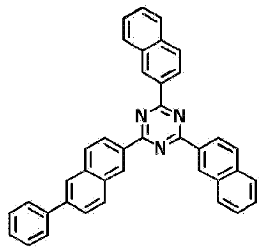
P3-47

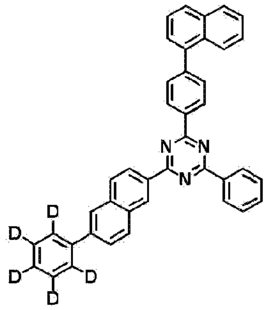
P3-48

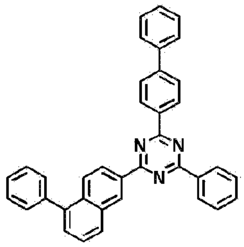
P3-49

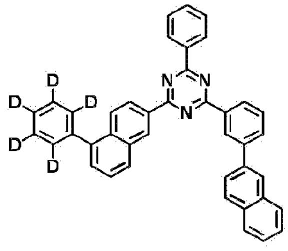
P3-50

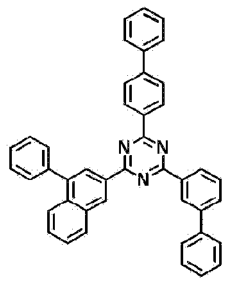
P3-51

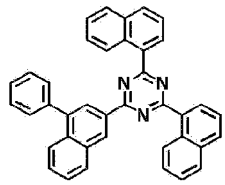
P3-52

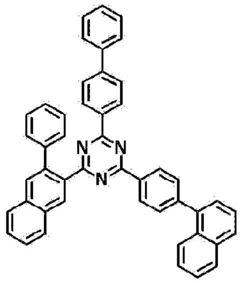
P3-53

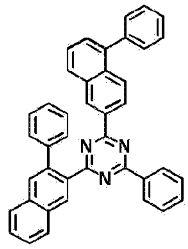
P3-54

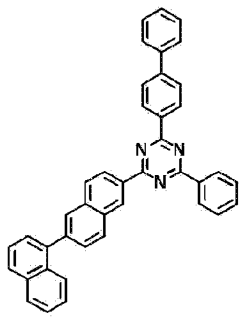
P3-55

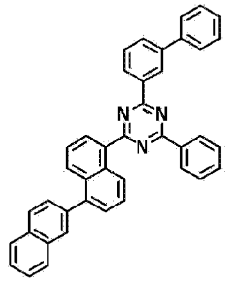
P3-56

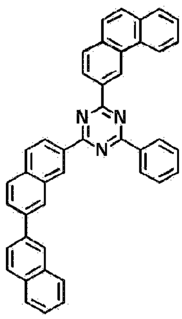
P3-57

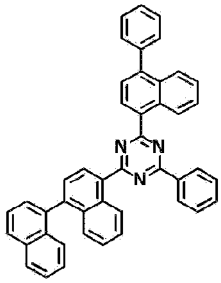
P3-58

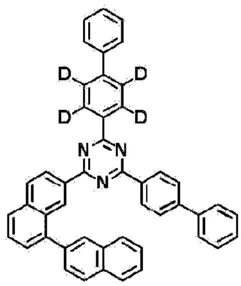
P3-59

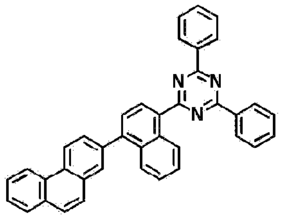
P3-60

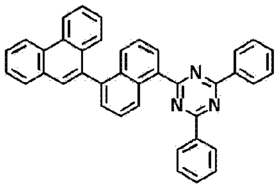
P3-61

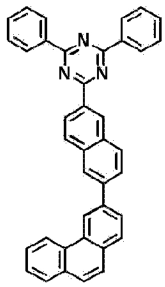
P3-62

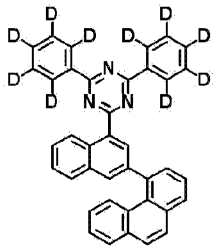
P3-63

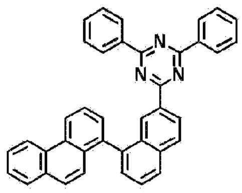
P3-64

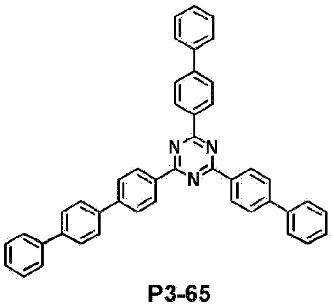
P3-65

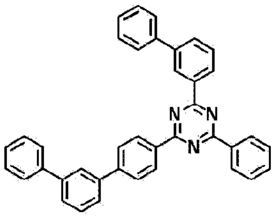
P3-66

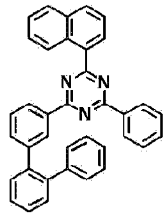
P3-67

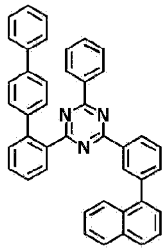
P3-68

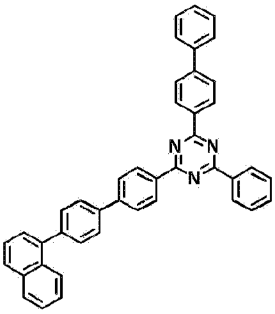
P3-69

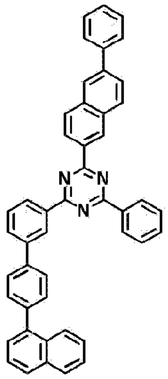
P3-70

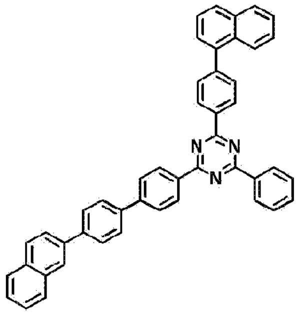
P3-71

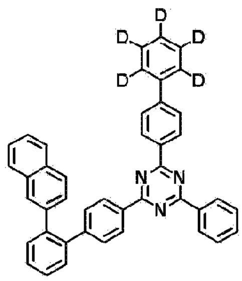
P3-72

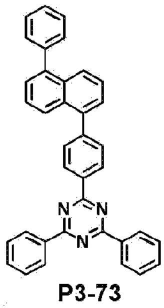
P3-73

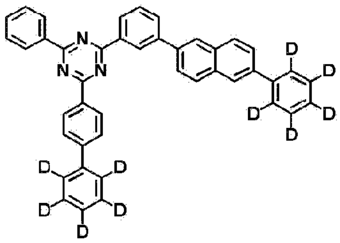
P3-74

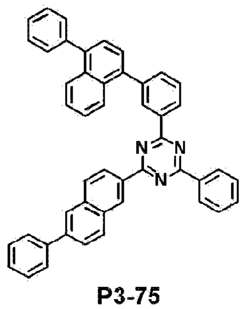
P3-75

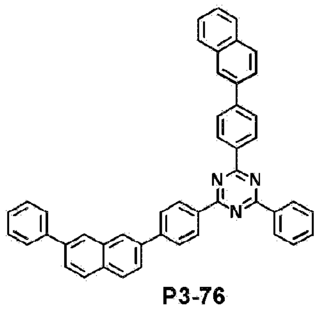
P3-76

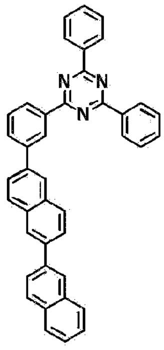
P3-77

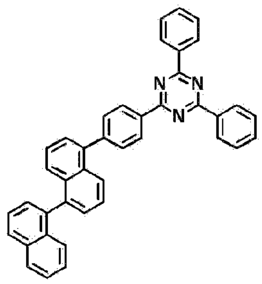
P3-78

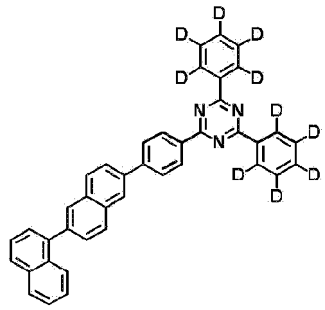
P3-79

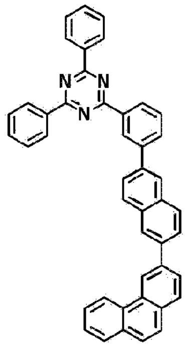
P3-80

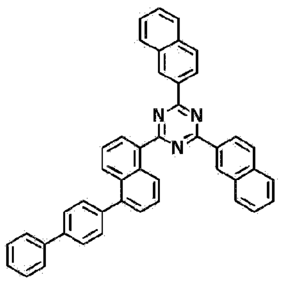
P3-81

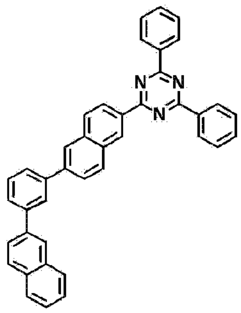
P3-82

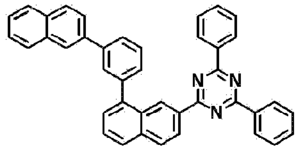
P3-83

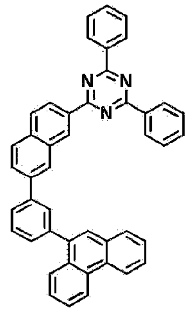
P3-84

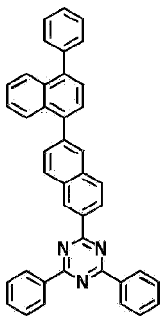
P3-85

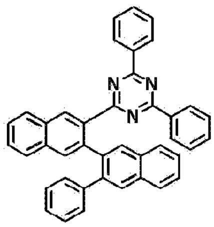
P3-86

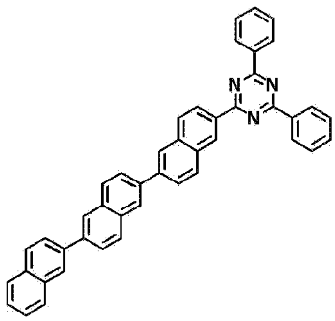
P3-87

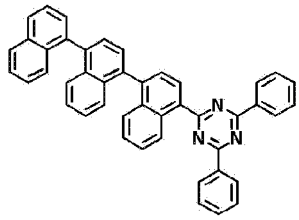
P3-88

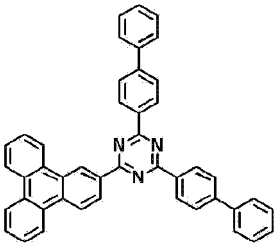

P3-89

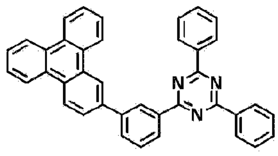

P3-90

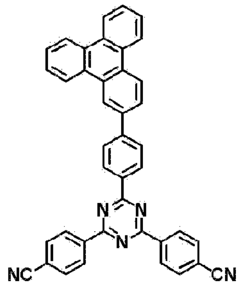

P3-91

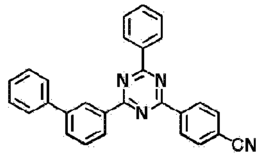

P3-92 .

**4.** The organic electronic device of claim 1, wherein compound represented by Formula 3 is one of the following compounds:

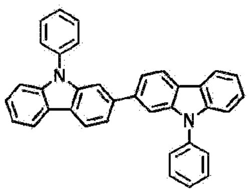

P5-1

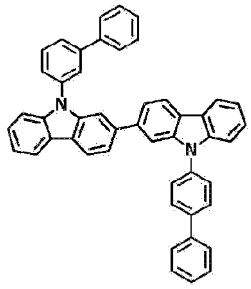

P5-2

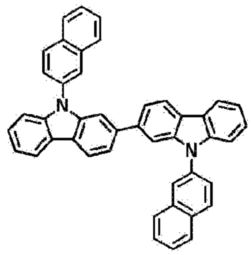

P5-3

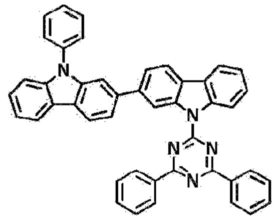

P5-4

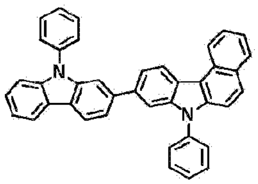

P5-5

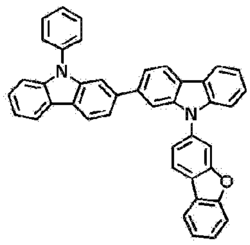

P5-6

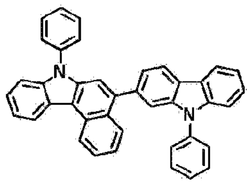

P5-7

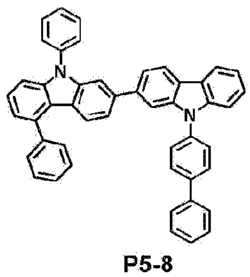

P5-8

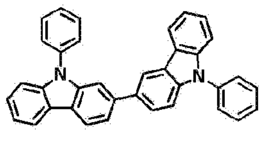

P5-9

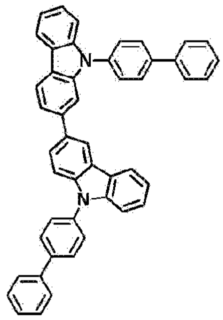

P5-10

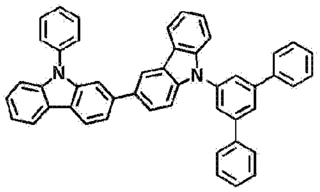

P5-11

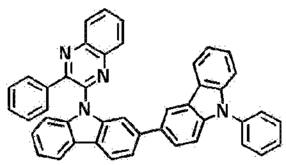

P5-12

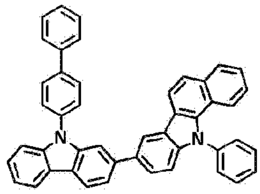

P5-13

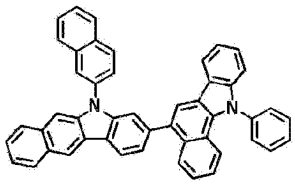

P5-14

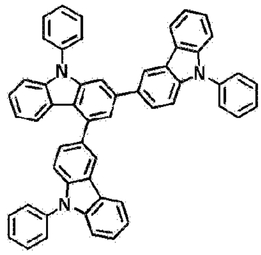

P5-15

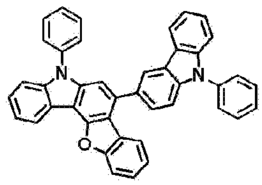

P5-16

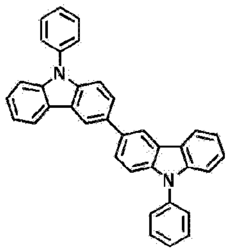

P5-17

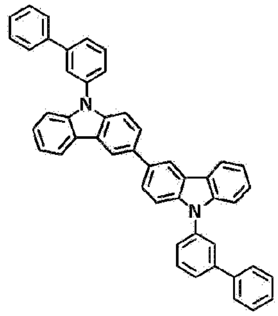

P5-18

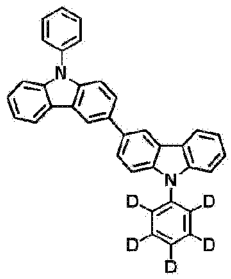

P5-19

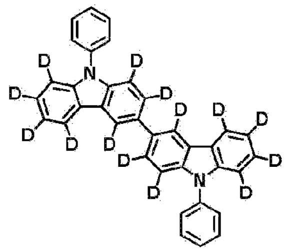

P5-20

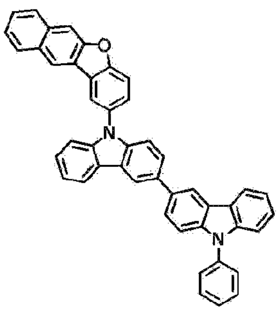

P5-21

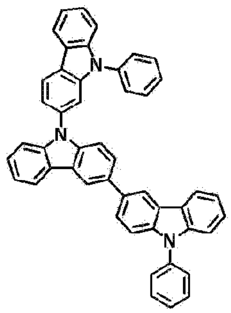

P5-22

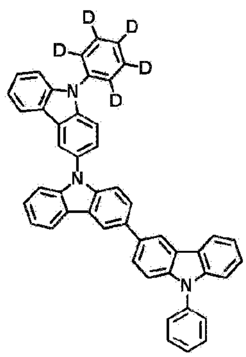

P5-23

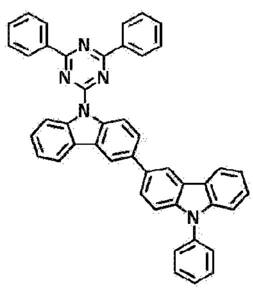

P5-24

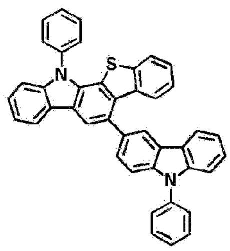

P5-25

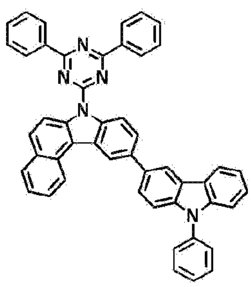

P5-26

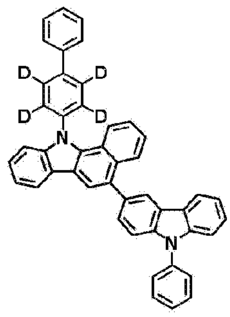

P5-27

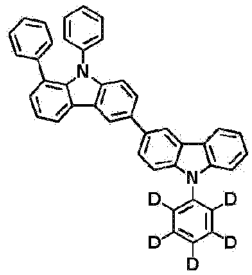

P5-28

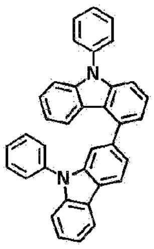
P5-29

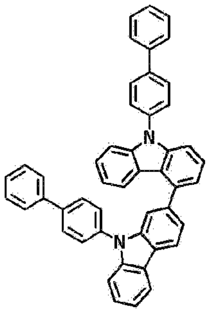
P5-30

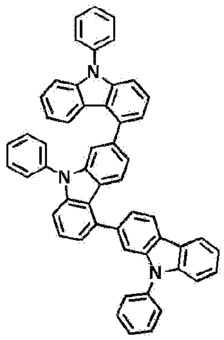
P5-31

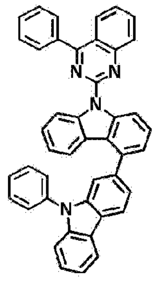
P5-32

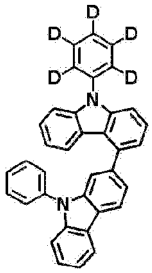
P5-33

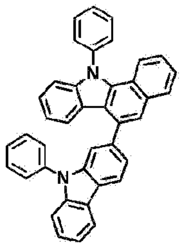
P5-34

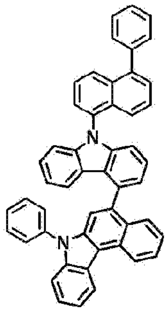
P5-35

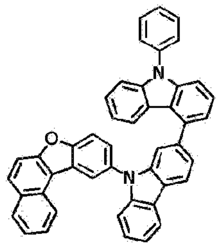
P5-36

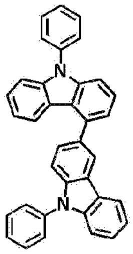
P5-37

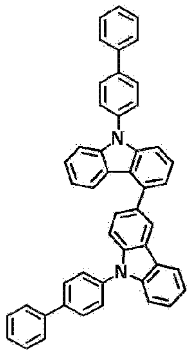
P5-38

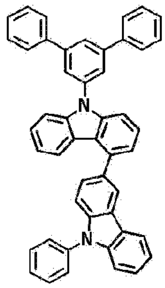
P5-39

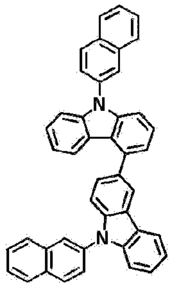
P5-40

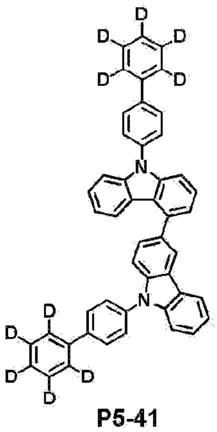
P5-41

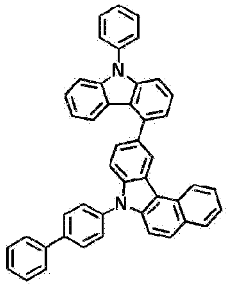
P5-42

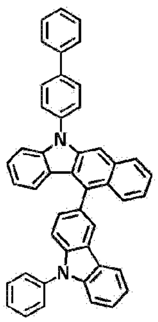
P5-43

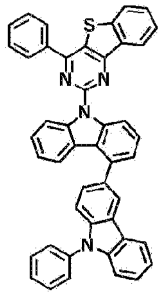
P5-44

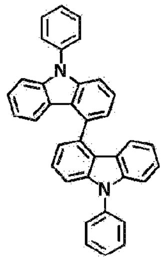

P5-45

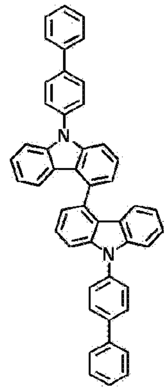

P5-46

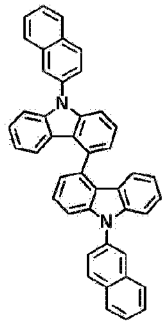

P5-47

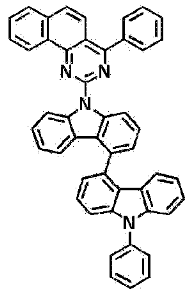

P5-48

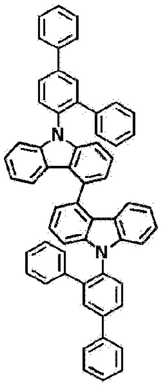

P5-49

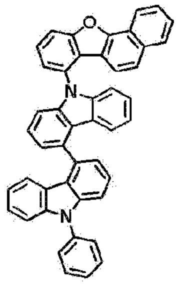

P5-50

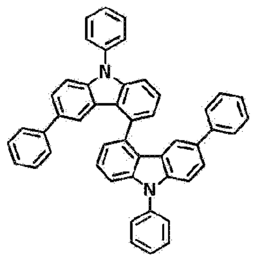

P5-51

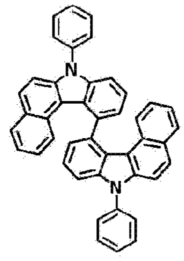

P5-52

5. The organic electronic device of claim 1, wherein the organic electronic device further comprises a layer for improving luminous efficiency, and the layer for improving luminous efficiency is formed on one side of both sides of the anode or the cathode, wherein the one side is not facing the organic layer.

6. The organic electronic device of claim 1, wherein the organic layer comprises a hole transport region and an electron transport region.

7. The organic electronic device of claim 6, wherein the organic layer comprises two or more stacks comprising the hole transport region and the electron transport region.

8. The organic electronic device of claim 7, wherein the organic layer further comprises a charge generation layer formed between the two or more stacks.

9. An electronic apparatus including a display device and a control unit for driving the display device, wherein the display device includes the organic electronic device of claim 1.

10. The electronic device of claim 9, wherein the organic electronic device is selected from the group consisting of an organic electroluminescent element, an organic transistor, an element for monochromatic illumination and a quantum dot display.

[Fig. 1]

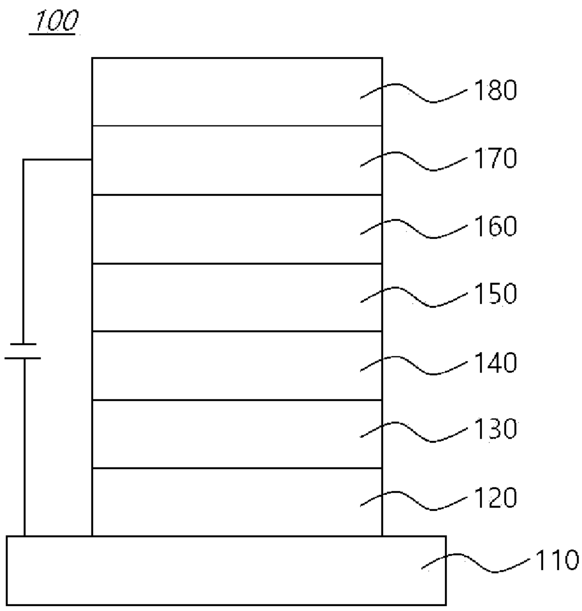
100
180
170
160
150
140
130
120
110

[Fig. 2]

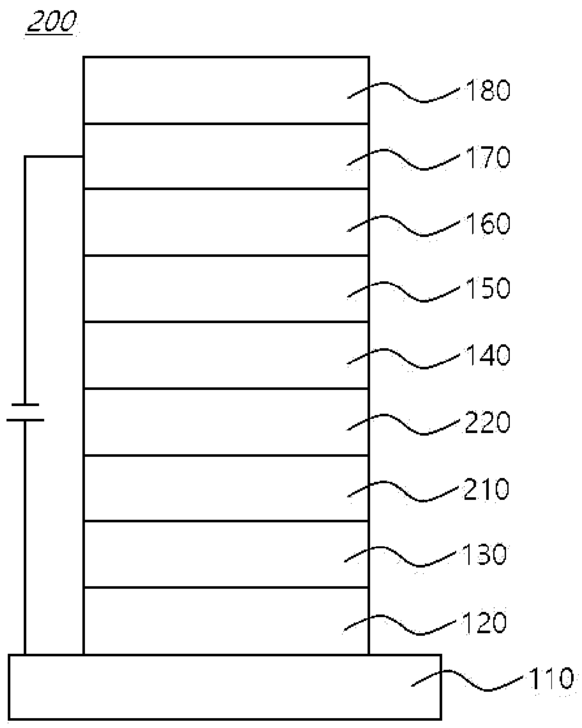
200
180
170
160
150
140
220
210
130
120
110

[Fig. 3]

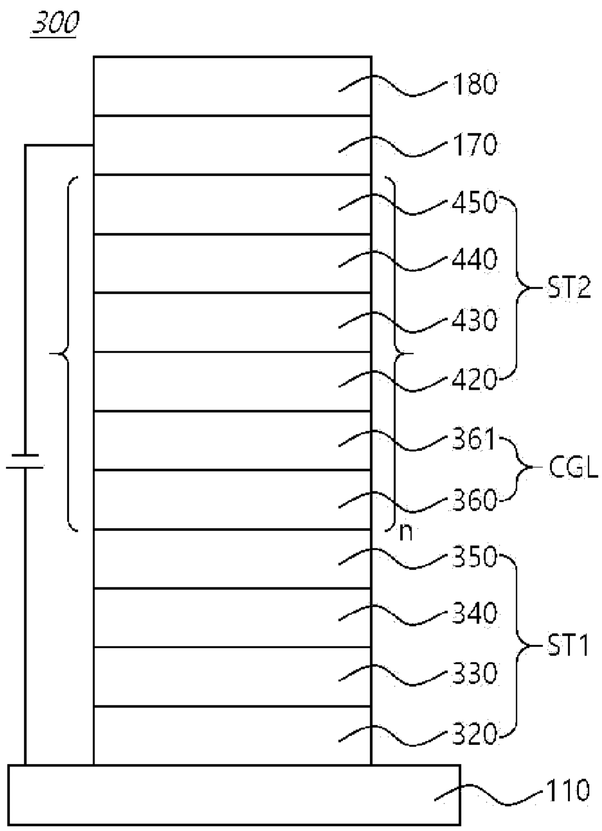
300
180
170
450
440
430
420
361
360
n
350
340
330
320
ST2
CGL
ST1
110

## INTERNATIONAL SEARCH REPORT

International application No.
**PCT/KR2023/020401**

**A. CLASSIFICATION OF SUBJECT MATTER**

**H10K 85/60**(2023.01)i; **C09K 11/06**(2006.01)i

According to International Patent Classification (IPC) or to both national classification and IPC

**B. FIELDS SEARCHED**

Minimum documentation searched (classification system followed by classification symbols)

H10K 85/60(2023.01); C09K 11/06(2006.01); H01L 27/32(2006.01); H01L 51/00(2006.01); H01L 51/50(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, CAplus) & keywords: 유기발광소자(OLED, organic light emitting diode), 호스트(host), 발광층(light emitting layer), 트리아진(triazine), 카바졸(carbazole)

**C. DOCUMENTS CONSIDERED TO BE RELEVANT**

| Category* | Citation of document, with indication, where appropriate, of the relevant passages | Relevant to claim No. |
|---|---|---|
| X | KR 10-2022-0122816 A (SAMSUNG DISPLAY CO., LTD.) 05 September 2022 (2022-09-05)<br>See claims 1, 2, 15 and 17; and paragraphs [0332], [0605] and [0618]. | 1-10 |
| X | KR 10-2021-0075283 A (SAMSUNG DISPLAY CO., LTD.) 23 June 2021 (2021-06-23)<br>See claims 1, 2, 17, 19 (compounds 1-11, 2-1 and 3-1) and 20; and paragraphs [0420], [0528] and [0545]. | 1-10 |
| A | KR 10-2020-0036795 A (LG CHEM, LTD.) 07 April 2020 (2020-04-07)<br>See entire document. | 1-10 |
| A | WO 2022-196603 A1 (KYULUX, INC.) 22 September 2022 (2022-09-22)<br>See entire document. | 1-10 |
| A | WO 2018-030446 A1 (IDEMITSU KOSAN CO., LTD.) 15 February 2018 (2018-02-15)<br>See entire document. | 1-10 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **20 March 2024** | **22 March 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/020401**

| Patent document cited in search report | Publication date (day/month/year) | Patent family member(s) | Publication date (day/month/year) |
|---|---|---|---|
| KR 10-2022-0122816 A | 05 September 2022 | CN 114975809 A | 30 August 2022 |
| | | US 2022-0271234 A1 | 25 August 2022 |
| KR 10-2021-0075283 A | 23 June 2021 | CN 112993197 A | 18 June 2021 |
| | | US 2021-0184151 A1 | 17 June 2021 |
| KR 10-2020-0036795 A | 07 April 2020 | CN 112534600 A | 19 March 2021 |
| | | KR 10-2178483 B1 | 13 November 2020 |
| | | US 2022-0123218 A1 | 21 April 2022 |
| | | WO 2020-067823 A1 | 02 April 2020 |
| | | WO 2020-067823 A9 | 14 May 2021 |
| WO 2022-196603 A1 | 22 September 2022 | CN 117121651 A | 24 November 2023 |
| | | EP 4310930 A1 | 24 January 2024 |
| | | JP 2022-142304 A | 30 September 2022 |
| | | KR 10-2023-0156073 A | 13 November 2023 |
| | | TW 202244244 A | 16 November 2022 |
| WO 2018-030446 A1 | 15 February 2018 | JP 2019-204805 A | 28 November 2019 |
| | | US 11189803 B2 | 30 November 2021 |
| | | US 2020-0321540 A1 | 08 October 2020 |

Form PCT/ISA/210 (patent family annex) (July 2022)